# EUROPEAN PATENT SPECIFICATION

(11) **EP 3 235 891 B1**
(45) Date of publication and mention of the grant of the patent: **23.12.2020**
(21) Application number: 16746391.8
(22) Date of filing: 15.01.2016
(51) Int. Cl.: C09K 11/06, C07F 15/00, H01L 51/50

(54) **COMPOSITION AND LIGHT-EMITTING ELEMENT USING SAME**
ZUSAMMENSETZUNG UND LICHTEMITTIERENDES ELEMENT DAMIT
COMPOSITION ET ÉLÉMENT ÉLECTROLUMINESCENT METTANT EN UVRE CETTE COMPOSITION

(30) Priority: 03.02.2015 JP 2015019055
(43) Date of publication of application: 25.10.2017
(73) Proprietor: Sumitomo Chemical Company, Ltd., Chuo-ku Tokyo 104-8260 (JP)
(72) Inventor: SASADA, Toshiaki, Tsukuba-shi Ibaraki 300-3294 (JP); SAITO, Takakazu, Tsukuba-shi Ibaraki 300-3294 (JP)
(74) Representative: J A Kemp LLP
(86) International application number: PCT/JP2016/051070
(87) International publication number: WO 2016/125560

(56) References cited:
- EP-A2- 2 746 359
- WO-A1-2011/090535
- WO-A1-2013/161739
- WO-A1-2013/176194
- WO-A1-2015/008851
- WO-A1-2015/163174
- WO-A2-2014/023377
- JP-A- 2014 075 344
- JP-A- 2015 174 931
- JP-A- 2015 174 932
- US-A1- 2011 227 478
- US-A1- 2012 292 600
- MARAPPAN VELUSAMY ET AL. SYNTHESIS, STRUCTURE AND ELECTROLUMINESCENT PROPERTIES OF CYCLOMETALATED IRIDIUM COMPLEXES POSSESSING STERICALLY HINDERED LIGANDS 2007, pages 3025 - 3034, XP002490863
- QIANG WANG ET AL: "High-Performance, Phosphorescent, Top-Emitting Organic Light-Emitting Diodes with p?i?n Homojunctions", ADVANCED FUNCTIONAL MATERIALS, WILEY - V C H VERLAG GMBH & CO. KGAA, DE, vol. 21, no. 9, 10 May 2011 (2011-05-10), pages 1681-1686, XP001561795, ISSN: 1616-301X, DOI: 10.1002/ADFM.201002229 [retrieved on 2011-03-04]

## Description

### Technical Field

The present invention relates to a composition and a light emitting device using the same.

### Background Art

An organic electroluminescent device (hereinafter, referred to also as "light emitting device") can be suitably used in applications such as display and illumination because of high light emission efficiency and low driving voltage, and is under active study and development.

As the material used in a light emitting layer of a light emitting device, for example, a composition comprising the phosphorescent compound (A) and the phosphorescent compound (C) represented by the following formulae and a composition comprising the phosphorescent compound (A), the phosphorescent compound (B) and the phosphorescent compound (C) represented by the following formulae are proposed (Patent document 1). The phenylpyridine ligand of the phosphorescent compound (B) is a ligand not having an aryl group and a monovalent heterocyclic group. The phenylisoquinoline ligand of the phosphorescent compound (C) is a ligand not having an aryl group and a monovalent heterocyclic group.

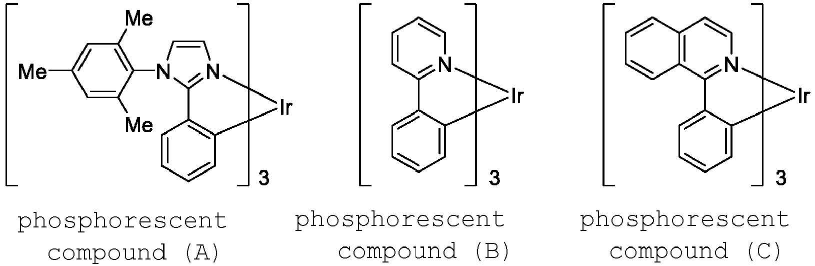

### Prior Art Document

### Patent Document

Patent document 1: International Publication WO2009/116414

### Summary of the Invention

### Problem to be Solved by the Invention

The light emitting device produced by using the above-described composition, however, has a problem of high driving voltage.

Then, the present invention has an object of providing a composition which is useful for producing a light emitting device the driving voltage of which is low. Further, the present invention has an object of providing a light emitting device comprising the composition.

### Means for Solving the Problem

The present invention provides the following [1] to [8].
[1] A composition comprising
   a phosphorescent compound represented by the formula (1-A1) or (1-A3) and
   a phosphorescent compound represented by the formula (2-B1) or (2-B2),
   wherein the maximum peak wavelength of the emission spectrum of the phosphorescent compound represented by the formula (1-A1) or (1-A3) is 380 nm or more and less than 495 nm, and
   the maximum peak wavelength of the emission spectrum of the phosphorescent compound represented by the formula (2-B1) or (2-B2) is 495 nm or more and less than 750 nm: 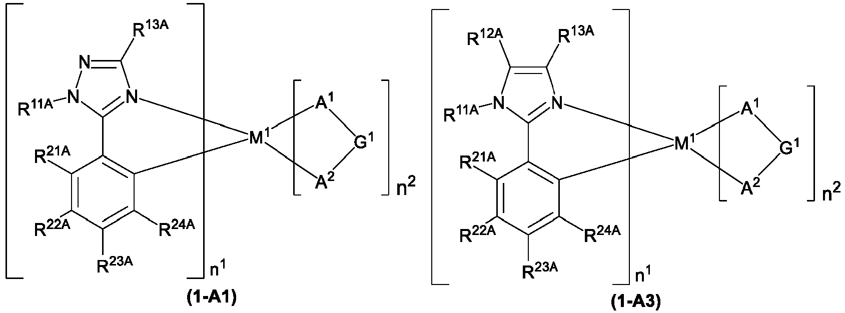 [wherein,
   M¹ represents an iridium atom.
   n¹ represents an integer of 1 or more, n² represents an integer of 0 or more, and n¹+n² is 3.
   R^{11A}, R^{12A}, R^{13A}, R^{21A}, R^{22A}, R^{23A} and R^{24A} each independently represent a substituent that is constituted of atoms selected from the group consisting of a hydrogen atom, a carbon atom, a nitrogen atom, an oxygen atom and a sulfur atom, and more specifically wherein R^{11A}, R^{12A}, R^{13A}, R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent heterocyclic group or a substituted amino group and these groups each optionally have a substituent, and when a plurality of R^{11A}, R^{12A}, R^{13A}, R^{21A}, R^{22A}, R^{23A} and R^{24A} are present, they may be the same or different at each occurrence, and R^{21A} and R^{22A}, R^{22A} and R^{23A}, and R^{23A} and R^{24A} each may be combined together to form a ring together with the atoms to which they are attached, and at least one selected from the group consisting of R^{11A}, R^{12A}, R^{13A}, R^{21A}, R^{22A}, R^{23A} and R^{24A} is a group represented by the formula (1-S1).

   The ligand constituted of the triazole or imidazole ring and the benzene ring is a ligand constituted of atoms selected from the group consisting of a hydrogen atom, a carbon atom, a nitrogen atom, an oxygen atom and a sulfur atom.
   A¹-G¹-A² represents an anionic bidentate ligand. A¹ and A² each independently represent a carbon atom, an oxygen atom or a nitrogen atom, and these atoms may be an atom constituting a ring. G¹ represents a single bond or an atomic group constituting the bidentate ligand together with A¹ and A². When a plurality of A¹-G¹-A² are present, they may be the same or different.] 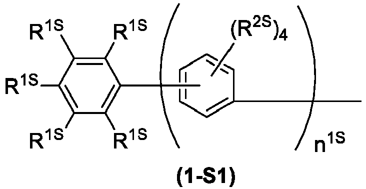 [wherein,
   n^{1s} represents an integer of 0 to 2.
   R^{1s} and R^{2s} each independently represent a hydrogen atom, an alkyl group, a cycloalkyl group, an alkoxy group or a cycloalkoxy group and these groups each optionally have a substituent, and the plurality of R^{1s} may be the same or different, and the plurality of R^{2s} may be the same or different.] 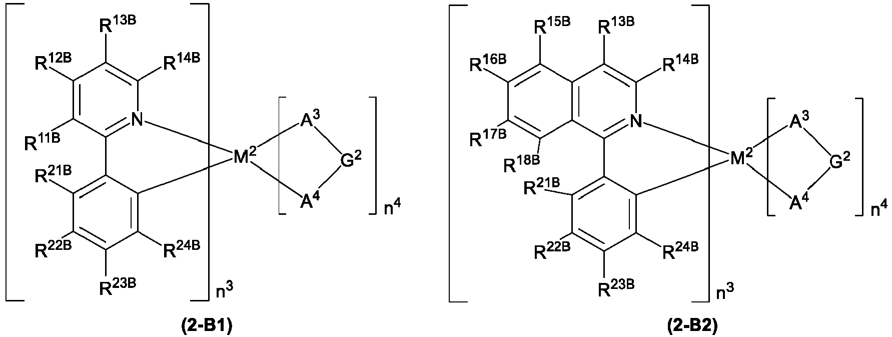
   [wherein,
   M² represents an iridium atom.
   n³ represents an integer of 1 or more, n⁴ represents an integer of 0 or more, and n³+n⁴ is 3.
   R^{11B}, R^{12B}, R^{13B}, R^{14B}, R^{21B}, R^{22B}, R^{23B} and R^{24B} each independently represent a hydrogen atom, an alkyl group, a cycloalkyl group, an alkoxy group, a cycloalkoxy group, an aryl group, an aryloxy group or a monovalent heterocyclic group and these groups each optionally have a substituent, and when a plurality of R^{11B}, R^{12B}, R^{13B}, R^{14B}, R^{21B}, R^{22B}, R^{23B} and R^{24B} are present, they may be the same or different at each occurrence, and R^{11B} and R^{12B}, R^{12B} and R^{13B}, R^{13B} and R^{14B}, R^{11B} and R^{21B}, R^{21B} and R^{22B}, R^{22B} and R^{23B}, and R^{23B} and R^{24B} each may be combined together to form a ring together with the atoms to which they are attached.
   R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group or a monovalent heterocyclic group and these groups each optionally have a substituent, and when a plurality of R^{13B}, R^{16B}, R^{17B} and R^{18B} are present, they may be the same or different at each occurrence, and R^{15B} and R^{16B}, R^{16B} and R^{17B}, and R^{17B} and R^{18B} each may be combined together to form a ring together with the atoms to which they are attached.
   At least one selected from the group consisting of R^{11B}, R^{12B}, R^{13B}, R^{14B}, R^{22B}, R^{22B}, R^{23B} and R^{24B} is a group represented by the formula (1-T1).

   The ligand constituted of the pyridine, quinoline or isoquinoline ring and the benzene ring is a ligand constituted of atoms selected from the group consisting of a hydrogen atom, a carbon atom, a nitrogen atom, an oxygen atom and a sulfur atom.
   A³-G²-A⁴ represents an anionic bidentate ligand. A³ and A⁴ each independently represent a carbon atom, an oxygen atom or a nitrogen atom, and these atoms may be an atom constituting a ring. G² represents a single bond or an atomic group constituting the bidentate ligand together with A³ and A⁴. When a plurality of A³-G²-A⁴ are present, they may be the same or different.] 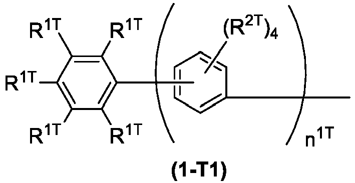 [wherein,
   n^{1T} represents an integer of 0 to 2.
   R^{1T} and R^{2T} each independently represent a hydrogen atom, an alkyl group, a cycloalkyl group, an alkoxy group or a cycloalkoxy group and these groups each optionally have a substituent, and the plurality of R^{1T} may be the same or different, and the plurality of R^{2T} may be the same or different.].
[2] The composition according to [1], wherein n¹ is 3.
[3] The composition according to [1] or [2], wherein the group represented by the formula (1-S1) is a group represented by the formula (1-S1-1), a group represented by the formula (1-S1-2), a group represented by the formula (1-S1-3) or a group represented by the formula (1-S1-4): 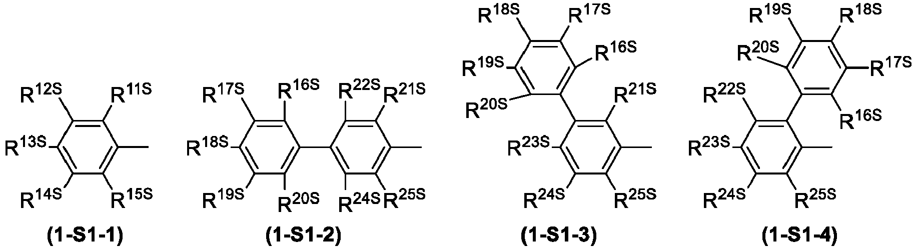 [wherein,
   R^{11s}, R^{12s}, R^{13s}, R^{14s}, R^{25s}, R^{16s}, R^{17s}, R^{18s}, R^{19s}, R^{20s}, R^{21s}, R^{22s}, R^{23s}, R^{24s} and R^{25s} each independently represent a hydrogen atom, an alkyl group, a cycloalkyl group, an alkoxy group or a cycloalkoxy group, and these groups each optionally have a substituent.].
[4] The composition according to any one of [1] to [3], wherein the group represented by the formula (1-T1) is a group represented by the formula (1-T1-1), a group represented by the formula (1-T1-2), a group represented by the formula (1-T1-3) or a group represented by the formula (1-T1-4): 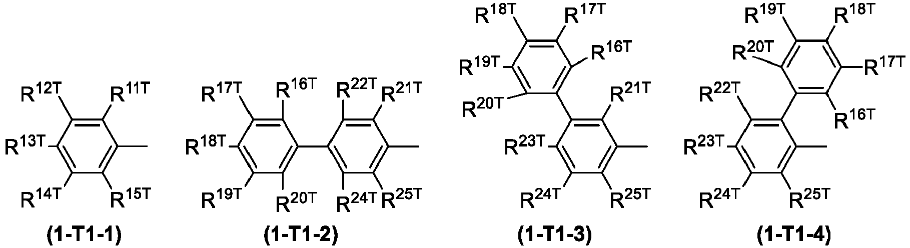 [wherein,
   R^{11T}, R^{12T}, R^{13T}, R^{14T}, R^{25T}, R^{16T}, R^{17T}, R^{18T}, R^{19T}, R^{20T}, R^{21T}, R^{22T}, R^{23T}, R^{24T} and R^{25T} each independently represent a hydrogen atom, an alkyl group, a cycloalkyl group, an alkoxy group or a cycloalkoxy group, and these groups each optionally have a substituent.].
[5] The composition according to any one of [1] to [4], further comprising a compound represented by the formula (H-1) : 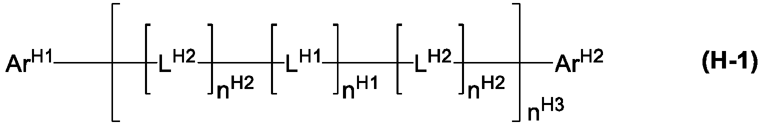 [wherein,
   Ar^{H1} and Ar^{H2} each independently represent an aryl group or a monovalent heterocyclic group, and these groups each optionally have a substituent.
   n^{H1} and n^{H2} each independently represent 0 or 1. When a plurality of n^{H1} are present, they may be the same or different. The plurality of n^{H2} may be the same or different.
   n^{H3} represents an integer of 0 or more.
   L^{H1} represents an arylene group, a divalent heterocyclic group or a group represented by -[C(R^{H11})₂]n^{H11}-, and these groups each optionally have a substituent. When a plurality of L^{H1} are present, they may be the same or different.
   n^{H11} represents an integer of 1 to 10. R^{H11} represents a hydrogen atom, an alkyl group, a cycloalkyl group, an alkoxy group, a cycloalkoxy group, an aryl group or a monovalent heterocyclic group, and these groups each optionally have a substituent. The plurality of R^{H11} may be the same or different and may be combined together to form a ring together with the carbon atoms to which they are attached.
   L^{H2} represents a group represented by -N(-L^{H21}-R^{H21})-. When a plurality of L^{H2} are present, they may be the same or different.
   L^{H21} represents a single bond, an arylene group or a divalent heterocyclic group, and these groups each optionally have a substituent. R^{H21} represents a hydrogen atom, an alkyl group, a cycloalkyl group, an aryl group or a monovalent heterocyclic group, and these groups each optionally have a substituent.].
[6] The composition according to any one of [1] to [4], further comprising a polymer compound comprising a constitutional unit represented by the formula (Y):

   -[-Ar^{Y1}-]- (Y)

   [wherein, Ar^{Y1} represents an arylene group, a divalent heterocyclic group or a divalent group in which at least one arylene group and at least one divalent heterocyclic group are bonded directly to each other, and these groups each optionally have a substituent.].
[7] The composition according to any one of [1] to [6], further comprising at least one material selected from the group consisting of a hole transporting material, a hole injection material, an electron transporting material, an electron injection material, a light emitting material, an antioxidant and a solvent.
[8] A light emitting device comprising the composition according to any one of [1] to [6].

All the other embodiments/examples described in the description and which do not fall under the scope of the appended set of claims are provided as reference.

### Effect of the Invention

According to the present invention, a composition which is useful for production of a light emitting device the driving voltage of which is low can be provided. Further, according to the present invention, a light emitting device comprising the composition can be provided.

### Modes for Carrying Out the Invention

Suitable embodiments of the present invention will be illustrated in detail below.

### <Explanation of common term>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a heavy hydrogen atom or a light hydrogen atom.

A solid line representing a bond to a central metal in a formula representing a metal complex denotes a covalent bond or a coordinate bond.

"Polymer compound" denotes a polymer having molecular weight distribution and having a polystyrene-equivalent number average molecular weight of 1×10³ to 1×10⁸.

A polymer compound may be any of a block copolymer, a random copolymer, an alternating copolymer and a graft copolymer, and may also be another embodiment.

An end group of a polymer compound is preferably a stable group because if a polymerization active group remains intact at the end, when the polymer compound is used for fabrication of a light emitting device, the light emitting property or luminance life possibly becomes lower. This end group is preferably a group having a conjugated bond to the main chain, and includes, for example, groups bonding to an aryl group or a monovalent heterocyclic group via a carbon-carbon bond.

"Low molecular weight compound" denotes a compound having no molecular weight distribution and having a molecular weight of 1×10⁴ or less.

"Constitutional unit" denotes a unit structure found once or more in a polymer compound.

"Alkyl group" may be any of linear or branched. The number of carbon atoms of the linear alkyl group is, not including the number of carbon atoms of a substituent, usually 1 to 50, preferably 3 to 30, more preferably 4 to 20. The number of carbon atoms of the branched alkyl groups is, not including the number of carbon atoms of a substituent, usually 3 to 50, preferably 3 to 30, more preferably 4 to 20.

The alkyl group optionally has a substituent, and examples thereof include a methyl group, an ethyl group, a propyl group, an isopropyl group, a butyl group, an isobutyl group, a tert-butyl group, a pentyl group, an isoamyl group, a 2-ethylbutyl group, a hexyl group, a heptyl group, an octyl group, a 2-butyl group, a 2-ethylhexyl group, a 3-propylheptyl group, a decyl group, a 3, 7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom or the like, and the alkyl group having a substituent includes a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl) propyl group and a 6-ethyloxyhexyl group.

The number of carbon atoms of "Cycloalkyl group" is, not including the number of carbon atoms of a substituent, usually 3 to 50, preferably 3 to 30, more preferably 4 to 20.

The cycloalkyl group optionally has a substituent, and examples thereof include a cyclohexyl group, a cyclohexylmethyl group and a cyclohexylethyl group.

"Aryl group" denotes an atomic group remaining after removing from an aromatic hydrocarbon one hydrogen atom linked directly to a carbon atom constituting the ring. The number of carbon atoms of the aryl group is, not including the number of carbon atoms of a substituent, usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, and groups obtained by substituting a hydrogen atom in these groups with an alkyl group, a cycloalkyl group, an alkoxy group, a cycloalkoxy group, an aryl group, a fluorine atom or the like.

"Alkoxy group" may be any of linear or branched. The number of carbon atoms of the linear alkoxy group is, not including the number of carbon atoms of a substituent, usually 1 to 40, preferably 4 to 10. The number of carbon atoms of the branched alkoxy group is, not including the number of carbon atoms of a substituent, usually 3 to 40, preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of "Cycloalkoxy group" is, not including the number of carbon atoms of a substituent, usually 3 to 40, preferably 4 to 10.

The cycloalkoxy group optionally has a substituent, and examples thereof include a cyclohexyloxy group.

The number of carbon atoms of "Aryloxy group" is, not including the number of carbon atoms of a substituent, usually 6 to 60, preferably 6 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group, a 1-pyrenyloxy group, and groups obtained by substituting a hydrogen atom in these groups with an alkyl group, a cycloalkyl group, an alkoxy group, a cycloalkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms of the monovalent heterocyclic group is, not including the number of carbon atoms of a substituent, usually 2 to 60, preferably 4 to 20.

The monovalent heterocyclic group optionally has a substituent, and examples thereof include a thienyl group, a pyrrolyl group, a furyl group, a pyridyl group, a piperidinyl group, a quinolinyl group, an isoquinolinyl group, a pyrimidinyl group, a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear or branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of "Cycloalkenyl group", not including the number of carbon atoms of the substituent, is usually 3 to 30, preferably 4 to 20.

The alkenyl group and cycloalkenyl group each optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups having a substituent.

"Alkynyl group" may be any of linear or branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of "Cycloalkynyl group", not including the number of carbon atoms of the substituent, is usually 4 to 30, preferably 4 to 20.

The alkynyl group and cycloalkynyl group each optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and these groups having a substituent.

"Arylene group" denotes an atomic group remaining after removing from an aromatic hydrocarbon two hydrogen atoms linked directly to carbon atoms constituting the ring. The number of carbon atoms of the arylene group is, not including the number of carbon atoms of a substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, preferably, groups represented by the formulae (A-1) to (A-20) . The arylene group includes groups obtained by linking a plurality of these groups. 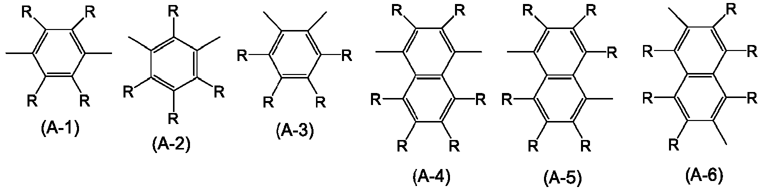 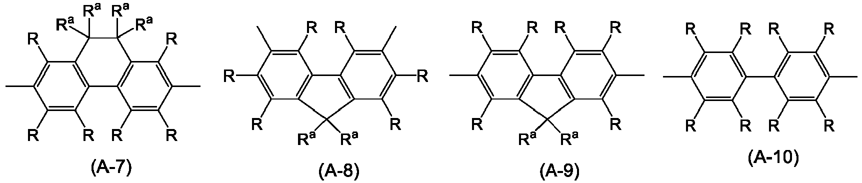 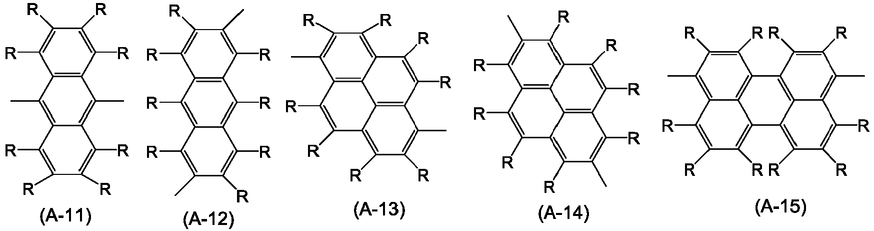 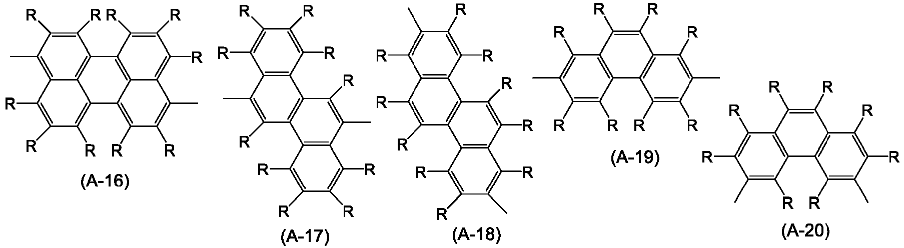 [wherein, R and R^{a} each independently represent a hydrogen atom, an alkyl group, a cycloalkyl group, an aryl group or a monovalent heterocyclic group. The plurality of R and R^{a} each may be the same or different, and groups R^{a} may be combined together to form a ring together with the atoms to which they are attached.]

The number of carbon atoms of the divalent heterocyclic group is, not including the number of carbon atoms of a substituent, usually 2 to 60, preferably 3 to 20, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the ring, preferably groups represented by the formulae (AA-1) to (AA-34). The divalent heterocyclic group includes groups obtained by linking a plurality of these groups. 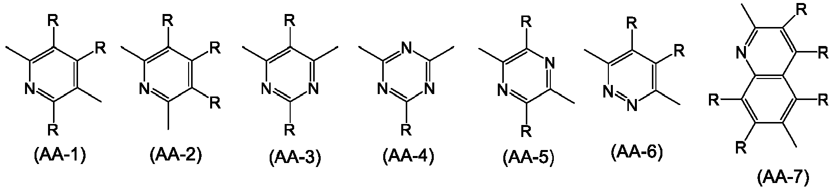 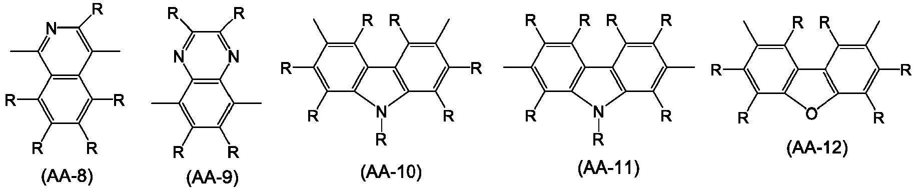 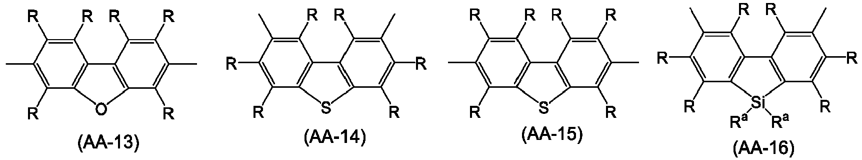 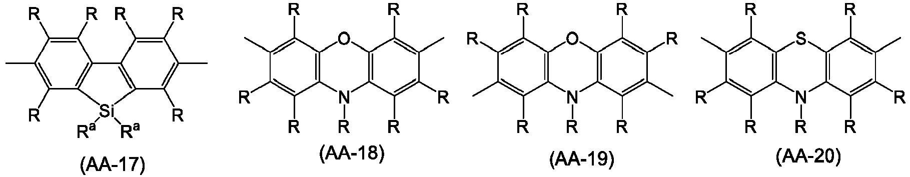 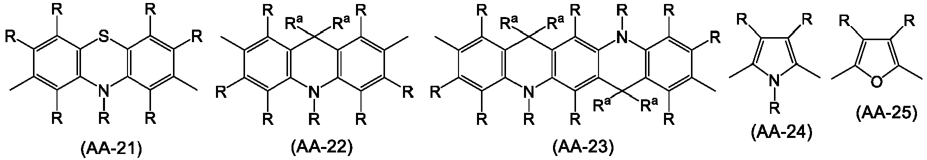 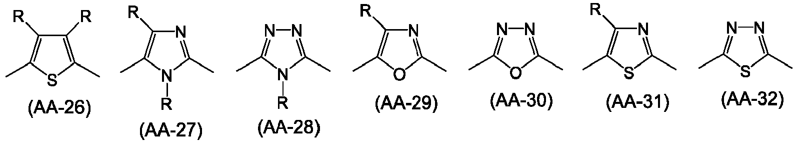 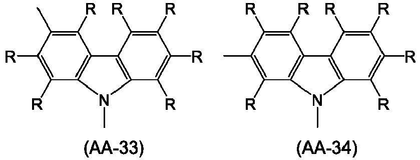 [wherein, R and R^{a} represent the same meaning as described above.]

"Crosslinkable group" is a group capable of forming a new bond by being subjected to a heating treatment, an ultraviolet irradiation treatment, a near ultraviolet irradiation treatment, a visible light irradiation treatment, an infrared irradiation treatment, a radical reaction and the like, and the crosslinkable groups are preferably groups represented by the formulae (XL-1) to (XL-17) in Group A of crosslinkable group.

### (Group A of crosslinkable group)

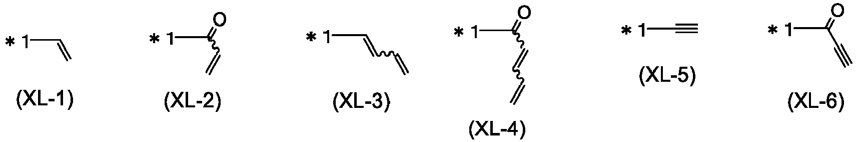

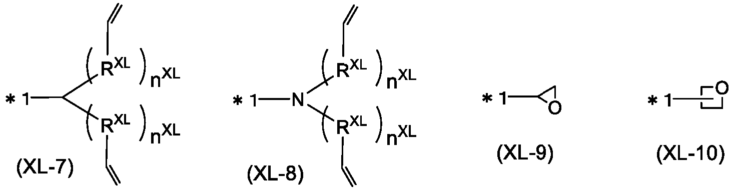

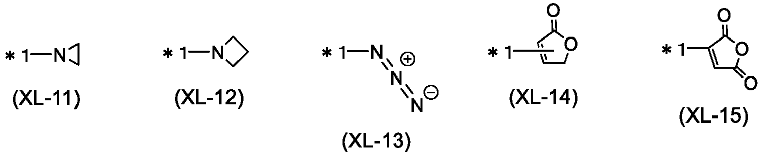

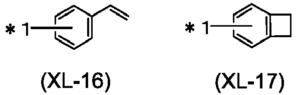

[wherein, R^{XL} represents a methylene group, an oxygen atom or a sulfur atom, and n^{XL} represents an integer of 0 to 5. When a plurality of R^{XL} are present, they may be the same or different, and when a plurality of n^{XL} are present, they may be the same or different. *1 represents a binding position. These crosslinkable groups each optionally have a substituent.]

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be a crosslinkable group.

### <Phosphorescent compound>

"Phosphorescent compound" denotes a compound showing a phosphorescent property, preferably is a metal complex showing emission from the triplet excited state. This metal complex showing emission from the triplet excited state has a central metal atom and a ligand.

As the central metal atom, exemplified are metal atoms having an atomic number of 40 or more, showing a spin-orbit interaction with the complex, and capable of causing intersystem crossing between the singlet state and the triplet state. Exemplified as the metal atom are a ruthenium atom, a rhodium atom, a palladium atom, an iridium atom and a platinum atom.

As the ligand, exemplified are neutral or anionic monodentate ligands or neutral or anionic polydentate ligands forming at least one bond selected from the group consisting of a coordinate bond and a covalent bond between it and the central metal atom. As the bond between the central metal atom and the ligand, exemplified are a metal-nitrogen bond, a metal-carbon bond, a metal-oxygen bond, a metal-phosphorus bond, a metal-sulfur bond and a metal-halogen bond. The polydentate ligand denotes usually a bidentate or more and hexadentate or less ligand.

The phosphorescent compounds are available from Aldrich, Luminescence Technology Corp., American Dye Source and the like.

As the obtaining method other than the above-described means, known methods described in literatures such as "Journal of the American Chemical Society, Vol. 107, 1431-1432 (1985)", "Journal of the American Chemical Society, Vol. 106, 6647-6653 (1984)", International Publication WO 2004/026886, International Publication WO 2006/121811, International Publication WO 2011/024761, and International Publication WO 2007/097153 can also be used to produce the phosphorescent compounds.

The emission spectrum maximum peak of the phosphorescent compound can be evaluated by dissolving the phosphorescent compound in an organic solvent such as xylene, toluene, chloroform, tetrahydrofuran and the like to prepare a dilute solution (about 1×10⁶ to 1×10⁻³ wt%) and measuring the PL spectrum of the dilute solution at room temperature. The organic solvent for dissolving the phosphorescent compound is preferably xylene.

### <Phosphorescent compound represented by the formula (1)>

Described herein is a phosphorescent compound represented by the formula (1).

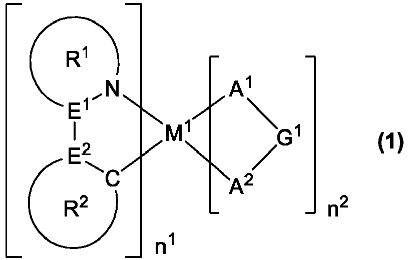

The composition of the present invention comprises a phosphorescent compound represented by the formula (1-A1) or (1-A3).

The phosphorescent compound represented by the formula (1) is a phosphorescent compound constituted of M¹ as a central metal, a ligand of which number is ruled by a suffix n¹ and a ligand of which number is ruled by a suffix n².

M¹ is preferably an iridium atom or a platinum atom, more preferably an iridium atom, because the driving voltage of a light emitting device comprising the composition of the present invention becomes lower. In the present invention, M¹ is an iridium atom.

When M¹ is a ruthenium atom, a rhodium atom or an iridium atom, n¹ is preferably 2 or 3, more preferably 3.

When M¹ is a palladium atom or a platinum atom, n¹ is preferably 2.

It is preferable that E¹ and E² represent a carbon atom.

The ring R¹ is preferably a 5-membered aromatic heterocyclic ring having two or more and three or less nitrogen atoms as a constituent atom, more preferably a diazole ring or a triazole ring, and these rings each optionally have a substituent. At least one ring selected from the group consisting of the ring R¹ and the ring R² has a group represented by the formula (1-S).

The ring R² is preferably a 5-membered or 6-membered aromatic hydrocarbon ring or a 5-membered or 6-membered aromatic heterocyclic ring, more preferably a 6-membered aromatic hydrocarbon ring or a 6-membered aromatic heterocyclic ring, further preferably a 6-membered aromatic hydrocarbon ring, and these rings each optionally have a substituent. When the ring R² is a 6-membered aromatic heterocyclic ring, E² is a carbon atom. At least one ring selected from the group consisting of the ring R¹ and the ring R² has a group represented by the formula (1-S).

The ring R² includes, for example, a benzene ring, a naphthalene ring, a fluorene ring, a phenanthrene ring, a pyridine ring, a diazabenzene ring and a triazine ring, and is preferably a benzene ring, a pyridine ring or a pyrimidine ring, more preferably a benzene ring, and these rings each optionally have a substituent. At least one ring selected from the group consisting of the ring R¹ and the ring R² has a group represented by the formula (1-S).

"The ligand constituted of the ring R¹ and the ring R² is a ligand constituted of atoms selected from the group consisting of a hydrogen atom, a carbon atom, a nitrogen atom, an oxygen atom and a sulfur atom" denotes that the ring R² and the ring R² are constituted of atoms selected from the group consisting of a hydrogen atom, a carbon atom, a nitrogen atom, an oxygen atom and a sulfur atom and the substituent which the rings have is constituted of atoms selected from the group consisting of a hydrogen atom, a carbon atom, a nitrogen atom, an oxygen atom and a sulfur atom.

The ligand constituted of the ring R¹ and the ring R² is preferably a ligand constituted of atoms selected from the group consisting of a hydrogen atom, a carbon atom, a nitrogen atom and an oxygen atom, more preferably a ligand constituted of a hydrogen atom, a carbon atom and a nitrogen atom.

"At least one ring selected from the group consisting of the ring R¹ and the ring R² has a group represented by the formula (1-S)" denotes that a part or all of hydrogen atoms bonding directly to carbon atoms or nitrogen atoms constituting at least one ring among a plurality of rings are substituted with a group represented by the formula (1-S) When a plurality of the rings R¹ and the rings R² are present (namely, when n¹ is 2 or 3) in the phosphorescent compound represented by the formula (1), at least one ring of the plurality of the rings R¹ and the rings R² has a group represented by the formula (1-S), and it is preferable that all the plurality of the rings R¹, all the plurality of the rings R², or all the plurality of the rings R¹ and the rings R² have a group represented by the formula (1-S) , and it is more preferable that all the plurality of the rings R¹ have a group represented by the formula (1-S).

It is preferable that the ring R¹ has a group represented by the formula (1-S).

The substituent which the ring R¹ and the ring R² optionally have (differing from a group represented by the formula (1-S) ) is preferably an alkyl group, a cycloalkyl group, an aryl group, a monovalent heterocyclic group, an alkoxy group, a cycloalkoxy group, an aryloxy group or a substituted amino group, more preferably an alkyl group, a cycloalkyl group, an aryl group or a monovalent heterocyclic group, further preferably an alkyl group, a cycloalkyl group or an aryl group, particularly preferably an alkyl group or a cycloalkyl group, and these groups each optionally further have a substituent.

When a plurality of the substituents (differing from a group represented by the formula (1-S) ) which the ring R¹ optionally has are present, they may be the same or different and may be combined together to form a ring together with the atoms to which they are attached, and it is preferable that a ring is not formed because the maximum peak wavelength of the emission spectrum of a phosphorescent compound represented by the formula (1) becomes shorter.

When a plurality of the substituents (differing from a group represented by the formula (1-S) ) which the ring R² optionally has are present, they may be the same or different and may be combined together to form a ring together with the atoms to which they are attached, and it is preferable that a ring is not formed because the maximum peak wavelength of the emission spectrum of a phosphorescent compound represented by the formula (1) becomes shorter.

### [Group represented by the formula (1-S)]

Described herein is a group represented by the formula (1-S). In the present invention, the group represented by the formula (1-S) is a group represented by the formula (1-S1).

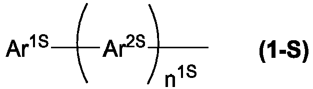

The aryl group represented by Ar^{1s} is preferably a phenyl group, a naphthyl group, an anthracenyl group, a phenanthrenyl group, a dihydrophenanthrenyl group, a fluorenyl group or a pyrenyl group, more preferably a phenyl group, a naphthyl group or a fluorenyl group, further preferably a phenyl group, and these groups each optionally have an alkyl group, a cycloalkyl group, an alkoxy group or a cycloalkoxy group as a substituent. The alkyl group, the cycloalkyl group, the alkoxy group and the cycloalkoxy group each optionally further have a substituent.

Ar^{1s} is preferably a phenyl group, and this phenyl group optionally has an alkyl group, a cycloalkyl group, an alkoxy group or a cycloalkoxy group as a substituent. The alkyl group, the cycloalkyl group, the alkoxy group and the cycloalkoxy group each optionally further have a substituent.

n^{1s} is preferably an integer of 0 to 5, more preferably an integer of 0 to 2, further preferably 0 or 1. In the present invention, n^{1s} is an integer of 0 to 2.

The arylene group represented by Ar^{2s} is preferably a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group or a chrysenediyl group, more preferably a phenylene group, a naphthalenediyl group or a fluorenediyl group, further preferably a phenylene group, and the these groups each optionally have an alkyl group, a cycloalkyl group, an alkoxy group or a cycloalkoxy group as a substituent. The alkyl group, the cycloalkyl group, the alkoxy group and the cycloalkoxy group each optionally further have a substituent.

Ar^{2s} preferably a phenylene group, and this phenylene group optionally has an alkyl group, a cycloalkyl group, an alkoxy group or a cycloalkoxy group as a substituent. The alkyl group, the cycloalkyl group, the alkoxy group and the cycloalkoxy group each optionally further have a substituent.

The substituent which Ar^{1s} and Ar^{2s} optionally have is preferably an alkyl group or a cycloalkyl group, more preferably an alkyl group, and these groups each optionally further have a substituent.

The substituent which the substituent which Ar^{1s} and Ar^{2s} optionally have optionally further has is preferably an alkyl group, a cycloalkyl group, an aryl group, a monovalent heterocyclic group, an alkoxy group, a cycloalkoxy group, an aryloxy group or a substituted amino group, more preferably an alkyl group, a cycloalkyl group, an aryl group or a monovalent heterocyclic group, further preferably an alkyl group or a cycloalkyl group.

It is preferable that the substituent which Ar^{1s} and Ar^{2s} optionally have (namely, an alkyl group, a cycloalkyl group, an alkoxy group and a cycloalkoxy group) do not further have a substituent.

The group represented by the formula (1-S) is preferably a group represented by the formula (1-S1), because the driving voltage of a light emitting device comprising the composition of the present invention becomes lower.

R^{1s} and R^{2s} are preferably a hydrogen atom, an alkyl group or a cycloalkyl group, more preferably a hydrogen atom or an alkyl group, and these groups each optionally have a substituent.

The substituent which R^{1s} and R^{2s} optionally have is preferably an alkyl group, a cycloalkyl group, an aryl group, a monovalent heterocyclic group, an alkoxy group, a cycloalkoxy group, an aryloxy group or a substituted amino group, more preferably an alkyl group, a cycloalkyl group, an aryl group or a monovalent heterocyclic group, further preferably an alkyl group or a cycloalkyl group.

It is preferable that R^{1s} and R^{2s} do not have a substituent.

At least one of the plurality of R^{1s} and the plurality of R^{2s} is preferably an alkyl group, a cycloalkyl group, an alkoxy group or a cycloalkoxy group, more preferably an alkyl group or a cycloalkyl group, further preferably an alkyl group, and these groups each optionally have a substituent.

The group represented by the formula (1-S1) is preferably a group represented by the formula (1-S1-1), a group represented by the formula (1-S1-2), a group represented by the formula (1-S1-3) or a group represented by the formula (1-S1-4), more preferably a group represented by the formula (1-S1-1) or a group represented by the formula (1-S1-2), because the driving voltage of a light emitting device comprising the composition of the present invention becomes lower.

R^{11s} to R^{25s} are preferably a hydrogen atom, an alkyl group or a cycloalkyl group, more preferably a hydrogen atom or an alkyl group, and these groups each optionally have a substituent.

The substituent which R^{11s} to R^{25s} optionally have is preferably an alkyl group, a cycloalkyl group, an aryl group, a monovalent heterocyclic group, an alkoxy group, a cycloalkoxy group, an aryloxy group or a substituted amino group, more preferably an alkyl group, a cycloalkyl group, an aryl group or a monovalent heterocyclic group, further preferably an alkyl group or a cycloalkyl group.

It is preferable that R^{11s} to R^{25s} do not have a substituent.

At least one of R^{11s} to R^{15s} is preferably an alkyl group, a cycloalkyl group, an alkoxy group or a cycloalkoxy group, more preferably an alkyl group or a cycloalkyl group, further preferably an alkyl group, and these groups each optionally have a substituent.

At least one of R^{11s}, R^{13s} and R^{15s} is preferably an alkyl group, a cycloalkyl group, an alkoxy group or a cycloalkoxy group, more preferably an alkyl group or a cycloalkyl group, further preferably an alkyl group, and these groups each optionally have a substituent.

At least one of R^{16s} to R^{25s} is preferably an alkyl group, a cycloalkyl group, an alkoxy group or a cycloalkoxy group, more preferably an alkyl group or a cycloalkyl group, further preferably an alkyl group, and these groups each optionally have a substituent.

At least one of R^{18s}, R^{21s} and R^{25s} is preferably an alkyl group, a cycloalkyl group, an alkoxy group or a cycloalkoxy group, more preferably an alkyl group or a cycloalkyl group, further preferably an alkyl group, and these groups each optionally have a substituent.

The group represented by the formula (1-S) includes, for example, groups represented by the formulae (1-S-1) to (1-S-30), and is preferably a group represented by the formulae (1-S-1) to (1-S-23) , more preferably a group represented by the formulae (1-S-1) to (1-S-19).

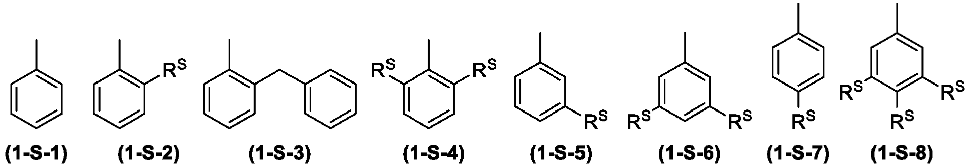

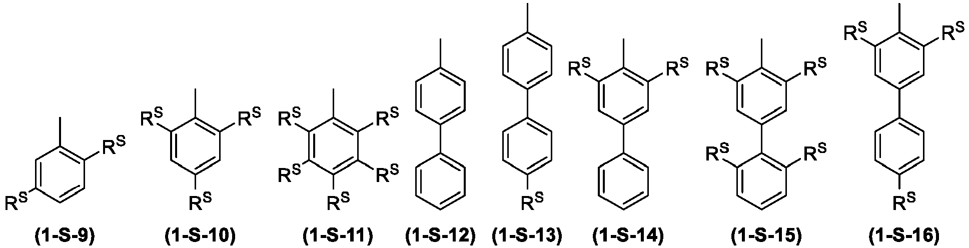

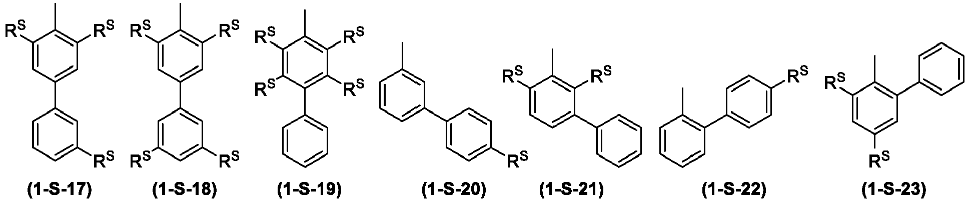

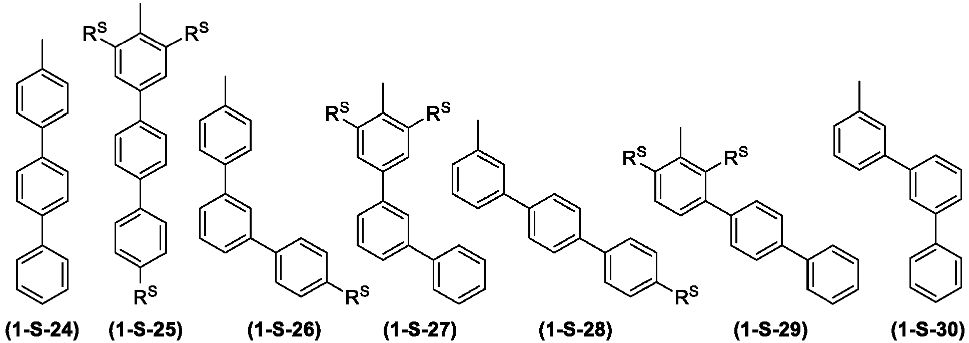

R^{S} represents a methyl group, an ethyl group, an isopropyl group, a tert-butyl group, a hexyl group, a 2-ethylhexyl group, a cyclohexyl group, a methoxy group, a 2-ethylhexyloxy group or a cyclohexyloxy group, and is preferably a methyl group, an ethyl group, an isopropyl group, a tert-butyl group, a hexyl group or a 2-ethylhexyl group. When a plurality of R^{S} are present, they may be the same or different.

### [Anionic bidentate ligand]

The anionic bidentate ligand represented by A¹-G¹-A² and the anionic bidentate ligand represented by A³-G²-A⁴ described later include, for example, ligands shown below. 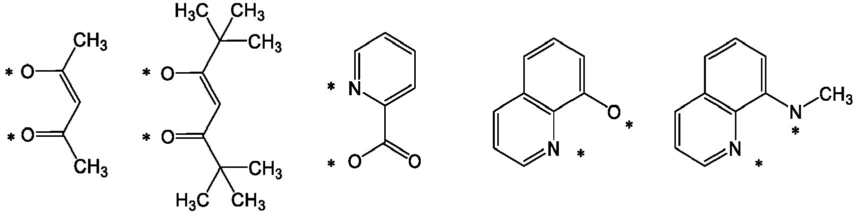 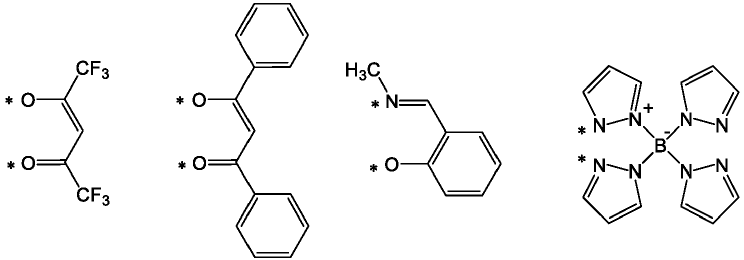 [wherein, * represents a site binding to M¹ or M² described later.]

The anionic bidentate ligand represented by A¹-G¹-A² and the anionic bidentate ligand represented by A³-G²-A⁴ described later may also be ligands shown below. 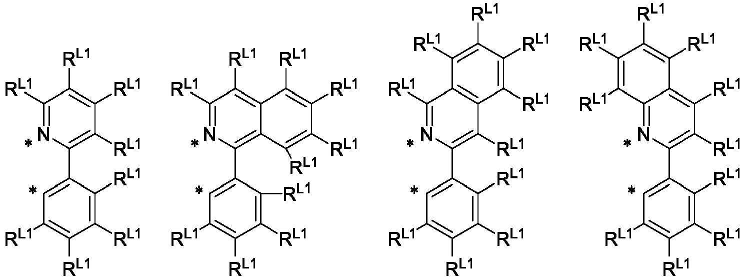 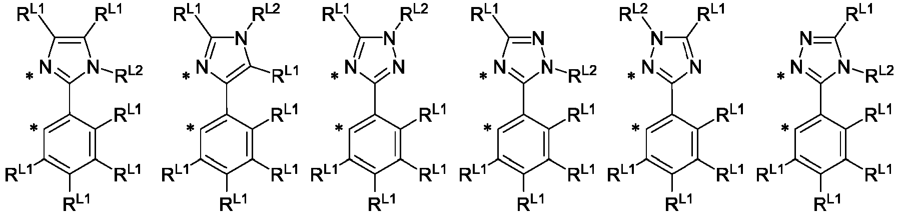 [wherein,
* represents a site binding to M¹ or M² described later.
R^{L1} represents a hydrogen atom, an alkyl group, a cycloalkyl group or a halogen atom, and these groups each optionally have a substituent. The plurality of R^{L1} may be the same or different.
R^{L2} represents an alkyl group, a cycloalkyl group or a halogen atom, and these groups each optionally have a substituent.]

The phosphorescent compound represented by the formula (1) is preferably a phosphorescent compound represented by the formula (1-A), because the driving voltage of a light emitting device comprising the composition of the present invention becomes lower.

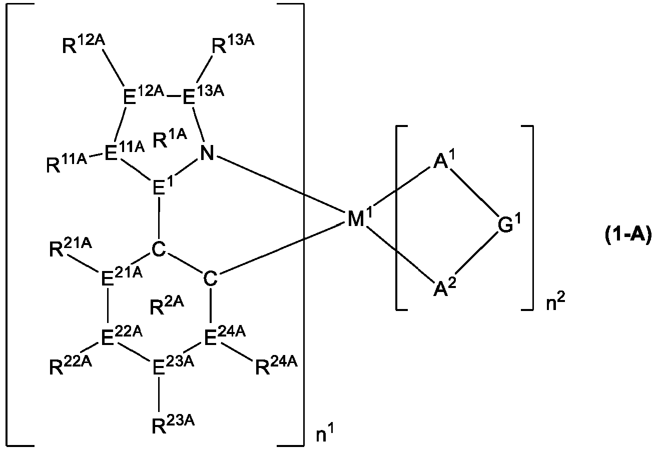

When the ring R^{1A} is a diazole ring, an imidazole ring in which E^{11A} is a nitrogen atom or an imidazole ring in which E^{12A} is a nitrogen atom is preferable, and an imidazole ring in which E^{11A} is a nitrogen atom is more preferable.

When the ring R^{1A} is a triazole ring, a triazole ring in which E^{11A} and E^{12A} are a nitrogen atom or a triazole ring in which E^{11A} and E^{13A} are a nitrogen atom is preferable, and a triazole ring in which E^{11A} and E^{12A} are a nitrogen atom is more preferable.

When E^{11A} is a nitrogen atom and R^{11A} is present, R^{11A} is preferably an alkyl group, a cycloalkyl group or a group represented by the formula (1-S), and these groups each optionally have a substituent.

When E^{11A} is a carbon atom, R^{11A} is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group, and these groups each optionally have a substituent.

When E^{12A} is a nitrogen atom and R^{12A} is present, R^{12A} is preferably an alkyl group, a cycloalkyl group or a group represented by the formula (1-S), and these groups each optionally have a substituent.

When E^{12A} is a carbon atom, R^{12A} is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group, and these groups each optionally have a substituent.

When E^{13a} is a nitrogen atom and R^{13A} is present, R^{13A} is preferably an alkyl group, a cycloalkyl group or a group represented by the formula (1-S), and these groups each optionally have a substituent.

When E^{13A} is a carbon atom, R^{13A} is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom, an alkyl group or a cycloalkyl group, and these groups each optionally have a substituent.

When the ring R^{1A} has a group represented by the formula (1-S), R^{11A} or R^{12A} is preferably a group represented by the formula (1-S), R^{11A} is more preferably a group represented by the formula (1-S).

When the ring R^{2A} is a pyridine ring, a pyridine ring in which E^{21A} is a nitrogen atom, a pyridine ring in which E^{22A} is a nitrogen atom or a pyridine ring in which E^{23A} is a nitrogen atom is preferable, and a pyridine ring in which E^{22A} is a nitrogen atom is more preferable.

When the ring R^{2A} is a pyrimidine ring, a pyrimidine ring in which E^{21A} and E^{23A} are a nitrogen atom or a pyrimidine ring in which E^{22A} and E^{24A} are a nitrogen atom is preferable, and a pyrimidine ring in which E^{22A} and E^{24A} are a nitrogen atom is more preferable.

The ring R^{2A} is preferably a benzene ring.

R^{21A}, R^{22A}, R^{23A} and R^{24A} represent preferably a hydrogen atom, an alkyl group, a cycloalkyl group or a group represented by the formula (1-S) , more preferably a hydrogen atom or a group represented by the formula (1-S), and these groups each optionally have a substituent.

When the ring R^{2A} has a group represented by the formula (1-S), it is preferable that R^{22A} or R^{23A} is a group represented by the formula (1-S) , it is more preferable that R^{22A} is a group represented by the formula (1-S).

R^{11A} and R^{12A}, R^{12A} and R^{13A}, R^{21A} and R^{22A}, R^{22A} and R^{23A}, and R^{23A} and R^{24A} each may be combined together to form a ring together with the atoms to which they are attached, but it is preferable to form no ring, because the maximum peak wavelength of the emission spectrum of a phosphorescent compound represented by the formula (1-A) becomes shorter. In the present invention, R^{21A} and R^{22A}, R^{22A} and R^{23A}, and R^{23A} and R^{24A} each may be combined together to form a ring together with the atoms to which they are attached.

The phosphorescent compound represented by the formula (1-A) is preferably a phosphorescent compound represented by the formula (1-A1), a phosphorescent compound represented by the formula (1-A2), a phosphorescent compound represented by the formula (1-A3) or a phosphorescent compound represented by the formula (1-A4), more preferably a phosphorescent compound represented by the formula (1-A1) or a phosphorescent compound represented by the formula (1-A3).

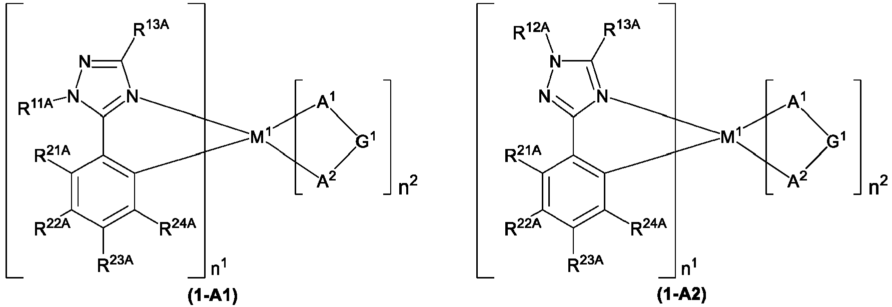

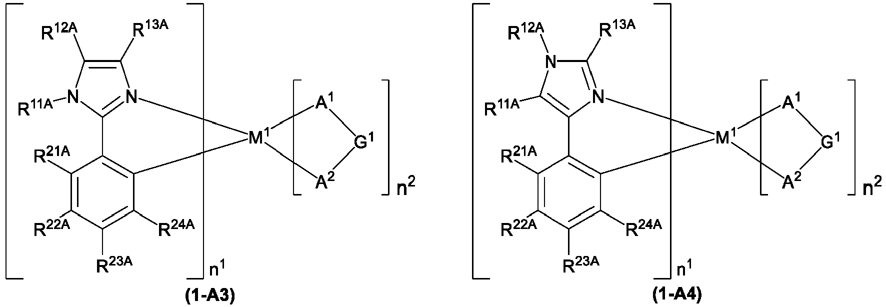

The phosphorescent compound represented by the formula (1-A1) includes, for example, phosphorescent compounds represented by the formulae (1-A1-1) to (1-A1-19), preferably is a phosphorescent compound represented by the formulae (1-A1-1) to (1-A1-16), more preferably a phosphorescent compound represented by the formulae (1-A1-1) to (1-A1-10).

**[Table 1]**

| Formula | M¹ | n¹ | R^{11A} | R^{13A} | R^{21A} | R^{22A} | R^{23A} | R^{24A} | n² | A¹-G¹-A² |
|---|---|---|---|---|---|---|---|---|---|---|
| (1-A1-1) | Ir | 3 | the formula (1-S-2) | Me | H | H | H | H | 0 | - |
| (1-A1-2) | Ir | 3 | the formula (1-S-9) | i-Pr | H | H | H | H | 0 | - |
| (1-A1-3) | Ir | 3 | the formula (1-S-10) | Me | H | H | H | H | 0 | - |
| (1-A1-4) | Ir | 3 | the formula (1-S-11) | C₃H₇ | H | H | H | H | 0 | - |
| (1-A1-5) | Ir | 3 | the formula (1-S-14) | C₃H₇ | H | H | H | H | 0 | - |
| (1-A1-6) | Ir | 3 | the formula (1-S-16) | Me | H | the formula (1-S-7) | H | H | 0 | - |
| (1-A1-7) | Ir | 3 | the formula (1-S-10) | Me | H | H | Me | H | 0 | - |
| (1-A1-8) | Ir | 3 | the formula (1-S-10) | Me | H | the formula (1-S-13) | H | H | 0 | - |
| (1-A1-9) | Ir | 3 | Me | C₃H₇ | H | the formula (1-S-7) | H | H | 0 | - |
| (1-A1-10) | Ir | 3 | Me | C₃H₇ | H | H | the formula (1-S-7) | H | 0 | - |

**[Table 2]**

| Formula | M¹ | n¹ | R^{11A} | R^{13A} | R^{21A} | R^{22A} | R^{23A} | R^{24A} | n² | A¹-G¹-A² |
|---|---|---|---|---|---|---|---|---|---|---|
| (1-A1-11) | Ir | 3 | the formula (1-S-6) | C₃H₇ | H | the formula (1-S-6) | H | H | 0 | - |
| (1-A1-12) | Ir | 3 | the formula (1-S-8) | C₃H₇ | H | the formula (1-S-10) | H | H | 0 | - |
| (1-A1-13) | Ir | 2 | the formula (1-S-10) | Me | H | H | H | H | 1 | 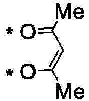 |
| (1-A1-14) | Ir | 2 | the formula (1-S-16) | Me | H | H | H | H | 1 | 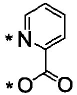 |
| (1-A1-15) | Pt | 2 | the formula (1-S-10) | C₃H₇ | H | H | H | H | 0 | - |
| (1-A1-16) | Pt | 2 | the formula (1-S-14) | Me | H | H | H | H | 0 | - |
| (1-A1-17) | Ru | 3 | the formula (1-S-10) | C₃H₇ | H | H | H | H | 0 | - |
| (1-A1-18) | Rh | 3 | the formula (1-S-10) | C₃H₇ | H | H | H | H | 0 | - |
| (1-A1-19) | Pd | 2 | the formula (1-S-10) | C₃H₇ | H | H | H | H | 0 | - |

The phosphorescent compound represented by the formula (1-A2) includes, for example, phosphorescent compounds represented by the formulae (1-A2-1) to (1-A2-19), and is preferably a phosphorescent compound represented by the formulae (1-A2-1) to (1-A2-16), more preferably a phosphorescent compound represented by the formulae (1-A2-1) to (1-A2-10).

**[Table 3]**

| Formula | M¹ | n¹ | R^{12A} | R^{13A} | R^{21A} | R^{22A} | R^{23A} | R^{24A} | n² | A¹-G¹-A² |
|---|---|---|---|---|---|---|---|---|---|---|
| (1-A2-1) | Ir | 3 | the formula (1-S-2) | Me | H | H | H | H | 0 | - |
| (1-A2-2) | Ir | 3 | the formula (1-S-9) | i-Pr | H | H | H | H | 0 | - |
| (1-A2-3) | Ir | 3 | the formula (1-S-10) | Me | H | H | H | H | 0 | - |
| (1-A2-4) | Ir | 3 | the formula (1-S-11) | C₃H₇ | H | H | H | H | 0 | - |
| (1-A2-5) | Ir | 3 | the formula (1-S-14) | C₃H₇ | H | H | H | H | 0 | - |
| (1-A2-6) | Ir | 3 | the formula (1-S-16) | Me | H | the formula (1-S-7) | H | H | 0 | - |
| (1-A2-7) | Ir | 3 | the formula (1-S-10) | Me | H | H | Me | H | 0 | - |
| (1-A2-8) | Ir | 3 | the formula (1-S-10) | Me | H | the formula (1-S-13) | H | H | 0 | - |
| (1-A2-9) | Ir | 3 | Me | C₃H₇ | H | the formula (1-S-7) | H | H | 0 | - |
| (1-A2-10) | Ir | 3 | Me | C₃H₇ | H | H | the formula (1-S-7) | H | 0 | - |

**[Table 4]**

| Formula | M¹ | n¹ | R^{12A} | R^{13A} | R^{21A} | R^{22A} | R^{23A} | R^{24A} | n² | A¹-G¹-A² |
|---|---|---|---|---|---|---|---|---|---|---|
| (1-A2-11) | Ir | 3 | the formula (1-S-6) | C₃H₇ | H | the formula (1-S-6) | H | H | 0 | - |
| (1-A2-12) | Ir | 3 | the formula (1-S-8) | C₃H₇ | H | the formula (1-S-10) | H | H | 0 | - |
| (1-A2-13) | Ir | 2 | the formula (1-S-10) | Me | H | H | H | H | 1 | 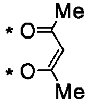 |
| (1-A2-14) | Ir | 2 | the formula (1-S-16) | Me | H | H | H | H | 1 | 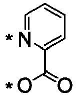 |
| (1-A2-15) | Pt | 2 | the formula (1-S-10) | C₃H₇ | H | H | H | H | 0 | - |
| (1-A2-16) | Pt | 2 | the formula (1-S-14) | Me | H | H | H | H | 0 | - |
| (1-A2-17) | Ru | 3 | the formula (1-S-10) | C₃H₇ | H | H | H | H | 0 | - |
| (1-A2-18) | Rh | 3 | the formula (1-S-10) | C₃H₇ | H | H | H | H | 0 | - |
| (1-A2-19) | Pd | 2 | the formula (1-S-10) | C₃H₇ | H | H | H | H | 0 | - |

The phosphorescent compound represented by the formula (1-A3) includes, for example, phosphorescent compounds represented by the formulae (1-A3-1) to (1-A3-24), and is preferably a phosphorescent compound represented by the formulae (1-A3-1) to (1-A3-19), more preferably a phosphorescent compound represented by the formulae (1-A3-1) to (1-A3-13).

**[Table 5]**

| Formula | M¹ | n¹ | R^{11A} | R^{12A} | R^{13A} | R²¹ A | R^{22A} | R^{23A} | R^{24A} | n² | A¹-G¹-A² |
|---|---|---|---|---|---|---|---|---|---|---|---|
| (1-A3-1) | Ir | 3 | the formula (1-S-2) | H | H | H | H | H | H | 0 | - |
| (1-A3-2) | Ir | 3 | the formula (1-S-4) | H | H | H | H | H | H | 0 | - |
| (1-A3-3) | Ir | 3 | the formula (1-S-9) | H | H | H | H | H | H | 0 | - |
| (1-A3-4) | Ir | 3 | the formula (1-S-10) | H | H | H | H | H | H | 0 | - |
| (1-A3-5) | Ir | 3 | the formula (1-S-10) | Me | C₃H₇ | H | H | H | H | 0 | - |
| (1-A3-6) | Ir | 3 | the formula (1-S-10) | H | the formula (1-S-2) | H | H | H | H | 0 | - |
| (1-A3-7) | Ir | 3 | the formula (1-S-11) | H | H | H | H | H | H | 0 | - |
| (1-A3-8) | Ir | 3 | the formula (1-S-14) | H | H | H | H | H | H | 0 | - |
| (1-A3-9) | Ir | 3 | the formula (1-S-16) | H | H | H | the formula (1-S-7) | H | H | 0 | - |
| (1-A3-10) | Ir | 3 | the formula (1-S-10) | H | H | H | H | the formula (1-S-7) | H | 0 | - |
| (1-A3-11) | Ir | 3 | the formula (1-S-10) | H | H | H | H | Me | H | 0 | - |
| (1-A3-12) | Ir | 3 | the formula (1-S-6) | H | H | H | the formula (1-S-6) | H | H | 0 | - |

**[Table 6]**

| Formula | M¹ | n¹ | R^{11A} | R^{12A} | R^{13A} | R^{21A} | R^{22A} | R^{23A} | R^{24A} | n² | A¹-G¹-A² |
|---|---|---|---|---|---|---|---|---|---|---|---|
| (1-A3-13) | Ir | 3 | the formula (1-S-7) | H | H | H | the formula (1-S-10) | H | H | 0 | - |
| (1-A3-14) | Ir | 3 | the formula (1-S-21) | H | H | H | H | H | H | 0 | - |
| (1-A3-15) | Ir | 3 | the formula (1-S-22) | H | H | H | H | H | H | 0 | - |
| (1-A3-16) | Ir | 3 | the formula (1-S-27) | H | H | H | H | H | H | 0 | - |
| (1-A3-17) | Ir | 3 | the formula (1-S-29) | H | H | H | H | H | H | 0 | - |
| (1-A3-18) | Ir | 2 | the formula (1-S-10) | H | H | H | H | H | H | 1 | 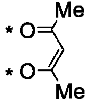 |
| (1-A3-19) | Ir | 2 | the formula (1-S-16) | H | H | H | H | H | H | 1 | 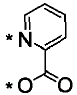 |
| (1-A3-20) | Pt | 2 | the formula (1-S-10) | H | H | H | H | H | H | 0 | - |
| (1-A3-21) | Pt | 2 | the formula (1-S-14) | H | H | H | H | H | H | 0 | - |
| (1-A3-22) | Ru | 3 | the formula (1-S-10) | H | H | H | H | H | H | 0 | - |
| (1-A3 -23) | Rh | 3 | the formula (1-S-10) | H | H | H | H | H | H | 0 | - |
| (1-A3 -24) | Pd | 2 | the formula (1-S-10) | H | H | H | H | H | H | 0 | - |

The phosphorescent compound represented by the formula (1-A4) includes, for example, phosphorescent compounds represented by the formulae (1-A4-1) to (1-A4-24), and is preferably a phosphorescent compound represented by the formulae (1-A4-1) to (1-A4-19), more preferably a phosphorescent compound represented by the formulae (1-A4-1) to (1-A4-13).

**[Table 7]**

| Formula | M¹ | n¹ | R^{12A} | R^{11A} | R^{13A} | R^{21A} | R^{22A} | R^{23A} | R^{24A} | n² | A¹-G¹-A² |
|---|---|---|---|---|---|---|---|---|---|---|---|
| (1-A4-1) | Ir | 3 | the formula (1-S-2) | H | H | H | H | H | H | 0 | - |
| (1-A4-2) | Ir | 3 | the formula (1-S-4) | H | H | H | H | H | H | 0 | - |
| (1-A4-3) | Ir | 3 | the formula (1-S-9) | H | H | H | H | H | H | 0 | - |
| (1-A4-4) | Ir | 3 | the formula (1-S-10) | H | H | H | H | H | H | 0 | - |
| (1-A4-5) | Ir | 3 | the formula (1-S-10) | Me | C₃H₇ | H | H | H | H | 0 | - |
| (1-A4-6) | Ir | 3 | the formula (1-S-10) | H | the formula (1-S-2) | H | H | H | H | 0 | - |
| (1-A4-7) | Ir | 3 | the formula (1-S-11) | H | H | H | H | H | H | 0 | - |
| (1-A4-8) | Ir | 3 | the formula (1-S-14) | H | H | H | H | H | H | 0 | - |
| (1-A4-9) | Ir | 3 | the formula (1-S-16) | H | H | H | the formula (1-S-7) | H | H | 0 | - |
| (1-A4-10) | Ir | 3 | the formula (1-S-10) | H | H | H | H | the formula (1-S-7) | H | 0 | - |
| (1-A4-11) | Ir | 3 | the formula (1-S-10) | H | H | H | H | Me | H | 0 | - |
| (1-A4-12) | Ir | 3 | the formula (1-S-6) | H | H | H | the formula (1-S-6) | H | H | 0 | - |

**[Table 8]**

| Formula | M¹ | n¹ | R^{12A} | R^{11A} | R^{13A} | R^{21A} | R^{22A} | R^{23A} | R^{24A} | n² | A¹-G¹-A² |
|---|---|---|---|---|---|---|---|---|---|---|---|
| (1-A4-13) | Ir | 3 | the formula (1-S-7) | H | H | H | the formula (1-S-10) | H | H | 0 | - |
| (1-A4-14) | Ir | 3 | the formula (1-S-21) | H | H | H | H | H | H | 0 | - |
| (1-A4-15) | Ir | 3 | the formula (1-S-22) | H | H | H | H | H | H | 0 | - |
| (1-A4-16) | Ir | 3 | the formula (1-S-27) | H | H | H | H | H | H | 0 | - |
| (1-A4-17) | Ir | 3 | the formula (1-S-29) | H | H | H | H | H | H | 0 | - |
| (1-A4-18) | Ir | 2 | the formula (1-S-10) | H | H | H | H | H | H | 1 | 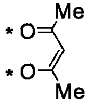 |
| (1-A4-19) | Ir | 2 | the formula (1-S-16) | H | H | H | H | H | H | 1 | 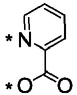 |
| (1-A4-20) | Pt | 2 | the formula (1-S-10) | H | H | H | H | H | H | 0 | - |
| (1-A4-21) | Pt | 2 | the formula (1-S-14) | H | H | H | H | H | H | 0 | - |
| (1-A4-22) | Ru | 3 | the formula (1-S-10) | H | H | H | H | H | H | 0 | - |
| (1-A4-23) | Rh | 3 | the formula (1-S-10) | H | H | H | H | H | H | 0 | - |
| (1-A4-24) | Pd | 2 | the formula (1-S-10) | H | H | H | H | H | H | 0 | - |

The phosphorescent compound represented by the formula (1) includes, for example, phosphorescent compounds represented by the formulae (1-A1-1) to (1-A1-19), the formulae (1-A2-1) to (1-A2-19), the formulae (1-A3-1) to (1-A3-24), the formulae (1-A4-1) to (1-A4-24) and the formulae (1-A-1) to (1-A-4), and is preferably a phosphorescent compound represented by the formulae (1-A1-1) to (1-A1-16), the formulae (1-A2-1) to (1-A2-16), the formulae (1-A3-1) to (1-A3-19) or the formulae (1-A4-1) to (1-A4-19), more preferably a phosphorescent compound represented by the formulae (1-A1-1) to (1-A1-10) or the formulae (1-A3-1) to (1-A3-13).

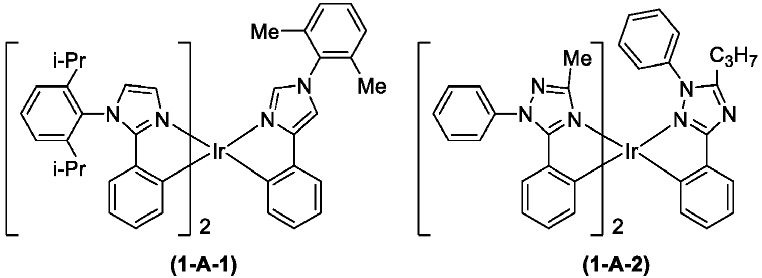

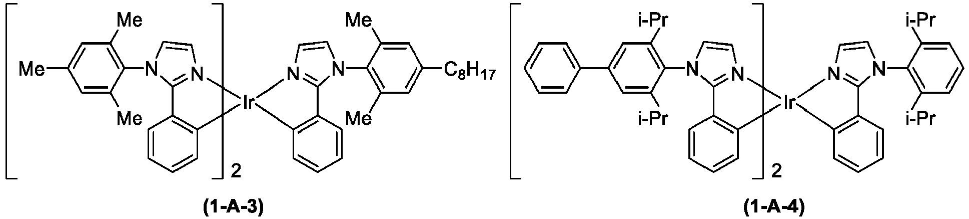

### <Phosphorescent compound represented by the formula (2)>

Described herein is a phosphorescent compound represented by the formula (2).

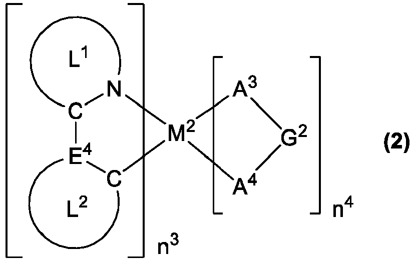

The composition of the present invention comprises a phosphorescent compound represented by the formula (2-B1) or (2-B2).

The phosphorescent compound represented by the formula (2) is a phosphorescent compound constituted of M² as a central metal, a ligand of which number is ruled by a suffix n³ and a ligand of which number is ruled by a suffix n⁴.

M² is preferably an iridium atom or a platinum atom, more preferably an iridium atom, because the driving voltage of a light emitting device comprising the composition of the present invention becomes lower. In the present invention, M² is an iridium atom.

When M² is a ruthenium atom, a rhodium atom or an iridium atom, n³ is preferably 2 or 3, more preferably 3.

When M² is a palladium atom or a platinum atom, n³ is preferably 2.

E⁴ is preferably a carbon atom.

The ring L¹ is preferably a 6-membered aromatic heterocyclic ring having 1 or more and 4 or less nitrogen atoms as a constituent atom, more preferably a 6-membered aromatic heterocyclic ring having 1 or more and 2 or less nitrogen atoms as a constituent atom, and these rings optionally have a substituent. At least one ring selected from the group consisting of the ring L¹ and the ring L² has a group represented by the formula (1-T).

The ring L¹ includes, for example, a pyridine ring, a diazabenzene ring, a quinoline ring and an isoquinoline ring, and is preferably a pyridine ring, a pyrimidine ring, a quinoline ring or an isoquinoline ring, more preferably a pyridine ring, a quinoline ring or an isoquinoline ring, and these rings each optionally have a substituent. At least one ring selected from the group consisting of the ring L¹ and the ring L² has a group represented by the formula (1-T).

The ring L² is preferably a 5-membered or 6-membered aromatic hydrocarbon ring or a 5-membered or 6-membered aromatic heterocyclic ring, more preferably a 6-membered aromatic hydrocarbon ring or a 6-membered aromatic heterocyclic ring, further preferably a 6-membered aromatic hydrocarbon ring, and these rings each optionally have a substituent. When the ring L² is a 6-membered aromatic heterocyclic ring, E⁴ is a carbon atom. At least one ring selected from the group consisting of the ring L¹ and the ring L² has a group represented by the formula (1-T).

The ring L² includes, for example, a benzene ring, a naphthalene ring, a fluorene ring, a phenanthrene ring, a pyridine ring, a diazabenzene ring, a pyrrole ring, a furan ring and a thiophene ring, and is preferably a benzene ring, a naphthalene ring, a fluorene ring, a pyridine ring or a pyrimidine ring, more preferably a benzene ring, a pyridine ring or a pyrimidine ring, further preferably a benzene ring, and these rings each optionally have a substituent. At least one ring selected from the group consisting of the ring L¹ and the ring L² has a group represented by the formula (1-T).

"The ligand constituted of the ring L¹ and the ring L² is a ligand constituted of atoms selected from the group consisting of a hydrogen atom, a carbon atom, a nitrogen atom, an oxygen atom and a sulfur atom" denotes that the ring L- and the ring L² are constituted of atoms selected from the group consisting of a hydrogen atom, a carbon atom, a nitrogen atom, an oxygen atom and a sulfur atom and the substituent which the rings have is constituted of atoms selected from the group consisting of a hydrogen atom, a carbon atom, a nitrogen atom, an oxygen atom and a sulfur atom.

The ligand constituted of the ring L¹ and the ring L² is preferably a ligand constituted of atoms selected from the group consisting of a hydrogen atom, a carbon atom, a nitrogen atom and an oxygen atom, more preferably a ligand constituted of a hydrogen atom, a carbon atom and a nitrogen atom.

"At least one ring selected from the group consisting of the ring L¹ and the ring L² has a group represented by the formula (1-T)" denotes that a part or all of hydrogen atoms bonding directly to carbon atoms or nitrogen atoms constituting at least one ring among a plurality of rings are substituted with a group represented by the formula (1-T). When a plurality of the rings L¹ and the rings L² are present (namely, when n³ is 2 or 3) in the phosphorescent compound represented by the formula (2), at least one ring of the plurality of the rings L¹ and the rings L² has a group represented by the formula (1-T), and it is preferable that all the plurality of the rings L¹, all the plurality of the rings L², or all the plurality of the rings L¹ and the rings L² have a group represented by the formula (1-T), it is more preferable that all the plurality of the rings L¹ or all the plurality of the rings L² have a group represented by the formula (1-T), it is further preferable that all the plurality of the rings L² have a group represented by the formula (1-T) .

The ring L² preferably has a group represented by the formula (1-T) .

The substituent which the ring L¹ and the ring L² optionally have (differing from a group represented by the formula (1-T)) is preferably an alkyl group, a cycloalkyl group, an aryl group, a monovalent heterocyclic group, an alkoxy group, a cycloalkoxy group, an aryloxy group or a substituted amino group, more preferably an alkyl group, a cycloalkyl group, an aryl group or a monovalent heterocyclic group, further preferably an alkyl group or a cycloalkyl group, and these groups each optionally further have a substituent.

When a plurality of the substituents which the ring L¹ optionally has (differing from a group represented by the formula (1-T)) are present, they may be the same or different and may be combined together to form a ring together with the atoms to which they are attached.

When a plurality of the substituents which the ring L² optionally has (differing from a group represented by the formula (1-T)) are present, they may be the same or different and may be combined together to form a ring together with the atoms to which they are attached.

The substituent which the ring L¹ optionally has (differing from a group represented by the formula (1-T)) and the substituent which the ring L² optionally has (differing from a group represented by the formula (1-T)) may be combined together to form a ring together with the atoms to which they are attached.

### [Group represented by the formula (1-T)]

Described herein is a group represented by the formula (1-T) . In the present invention, the group represented by the formula (1-T) is a group represented by the formula (1-T1).

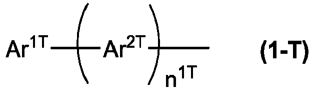

The examples and preferable ranges of the aryl group represented by Ar^{1 T} are the same as the examples and preferable ranges of the aryl group represented by Ar^{1S}.

Ar^{1T} is preferably a phenyl group, and this phenyl group optionally has an alkyl group, a cycloalkyl group, an alkoxy group or a cycloalkoxy group as a substituent. The alkyl group, the cycloalkyl group, the alkoxy group and the cycloalkoxy group each optionally further have a substituent.

n^{1T} is preferably an integer of 0 to 5, more preferably an integer of 0 to 2, further preferably 0 or 1, particularly preferably 0. In the present invention, n^{1T} is an integer of 0 to 2.

The examples and preferable ranges of the arylene group represented by Ar^{2T} are the same as the examples and preferable ranges of the arylene group represented by Ar^{2S}.

Ar^{2T} is preferably a phenylene group, and this phenylene group optionally has an alkyl group, a cycloalkyl group, an alkoxy group or a cycloalkoxy group as a substituent. The alkyl group, the cycloalkyl group, the alkoxy group and the cycloalkoxy group each optionally further have a substituent.

The examples and preferable ranges of the substituent which Ar^{1T} and Ar^{2T} optionally have are the same as the examples and preferable ranges of the substituent which Ar^{1S} and Ar^{2S} optionally have.

The examples and preferable ranges of the substituent which the substituent which Ar^{1T} and Ar^{2T} optionally have optionally further has are the same as the examples and preferable ranges of the substituent which the substituent which Ar^{1S} and Ar^{2S} optionally have optionally further has.

It is preferable that the substituent which Ar^{1T} and Ar^{2T} optionally have (namely, an alkyl group, a cycloalkyl group, an alkoxy group and a cycloalkoxy group) does not have a further substituent.

The group represented by the formula (1-T) is preferably a group represented by the formula (1-T1), because the driving voltage of a light emitting device comprising the composition of the present invention becomes lower.

R^{1T} and R^{2T} represent preferably a hydrogen atom, an alkyl group or a cycloalkyl group, more preferably a hydrogen atom or an alkyl group, and these groups each optionally have a substituent.

The examples and preferable ranges of the substituent which R^{1T} and R^{2T} optionally have are the same as the examples and preferable ranges of the substituent which R^{1S} and R^{2S} optionally have.

It is preferable that R^{1T} and R^{2T} do not have a substituent.

At least one of the plurality of R^{1T} and the plurality of R^{2T} is preferably an alkyl group, a cycloalkyl group, an alkoxy group or a cycloalkoxy group, more preferably an alkyl group or a cycloalkyl group, further preferably an alkyl group, and these groups each optionally have a substituent.

The group represented by the formula (1-T1) is preferably a group represented by the formula (1-T1-1), a group represented by the formula (1-T1-2), a group represented by the formula (1-T1-3) or a group represented by the formula (1-T1-4), more preferably a group represented by the formula (1-T1-1) or a group represented by the formula (1-T1-2), further preferably a group represented by the formula (1-T1-1), because the driving voltage of a light emitting device comprising the composition of the present invention becomes lower.

R^{11T} to R^{25T} are preferably a hydrogen atom, an alkyl group or a cycloalkyl group, more preferably a hydrogen atom or an alkyl group, and these groups each optionally have a substituent.

The examples and preferable ranges of the substituent which R^{11T} to R^{25T} optionally have are the same as the examples and preferable ranges of the substituent which R^{11S} to R^{25S} optionally have.

It is preferable that R^{11T} to R^{25T} do not have a substituent.

At least one of R^{11T} to R^{15T} is preferably an alkyl group, a cycloalkyl group, an alkoxy group or a cycloalkoxy group, more preferably an alkyl group or a cycloalkyl group, further preferably an alkyl group, and these groups each optionally have a substituent.

R^{13T} is preferably an alkyl group, a cycloalkyl group, an alkoxy group or a cycloalkoxy group, more preferably an alkyl group or a cycloalkyl group, further preferably an alkyl group, and these groups each optionally have a substituent.

At least one of R^{16T} to R^{25T} is preferably an alkyl group, a cycloalkyl group, an alkoxy group or a cycloalkoxy group, more preferably an alkyl group or a cycloalkyl group, further preferably an alkyl group, and these groups each optionally have a substituent.

R^{18T} is preferably an alkyl group, a cycloalkyl group, an alkoxy group or a cycloalkoxy group, more preferably an alkyl group or a cycloalkyl group, further preferably an alkyl group, and these groups each optionally have a substituent.

The group represented by the formula (1-T) includes, for example, groups represented by the formulae (1-T-1) to (1-S-25), and is preferably a group represented by the formulae (1-T-1) to (1-T-21), more preferably a group represented by the formulae (1-S-1) to (1-S-10).

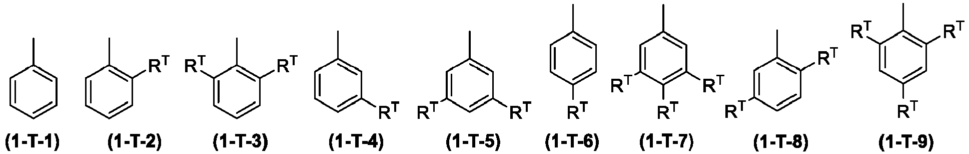

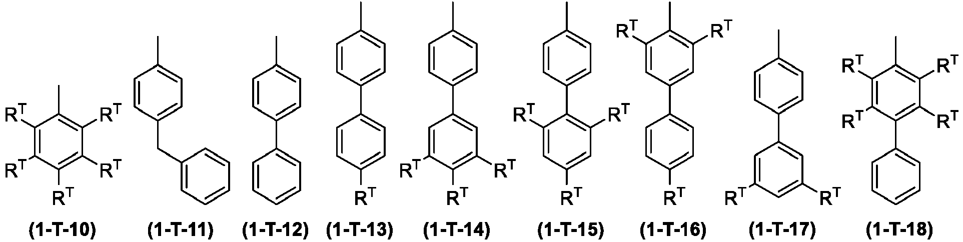

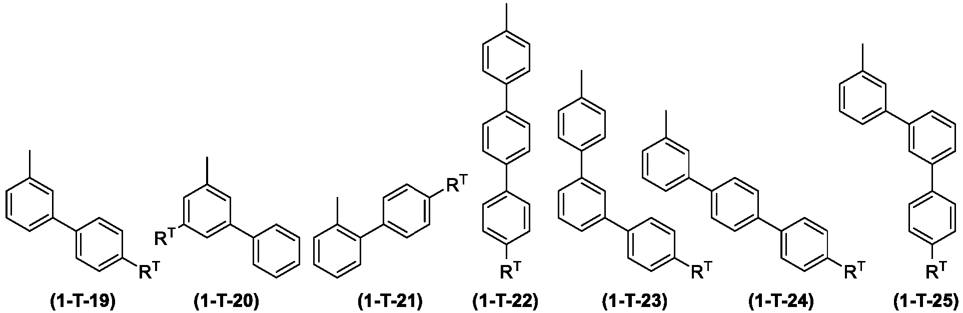

R^{T} represents a methyl group, an ethyl group, an isopropyl group, a tert-butyl group, a hexyl group, a 2-ethylhexyl group, a cyclohexyl group, a methoxy group, a 2-ethylhexyloxy group or a cyclohexyloxy group, and is preferably a methyl group, an ethyl group, an isopropyl group, a tert-butyl group, a hexyl group or a 2-ethylhexyl group. When a plurality of R^{T} are present, they may be the same or different.

The phosphorescent compound represented by the formula (2) is preferably a phosphorescent compound represented by the formula (2-B), because the driving voltage of a light emitting device comprising the composition of the present invention becomes lower.

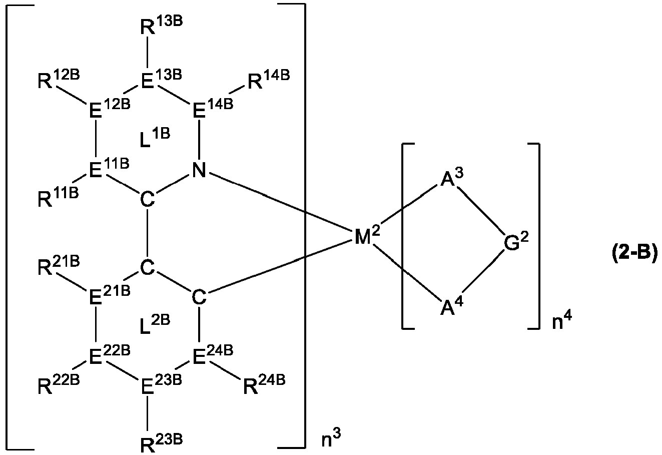

When the ring L^{1B} is a pyrimidine ring, a pyrimidine ring in which E^{11B} is a nitrogen atom is preferable.

R^{11B}, R^{12B}, R^{13B} and R^{14B} represent preferably a hydrogen atom, an alkyl group, a cycloalkyl group or a group represented by the formula (1-T), more preferably a hydrogen atom or a group represented by the formula (1-T), and these groups each optionally have a substituent.

When the ring L^{1B} has a group represented by the formula (1-T), it is preferable that R^{11B}, R^{12B} or R^{13B} is a group represented by the formula (1-T), it is more preferable that R^{12B} or R^{13B} is a group represented by the formula (1-T), it is further preferable that R^{13B} is a group represented by the formula (1-T).

When the ring L^{2B} is a pyridine ring, a pyridine ring in which E^{21B} is a nitrogen atom, a pyridine ring in which E^{22B} is a nitrogen atom or a pyridine ring in which E^{23B} is a nitrogen atom is preferable, a pyridine ring in which E^{22B} is a nitrogen atom is more preferable.

When the ring L^{2B} is a pyrimidine ring, a pyrimidine ring in which E^{21B} and E^{23B} are a nitrogen atom or a pyrimidine ring in which E^{22B} and E^{24B} are a nitrogen atom is preferable, a pyrimidine ring in which E^{22B} and E^{24B} are a nitrogen atom is more preferable.

The ring L^{2B} is preferably a benzene ring.

R^{21B}, R^{22B}, R^{23B} and R^{24B} represent preferably a hydrogen atom, an alkyl group, a cycloalkyl group or a group represented by the formula (1-T), more preferably a hydrogen atom or a group represented by the formula (1-T), and these groups optionally have a substituent.

When the ring L^{2B} has a group represented by the formula (1-T), it is preferable that R^{22B} or R^{23B} is a group represented by the formula (1-T), it is more preferable that R^{22B} is a group represented by the formula (1-T).

The phosphorescent compound represented by the formula (2-B) is preferably a phosphorescent compound represented by the formula (2-B1), a phosphorescent compound represented by the formula (2-B2), a phosphorescent compound represented by the formula (2-B3) or a phosphorescent compound represented by the formula (2-B4), more preferably a phosphorescent compound represented by the formula (2-B1) or a phosphorescent compound represented by the formula (2-B2).

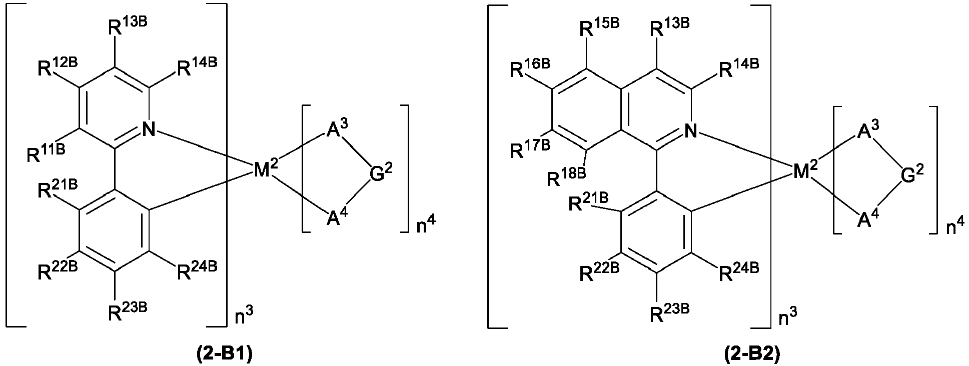

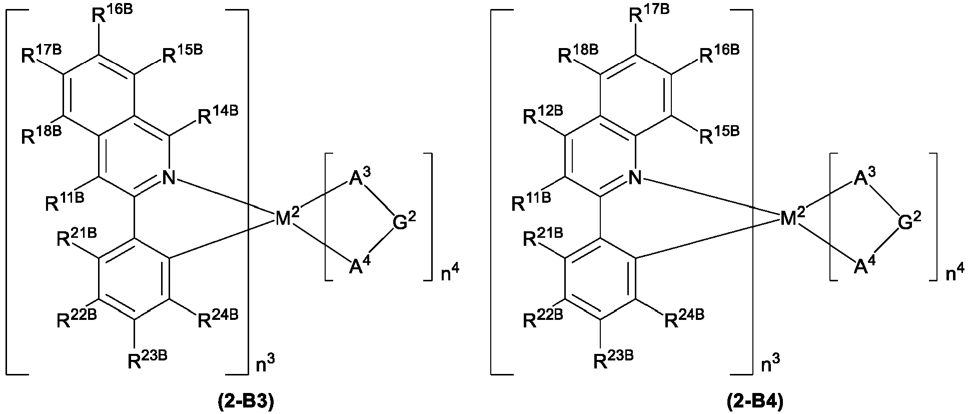

R^{15B}, R^{16B}, R^{17B} and R^{18B} represent preferably a hydrogen atom, an alkyl group, a cycloalkyl group, an aryl group or a monovalent heterocyclic group, more preferably a hydrogen atom, an alkyl group or an aryl group, further preferably a hydrogen atom or an alkyl group, particularly preferably a hydrogen atom, and these groups each optionally have a substituent.

The phosphorescent compound represented by the formula (2-B1) includes, for example, phosphorescent compounds represented by the formulae (2-B1-1) to (2-B1-24), and is preferably a phosphorescent compound represented by the formulae (2-B1-1) to (2-B1-19), more preferably a phosphorescent compound represented by the formulae (2-B1-1) to (2-B1-13), further preferably a phosphorescent compound represented by the formulae (2-B1-1) to (2-B1-10).

**[Table 9]**

| Formula | M² | n³ | R^{11B} | R^{12B} | R^{13B} | R^{14B} | R^{21B} | R^{22B} | R^{23B} | R^{24B} | n⁴ | A³-G²-A⁴ |
|---|---|---|---|---|---|---|---|---|---|---|---|---|
| (2-B1-1) | Ir | 3 | H | H | H | H | H | the formula (1-T-1) | H | H | 0 | - |
| (2-B1-2) | Ir | 3 | H | H | H | H | H | the formula (1-T-5) | H | H | 0 | - |
| (2-B1-3) | Ir | 3 | H | H | H | H | H | the formula (1-T-6) | H | H | 0 | - |
| (2-B1-4) | Ir | 3 | H | H | H | H | H | H | the formula (1-T-6) | H | 0 | - |
| (2-B1-5) | Ir | 3 | H | the formula (1-T-6) | H | H | H | H | C₆H₁₃ | H | 0 | - |
| (2-B1-6) | Ir | 3 | H | H | the formula (1-T-6) | H | H | H | H | H | 0 | - |
| (2-B1-7) | Ir | 3 | H | H | Me | H | H | the formula (1-T-6) | H | H | 0 | - |
| (2-B1-8) | Ir | 3 | Me | H | Me | H | H | the formula (1-T-1) | H | H | 0 | - |
| (2-B1-9) | Ir | 3 | H | H | the formula (1-T-6) | H | H | the formula (1-T-6) | H | H | 0 | - |
| (2-B1-10) | Ir | 3 | H | H | H | H | H | the formula (1-T-8) | H | H | 0 | - |
| (2-B1-11) | Ir | 2 | H | H | H | H | H | the formula (1-T-1) | H | H | 1 | 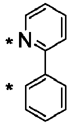 |
| (2-B1-12) | Ir | 2 | H | H | H | H | H | the formula (1-T-6) | H | H | 1 | 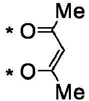 |
| (2-B1-13) | Ir | 2 | H | H | H | H | H | the formula (1-T-6) | H | H | 1 | 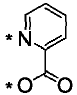 |

**[Table 10]**

| Formula | M² | n³ | R^{11B} | R^{12B} | R^{13B} | R^{14B} | R^{21B} | R^{22B} | R^{23B} | R^{24B} | n⁴ | A³-G²-A⁴ |
|---|---|---|---|---|---|---|---|---|---|---|---|---|
| (2-B1-14) | Ir | 3 | H | H | H | H | H | the formula (1-T-13) | H | H | 0 | - |
| (2-B1-15) | Ir | 3 | H | H | H | H | H | the formula (1-T-14) | H | H | 0 | - |
| (2-B1-16) | Ir | 3 | H | H | H | H | H | the formula (1-T-19) | H | H | 0 | - |
| (2-B1-17) | Ir | 3 | H | H | H | H | H | the formula (1-T-23) | H | H | 0 | - |
| (2-B1-18) | Ir | 3 | H | H | H | H | H | the formula (1-T-25) | H | H | 0 | - |
| (2-B1-19) | Ir | 1 | H | H | H | H | H | the formula (1-T-6) | H | H | 1 | 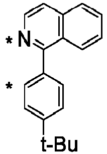 |
| (2-B1-20) | Pt | 2 | H | H | H | H | H | the formula (1-T-6) | H | H | 0 | - |
| (2-B1-21) | Pt | 2 | H | H | H | H | H | the formula (1-T-6) | H | H | 0 | - |
| (2-B1-22) | Ru | 3 | H | H | H | H | H | the formula (1-T-6) | H | H | 0 | - |
| (2-B1-23) | Rh | 3 | H | H | H | H | H | the formula (1-T-6) | H | H | 0 | - |
| (2-B1-24) | Pd | 2 | H | H | H | H | H | the formula (1-T-6) | H | H | 0 | - |

The phosphorescent compound represented by the formula (2-B2)includes, for example, phosphorescent compounds represented by the formulae (2-B2-1) to (2-B2-22), and is preferably a phosphorescent compound represented by the formulae (2-B2-1) to (2-B2-17), more preferably a phosphorescent compound represented by the formulae (2-B2-1) to (2-B2-12), further preferably a phosphorescent compound represented by the formulae (2-B2-1) to (2-B2-9).

**[Table 11]**

| Formula | M² | n³ | R^{13B} | R^{14B} | R^{15B} | R^{16B} | R^{17B} | R^{18B} | R^{21B} | R^{22B} | R^{23B} | R^{24B} | n⁴ | A³-G²-A⁴ |
|---|---|---|---|---|---|---|---|---|---|---|---|---|---|---|
| (2-B2-1) | Ir | 3 | H | H | H | H | H | H | H | the formula (1-T-1) | H | H | 0 | - |
| (2-B2-2) | Ir | 3 | H | H | H | H | H | H | H | the formula (1-T-5) | H | H | 0 | - |
| (2-B2-3) | Ir | 3 | H | H | H | H | H | H | H | the formula (1-T-6) | H | H | 0 | - |
| (2-B2-4) | Ir | 3 | H | H | H | H | H | H | H | H | the formula (1-T-6) | H | 0 | - |
| (2-B2-5) | Ir | 3 | the formula (1-T-6) | H | H | H | H | H | H | H | t-Bu | H | 0 | - |
| (2-B2-6) | Ir | 3 | H | H | H | Me | Me | H | H | the formula (1-T-6) | H | H | 0 | - |
| (2-B2-7) | Ir | 3 | Me | Me | H | H | H | H | H | the formula (1-T-6) | H | H | 0 | - |
| (2-B2-8) | Ir | 3 | the formula (1-T-6) | H | H | H | H | H | H | the formula (1-T-6) | H | H | 0 | - |
| (2-B2-9) | Ir | 3 | H | H | H | H | H | H | H | the formula (1-T-7) | H | H | 0 | - |
| (2-B2-10) | Ir | 2 | H | H | H | H | H | H | H | the formula (1-T-1) | H | H | 1 | 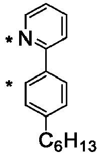 |
| (2-B2-11) | Ir | 2 | H | H | H | H | H | H | H | the formula (1-T-6) | H | H | 1 | 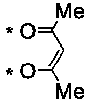 |
| (2-B2-12) | Ir | 1 | H | H | H | H | H | H | H | the formula (1-T-6) | H | H | 2 | 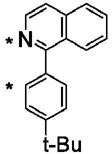 |

**[Table 12]**

| Formula | M² | n³ | R^{13B} | R^{14B} | R^{15B} | R^{16B} | R^{17B} | R^{18B} | R^{21B} | R^{22B} | R^{23B} | R^{24B} | n⁴ | A³-G³⁻A⁴ |
|---|---|---|---|---|---|---|---|---|---|---|---|---|---|---|
| (2-B2-13) | Ir | 3 | H | H | H | H | H | H | H | the formula (1-T-13) | H | H | 0 | - |
| (2-B2-14) | Ir | 3 | H | H | H | H | H | H | H | the formula (1-T-17) | H | H | 0 | - |
| (2-B2-15) | Ir | 3 | H | H | H | H | H | H | H | the formula (1-T-19) | H | H | 0 | - |
| (2-B2-16) | Ir | 3 | H | H | H | H | H | H | H | the formula (1-T-23) | H | H | 0 | - |
| (2-B2-17) | Ir | 3 | H | H | H | H | H | H | H | the formula (1-T-25) | H | H | 0 | - |
| (2-B2-18) | Pt | 2 | H | H | H | H | H | H | H | the formula (1-T-6) | H | H | 0 | - |
| (2-B2-19) | Pt | 2 | H | H | H | H | H | H | H | the formula (1-T-6) | H | H | 0 | - |
| (2-B2-20) | Ru | 3 | H | H | H | H | H | H | H | the formula (1-T-6) | H | H | 0 | - |
| (2-B2-21) | Rh | 3 | H | H | H | H | H | H | H | the formula (1-T-6) | H | H | 0 | - |
| (2-B2-22) | Pd | 2 | H | H | H | H | H | H | H | the formula (1-T-6) | H | H | 0 | - |

The phosphorescent compound represented by the formula (2-B3) includes, for example, phosphorescent compounds represented by the formulae (2-B3-1) to (2-B3-18), and is preferably a phosphorescent compound represented by the formulae (2-B3-1) to (2-B3-13), more preferably a phosphorescent compound represented by the formulae (2-B3-1) to (2-B3-8).

**[Table 13]**

| Formula | M² | n³ | R^{11B} | R^{14B} | R^{15B} | R^{16B} | R^{17B} | R^{18B} | R^{21B} | R^{22B} | R^{23B} | R^{24B} | n⁴ | A³-G²-A⁴ |
|---|---|---|---|---|---|---|---|---|---|---|---|---|---|---|
| (2-B3-1) | Ir | 3 | H | H | H | H | H | H | H | the formula (1-T-1) | H | H | 0 | - |
| (2-B3-2) | Ir | 3 | H | H | H | H | H | H | H | the formula (1-T-5) | H | H | 0 | - |
| (2-B3-3) | Ir | 3 | H | H | H | H | H | H | H | the formula (1-T-6) | H | H | 0 | - |
| (2-B3-4) | Ir | 3 | H | H | H | H | H | H | Me | H | the formula (1-T-6) | H | 0 | - |
| (2-B3-5) | Ir | 3 | H | the formula (1-T-1) | H | H | H | H | H | H | t-Bu | H | 0 | - |
| (2-B3-6) | Ir | 3 | H | H | H | Me | Me | H | H | the formula (1-T-6) | H | H | 0 | - |
| (2-B3-7) | Ir | 3 | Me | Me | H | H | H | H | H | the formula (1-T-6) | H | H | 0 | - |
| (2-B3-8) | Ir | 2 | H | H | H | H | H | H | H | the formula (1-T-6) | H | H | 1 | 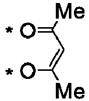 |
| (2-B3-9) | Ir | 3 | H | H | H | H | H | H | H | the formula (1-T-13) | H | H | 0 | - |

**[Table 14]**

| Formula | M² | n³ | R^{11B} | R^{14B} | R^{15B} | R^{16B} | R^{17B} | R^{18B} | R^{21B} | R^{22B} | R^{23B} | R^{24B} | n⁴ | A³-G²-A⁴ |
|---|---|---|---|---|---|---|---|---|---|---|---|---|---|---|
| (2-B3-10) | Ir | 3 | H | H | H | H | H | H | H | the formula (1-T-17) | H | H | 0 | - |
| (2-B3-11) | Ir | 3 | H | H | H | H | H | H | H | the formula (1-T-19) | H | H | 0 | - |
| (2-B3-12) | Ir | 3 | H | H | H | H | H | H | H | the formula (1-T-23) | H | H | 0 | - |
| (2-B3-13) | Ir | 3 | H | H | H | H | H | H | H | the formula (1-T-25) | H | H | 0 | - |
| (2-B3-14) | Pt | 2 | H | H | H | H | H | H | H | the formula (1-T-6) | H | H | 0 | - |
| (2-B3-15) | Pt | 2 | H | H | H | H | H | H | H | the formula (1-T-6) | H | H | 0 | - |
| (2-B3-16) | Ru | 3 | H | H | H | H | H | H | H | the formula (1-T-6) | H | H | 0 | - |
| (2-B3-17) | Rh | 3 | H | H | H | H | H | H | H | the formula (1-T-6) | H | H | 0 | - |
| (2-B3-18) | Pd | 2 | H | H | H | H | H | H | H | the formula (1-T-6) | H | H | 0 | - |

The phosphorescent compound represented by the formula (2-B4) includes, for example, phosphorescent compounds represented by the formulae (2-B4-1) to (2-B4-19), and is preferably a phosphorescent compound represented by the formulae (2-B4-1) to (2-B4-14), more preferably a phosphorescent compound represented by the formulae (2-B4-1) to (2-B4-9).

**[Table 15]**

| Formula | M² | n³ | R^{11B} | R^{12B} | R^{15B} | R^{16B} | R^{17B} | R^{18B} | R^{21B} | R^{22B} | R^{23B} | R^{24B} | n⁴ | A³-G²-A⁴ |
|---|---|---|---|---|---|---|---|---|---|---|---|---|---|---|
| (2-B4-1) | Ir | 3 | H | H | H | H | H | H | H | the formula (1-T-1) | H | H | 0 | - |
| (2-B4-2) | Ir | 3 | H | H | H | H | H | H | H | the formula (1-T-5) | H | H | 0 | - |
| (2-B4-3) | Ir | 3 | H | H | H | H | H | H | H | the formula (1-T-6) | H | H | 0 | - |
| (2-B4-4) | Ir | 3 | H | H | H | H | H | H | H | H | the formula (1-T-6) | H | 0 | - |
| (2-B4-5) | Ir | 3 | H | the formula (1-T-6) | H | H | H | H | H | Me | H | Me | 0 | - |
| (2-B4-6) | Ir | 3 | H | H | H | Me | H | H | H | the formula (1-T-6) | H | H | 0 | - |
| (2-B4-7) | Ir | 3 | Me | H | H | H | H | H | H | the formula (1-T-6) | H | H | 0 | - |
| (2-B4-8) | Ir | 3 | H | the formula (1-T-6) | H | Me | H | H | H | the formula (1-T-6) | H | H | 0 | - |
| (2-B4-9) | Ir | 2 | H | H | H | H | H | H | H | the formula (1-T-6) | H | H | 1 | 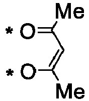 |
| (2-B4-10) | Ir | 3 | H | H | H | H | H | H | H | the formula (1-T-13) | H | H | 0 | - |

**[Table 16]**

| Formula | M² | n³ | R^{11B} | R^{12B} | R^{15B} | R^{16B} | R^{17B} | R^{18B} | R^{21B} | R^{22B} | R^{23B} | R^{24B} | n⁴ | A³-G²-A⁴ |
|---|---|---|---|---|---|---|---|---|---|---|---|---|---|---|
| (2-B4-11) | Ir | 3 | H | H | H | H | H | H | H | the formula (1-T-17) | H | H | 0 | - |
| (2-B4-12) | Ir | 3 | H | H | H | H | H | H | H | the formula (1-T-19) | H | H | 0 | - |
| (2-B4-13) | Ir | 3 | H | H | H | H | H | H | H | the formula (1-T-23) | H | H | 0 | - |
| (2-B4-14) | Ir | 3 | H | H | H | H | H | H | H | the formula (1-T-25) | H | H | 0 | - |
| (2-B4-15) | Pt | 2 | H | H | H | H | H | H | H | the formula (1-T-6) | H | H | 0 | - |
| (2-B4-16) | Pt | 2 | H | H | H | H | H | H | H | the formula (1-T-6) | H | H | 0 | - |
| (2-B4-17) | Ru | 3 | H | H | H | H | H | H | H | the formula (1-T-6) | H | H | 0 | - |
| (2-B4-18) | Rh | 3 | H | H | H | H | H | H | H | the formula (1-T-6) | H | H | 0 | - |
| (2-B4-19) | Pd | 2 | H | H | H | H | H | H | H | the formula (1-T-6) | H | H | 0 | - |

The phosphorescent compound represented by the formula (2) includes, for example, phosphorescent compounds represented by the formulae (2-B1-1) to (2-B1-24), the formulae (2-B2-1) to (2-B2-22), the formulae (2-B3-1) to (2-B3-18), the formulae (2-B4-1) to (2-B4-19) and the formulae (2-B-1) to (2-B-2), and is preferably a phosphorescent compound represented by the formulae (2-B1-1) to (2-B1-19), the formulae (2-B2-1) to (2-B2-17), the formulae (2-B3-1) to (2-B3-13) or the formulae (2-B4-1) to (2-B4-14), more preferably a phosphorescent compound represented by the formulae (2-B1-1) to (2-B1-10) or the formulae (2-B2-1) to (2-B2-9).

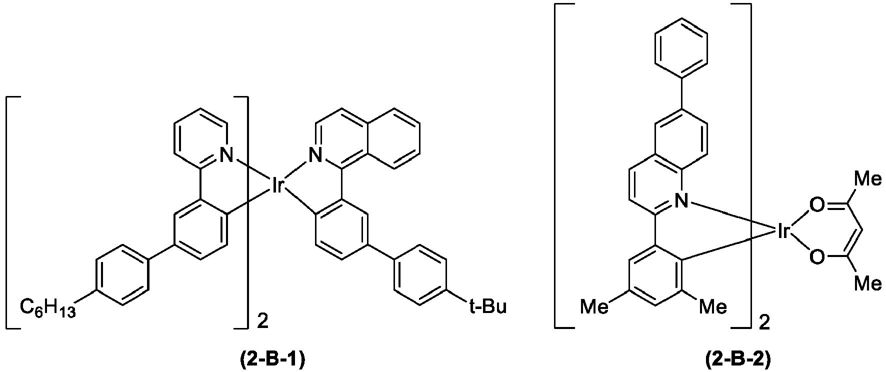

### <Composition>

The composition of the present invention is a composition comprising a phosphorescent compound represented by the formula (1-A1) or (1-A3) and a phosphorescent compound represented by the formula (2-B1) or (2-B2).

In the composition of the present invention, one kind of the phosphorescent compound represented by the formula (1-A1) or (1-A3) may be contained singly or two or more kinds of the phosphorescent compounds may be contained. Further, in the composition of the present invention, one kind of the phosphorescent compound represented by the formula (2-B1) or (2-B2)may be contained singly or two or more kinds of the phosphorescent compounds may be contained.

The light emission color can be coordinated, and the light emission color can also be coordinated to white color, by regulating the ratio of the content of a phosphorescent compound represented by the formula (1-A1) or (1-A3) to the content of a phosphorescent compound represented by the formula (2-B1) or (2-B2), in the composition of the present invention.

The light emission color of a light emitting device can be confirmed by measuring the light emission chromaticity of a light emitting device and determining the chromaticity coordinate (CIE chromaticity coordinate). For white light emission color, for example, X of chromaticity coordinate is in the range of 0.20 to 0.50 and Y of chromaticity coordinate is in the range of 0.20 to 0.50, and it is preferable that X of chromaticity coordinate is in the range of 0.25 to 0.40 and Y of chromaticity coordinate is in the range of 0.25 to 0.40.

From the standpoint of coordinating the light emission color of a light emitting device comprising the composition of the present invention (particularly, coordinating the light emission color to white), the maximum peak wavelength of the emission spectrum of the phosphorescent compound represented by the formula (1-A1) or (1-A3) is 380 nm or more and less than 495 nm, preferably 400 nm to 490 nm, more preferably 420 nm to 480 nm.

From the standpoint of coordinating the light emission color of a light emitting device comprising the composition of the present invention (particularly, coordinating the light emission color to white), the maximum peak wavelength of the emission spectrum of the phosphorescent compound represented by the formula (2-B1) or (2-B2) is 495 nm or more and less than 750 nm, preferably 500 nm to 680 nm, more preferably 505 nm to 640 nm.

When two or more kinds of phosphorescent compounds represented by the formula (2-B1) or (2-B2) are contained in the composition of the present invention, it is preferable that the maximum peak wavelengths of the emission spectrums of at least two phosphorescent compounds represented by the formula (2-B1) or (2-B2) are mutually different, and its difference is preferably 10 to 200 nm, more preferably 20 to 150 nm, further preferably 40 to 120 nm, from the standpoint of coordinating the light emission color of a light emitting device comprising the composition of the present invention (particularly, coordinating the light emission color to white).

When two or more kinds of phosphorescent compounds represented by the formula (2-B1) or (2-B2) are contained in the composition of the present invention and the maximum peak wavelengths of the emission spectrums of at least two phosphorescent compounds represented by the formula (2-B1) or (2-B2)are different, then, the maximum peak wavelength of the emission spectrum at shorter wavelength side of a phosphorescent compound represented by the formula (2-B1) or (2-B2)is preferably 500 nm or more and less than 570 nm, more preferably 505 nm to 560 nm, from the standpoint of coordinating the light emission color of a light emitting device comprising the composition of the present invention (particularly, coordinating the light emission color to white). Further, the maximum peak wavelength of the emission spectrum at longer wavelength side of a phosphorescent compound represented by the formula (2-B1) or (2-B2) is preferably 570 nm to 680 nm, more preferably 590 nm to 640.

From the standpoint of coordinating the light emission color of a light emitting device comprising the composition of the present invention (particularly, coordinating the light emission color to white), the total content of phosphorescent compounds represented by the formula (2-B1) or (2-B2) is preferably 0.01 to 50 parts by weight, more preferably 0.05 to 30 parts by weight, further preferably 0.1 to 10 parts by weight, particularly preferably 0.5 to 5 parts by weight, when the total content of phosphorescent compounds represented by the formula (1-A1) or (1-A3) is 100 parts by weight.

When two or more kinds of phosphorescent compounds represented by the formula (2-B1) or (2-B2) are contained in the composition of the present invention and the emission spectrum maximum peak wavelengths of at least two phosphorescent compounds represented by the formula (2-B1) or (2-B2)are different, then, the content of a phosphorescent compound represented by the formula (2-B1) or (2-B2) at the longer wavelength side is usually 1 to 10000 parts by weight, and it is preferably5 to 1000 parts by weight and more preferably 10 to 200 parts by weight when the content of a phosphorescent compound represented by the formula (2-B1) or (2-B2) at the shorter wavelength side is 100 parts by weight, because a light emitting device comprising the composition of the present invention is excellent in color reproducibility.

When two or more kinds of phosphorescent compounds represented by the formula (2-B1) or (2-B2) are contained in the composition of the present invention, at least one phosphorescent compound represented by the formula (2-B1) or (2-B2)is preferably a phosphorescent compound represented by the formula (2-B1), because the driving voltage of a light emitting device comprising the composition of the present invention becomes lower.

When two or more kinds of phosphorescent compounds represented by the formula (2-B1) or (2-B2) are contained in the composition of the present invention, the combination of at least two phosphorescent compounds represented by the formula (2-B1) or (2-B2) is preferably a combination of a phosphorescent compound represented by the formula (2-B1) and a phosphorescent compound represented by the formula (2-B2), because the driving voltage of a light emitting device comprising the composition of the present invention becomes lower.

### <Other components>

The composition of the present invention may further comprise at least one material selected from the group consisting of a hole transporting material, a hole injection material, an electron transporting material, an electron injection material, a light emitting material (differing from a phosphorescent compound represented by the formula (1) and a phosphorescent compound represented by the formula (2)), an antioxidant and a solvent.

### [Host material]

The driving voltage of a light emitting device comprising the composition of the present invention becomes lower when the composition of the present invention further comprises a host material having at least one function selected from hole injectability, hole transportability, electron injectability and electron transportability. In the composition of the present invention, one kind of the host material may be contained singly or two or more kinds of the host materials may be contained.

When the composition of the present invention further comprises a host material, the content of the host material is usually 1 to 99 parts by weight, preferably 10 to 90 parts by weight, more preferably 20 to 80 parts by weight, further preferably 50 to 70 parts by weight, when the total content of a phosphorescent compound represented by the formula (1-A1) or (1-A3), a phosphorescent compound represented by the formula (2-B1) or (2-B2) and a host material is 100 parts by weight.

It is preferable that the lowest excited triplet state (T₁) of a host material is at energy level which is equivalent to or higher than that of the lowest excited triplet state (T₁) of a phosphorescent compound represented by the formula (1-A1) or (1-A3), because the driving voltage of a light emitting device comprising the composition of the present invention becomes lower.

The host material is classified into low molecular weight compounds and polymer compounds.

### [Low molecular weight host]

The low molecular weight compound which is preferable as a host material (hereinafter, referred to also as "low molecular weight host") will be explained.

The low molecular weight host is preferably a compound represented by the formula (H-1).

Ar^{H1} and Ar^{H2} are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a phenyl group or 9H-carbazole-9-yl group, especially preferably 9H-carbazole-9-yl group, and these groups each optionally have a substituent.

The substituent which Ar^{H1} and Ar^{H2} optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or a cycloalkoxy group, further preferably an alkyl group or a cycloalkoxy group, and these groups each optionally further have a substituent.

n^{H1} is preferably 1. n^{H2} is preferably 0.

n^{H3} is usually an integer of 0 to 10, preferably an integer of 0 to 5, further preferably an integer of 1 to 3, particularly preferably 1.

n^{H11} is preferably an integer of 1 to 5, more preferably an integer of 1 to 3, further preferably 1.

R^{H11} is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and these groups each optionally have a substituent.

L^{H1} is preferably an arylene group or a divalent heterocyclic group.

L^{H1} is preferably a group represented by the formulae (A-1) to (A-3), the formulae (A-8) to (A-10), the formulae (AA-1) to (AA-6), the formulae (AA-10) to (AA-21) or the formulae (AA-24) to (AA-34), more preferably a group represented by the formula (A-1), the formula (A-2), the formula (A-8), the formula (A-9), the formulae (AA-1) to (AA-4), the formulae (AA-10) to (AA-15) or the formulae (AA-29) to (AA-34), further preferably a group represented by the formula (A-1), the formula (A-2), the formula (A-8), the formula (A-9), the formula (AA-2), the formula (AA-4) or the formulae (AA-10) to (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which L^{H1} optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups optionally further have a substituent.

L^{H21} is preferably a single bond or an arylene group, more preferably a single bond, and this arylene group optionally has a substituent.

The definition and examples of the arylene group or the divalent heterocyclic group represented by L^{H21} are the same as the definition and examples of the arylene group or the divalent heterocyclic group represented by L^{H1}.

R^{H21} is preferably an aryl group or a monovalent heterocyclic group, and these groups each optionally have a substituent.

The definition and examples of the aryl group and the monovalent heterocyclic group represented by R^{H21} are the same as the definition and examples of the aryl group and the monovalent heterocyclic group represented by Ar^{H1} and Ar^{H2}.

The definition and examples of the substituent which R^{H21} optionally has are the same as the definition and examples of the substituent which Ar^{H1} and Ar^{H2} optionally have.

The compound represented by the formula (H-1) is preferably a compound represented by the formula (H-2). 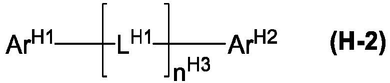 [wherein, Ar^{H1}, Ar^{H2}, n^{H3} and L^{H1} represent the same meaning as described above.]

As the compound represented by the formula (H-1), compounds represented by the following formulae (H-101) to (H-118) are exemplified.

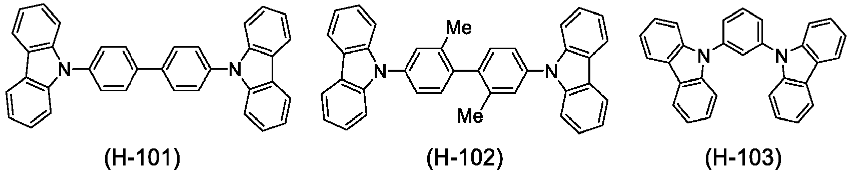

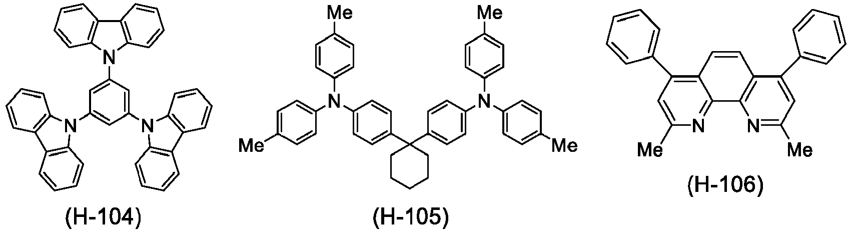

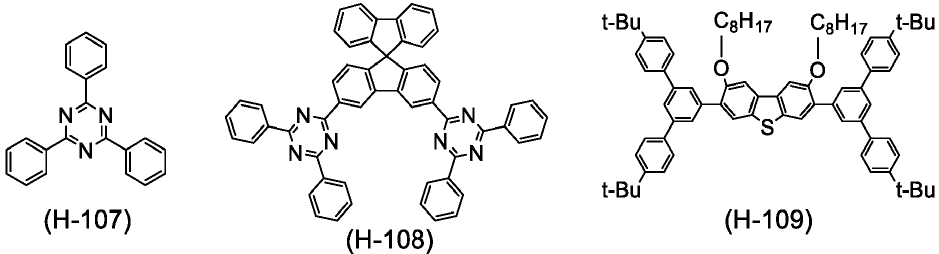

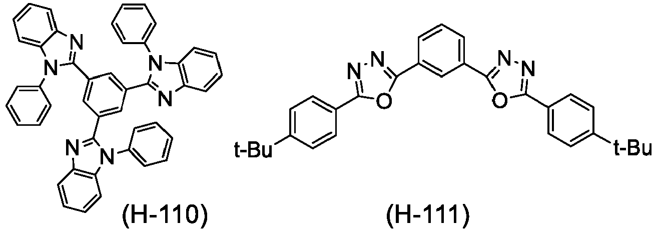

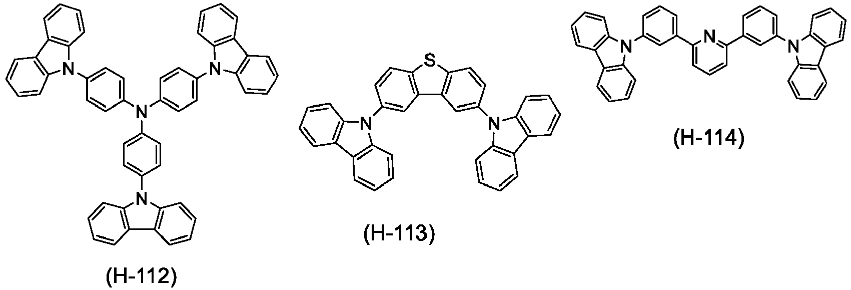

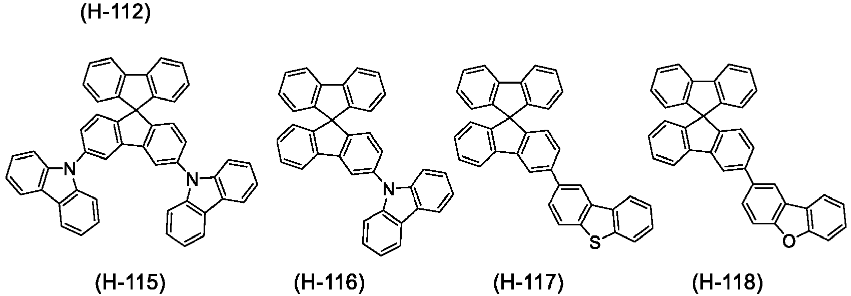

The polymer compound used as a host material includes, for example, polymer compounds as a hole transporting material described later and polymer compounds as an electron transporting material described later.

### [Polymer host]

The polymer compound which is preferable as a host compound (hereinafter, referred to also as "polymer host") will be explained.

The polymer host is preferably a polymer compound comprising a constitutional unit represented by the formula (Y) .

The arylene group represented by Ar^{Y1} is more preferably a group represented by the formula (A-1), the formula (A-2), the formulae (A-6) to (A-10), the formula (A-19) or the formula (A-20), further preferably a group represented by the formula (A-1), the formula (A-2), the formula (A-7), the formula (A-9) or the formula (A-19), and these groups each optionally have a substituent.

The divalent heterocyclic group represented by Ar^{Y1} is more preferably a group represented by the formulae (AA-1) to (AA-4), the formulae (AA-10) to (AA-15), the formulae (AA-18) to (AA-21), the formula (AA-33) or the formula (AA-34), further preferably a group represented by the formula (AA-4), the formula (AA-10), the formula (AA-12), the formula (AA-14) or the formula (AA-33), and these groups each optionally have a substituent.

The more preferable range and the further preferable range of the arylene group and the divalent heterocyclic group in the divalent group in which at least one arylene group and at least one divalent heterocyclic group are bonded directly to each other represented by Ar^{Y1} are the same as the more preferable range and the further preferable range of the arylene group and the divalent heterocyclic group represented by Ar^{Y1} described above, respectively.

"The divalent group in which at least one arylene group and at least one divalent heterocyclic group are bonded directly to each other" includes, for example, groups represented by the following formulae, and each of them optionally has a substituent. 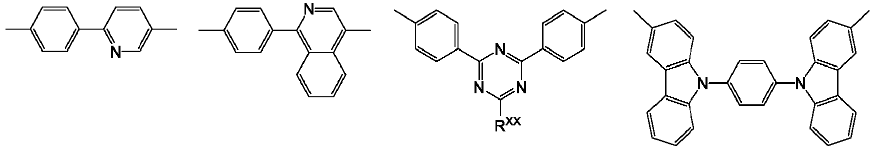 [wherein, R^{XX} represents a hydrogen atom, an alkyl group, a cycloalkyl group, an aryl group or a monovalent heterocyclic group and these groups each optionally have a substituent.]

R^{XX} is preferably an alkyl group, a cycloalkyl group or an aryl group, and these groups each optionally have a substituent.

The substituent which the group represented by Ar^{Y1} optionally has is preferably an alkyl group, a cycloalkyl group or an aryl group, and these groups each optionally further have a substituent.

The constitutional unit represented by the formula (Y) includes, for example, constitutional units represented by the formulae (Y-1) to (Y-10), and from the standpoint of the luminance life of a light emitting device comprising the composition of the present invention preferable are constitutional units represented by the formulae (Y-1) to (Y-3), from the standpoint of the electron transportability of a light emitting device comprising the composition of the present invention preferable are constitutional units represented by the formulae (Y-4) to (Y-7), and from the standpoint of the hole transportability of a light emitting device comprising the composition of the present invention preferable are constitutional units represented by the formulae (Y-8) to (Y-10). 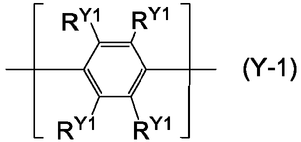 [wherein, R^{Y1} represents a hydrogen atom, an alkyl group, a cycloalkyl group, an alkoxy group, a cycloalkoxy group, an aryl group or a monovalent heterocyclic group, and these groups each optionally have a substituent. The plurality of R^{Y1} may be the same or different, and adjacent R^{Y1}s may be combined together to form a ring together with the carbon atoms to which they are attached.]

R^{Y1} is preferably a hydrogen atom, an alkyl group, a cycloalkyl group or an aryl group, and these groups each optionally have a substituent.

It is preferable that the constitional unit represented by the formula (Y-1) is a constitutional unit represented by the formula (Y-1'). 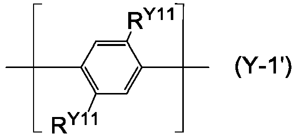 [wherein, R^{Y11} represents an alkyl group, a cycloalkyl group, an alkoxy group, a cycloalkoxy group, an aryl group or a monovalent heterocyclic group, and these groups each optionally have a substituent. The plurality of R^{Y11} may be the same or different.]

R^{Y11} is preferably an alkyl group, a cycloalkyl group or an aryl group, more preferably an alkyl group or a cycloalkyl group, and these groups each optionally have a substituent. 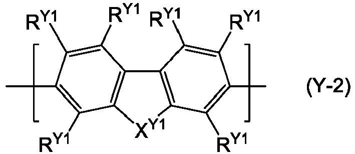 [wherein,
R^{Y1} represents the same meaning as described above.
X^{Y1} represents a group represented by -C(R^{Y2})₂-, -C(R^{Y2})=C(R^{Y2})- or -C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent heterocyclic group and these groups each optionally have a substituent. The plurality of R^{Y2} may be the same or different, and these R^{Y2}s may be combined together to form a ring together with the carbon atoms to which they are attached.]

R^{Y2} is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two R^{Y2}s in the group represented by -C(R^{Y2})₂ - in X^{Y1}, it is preferable that the both are an alkyl group or a cycloalkyl group, the both are an aryl group, the both are a monovalent heterocyclic group, or one is an alkyl group or a cycloalkyl group and the other is an aryl group or a monovalent heterocyclic group, it is more preferable that one is an alkyl group or cycloalkyl group and the other is an aryl group, and these groups each optionally have a substituent. The two groups R^{Y2} may be combined together to form a ring together with the atoms to which they are attached, and when the groups R^{Y2} form a ring, the group represented by -C(R^{Y2})₂- is preferably a group represented by the formulae (Y-A1) to (Y-A5), more preferably a group represented by the formula (Y-A4), and these groups each optionally have a substituent.

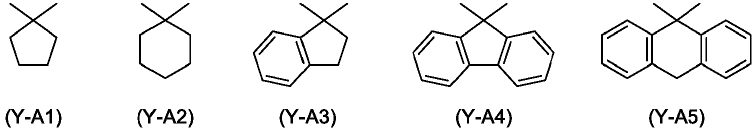

Regarding the combination of two R^{Y2}s in the group represented by -C(R^{Y2})=C(R^{Y2})- in X^{Y1}, it is preferable that the both are an alkyl group or cycloalkyl group, or one is an alkyl group or a cycloalkyl group and the other is an aryl group, and these groups each optionally have a substituent.

Four R^{Y2}s in the group represented by -C(R^{Y2})₂-C(R^{Y2})₂- in X^{Y1} are preferably an alkyl group or a cycloalkyl group each optionally having a substituent. The plurality of R^{Y2} may be combined together to form a ring together with the atoms to which they are attached, and when the groups R^{Y2} form a ring, the group represented by -C(R^{Y2})₂-C(R^{Y2})₂- is preferably a group represented by the formulae (Y-B1) to (Y-B5), more preferably a group represented by the formula (Y-B3), and these groups each optionally have a substituent. 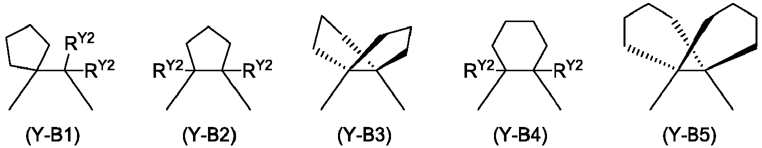 [wherein, R^{Y2} represents the same meaning as described above.]

It is preferable that the constitutional unit represented by the formula (Y-2) is a constitutional unit represented by the formula (Y-2'). 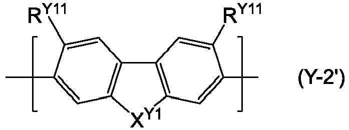 [wherein, R^{Y11} and X^{Y1} represent the same meaning as described above.] 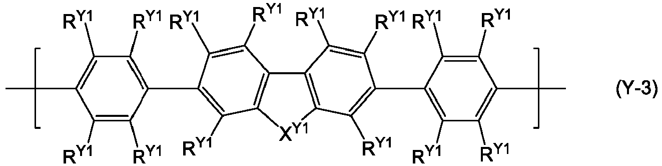 [wherein, R^{Y1} and X^{Y1} represent the same meaning as described above.]

It is preferable that the constitutional unit represented by the formula (Y-3) is a constitutional unit represented by the formula (Y-3'). 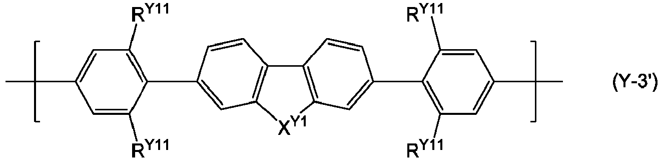 [wherein, R^{Y11} and X^{Y1} represent the same meaning as described above.] 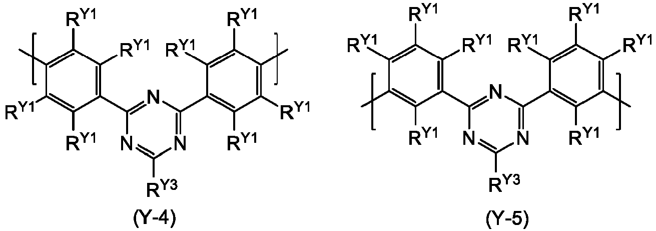 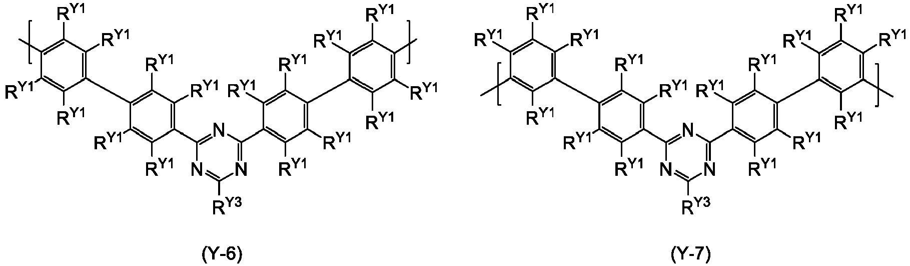 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent heterocyclic group and these groups each optionally have a substituent.]

R^{Y3} is preferably an alkyl group, a cycloalkyl group, an alkoxy group, a cycloalkoxy group, an aryl group or a monovalent heterocyclic group, more preferably an aryl group, and these groups each optionally have a substituent.

It is preferable that the constitutional unit represented by the formula (Y-4) is a constitutional unit represented by the formula (Y-4'), and it is preferable that the constitutional unit represented by the formula (Y-6) is a constitutional unit represented by the formula (Y-6'). 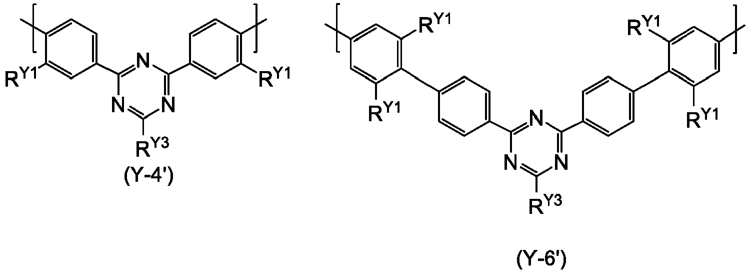 [wherein, R^{Y1} and R^{Y3} represent the same meaning as described above.] 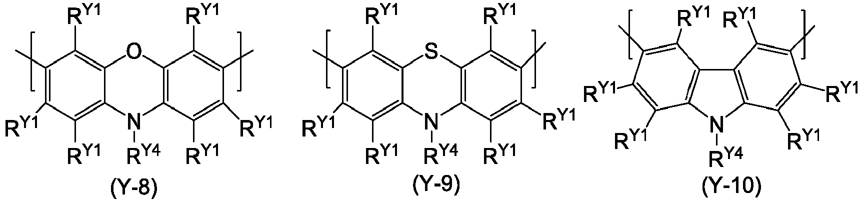 [wherein,
R^{Y1} represents the same meaning as described above.
R^{Y4} represents a hydrogen atom, an alkyl group, a cycloalkyl group, an alkoxy group, a cycloalkoxy group, an aryl group or a monovalent heterocyclic group, and these groups each optionally have a substituent.]

R^{Y4} is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formulae (Y-101) to (Y-121), a constitutional unit composed of a divalent heterocyclic group represented by the formulae (Y-201) to (Y-206), and a constitutional unit composed of a divalent group in which at least one arylene group and at least one divalent heterocyclic group are bonded directly to each other represented by the formulae (Y-301) to (Y-304).

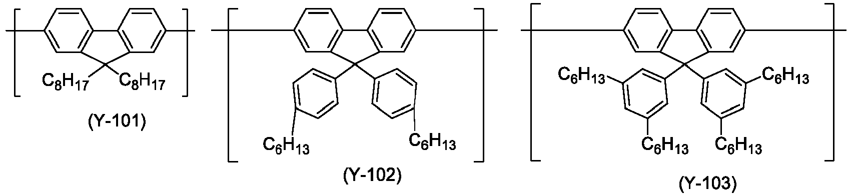

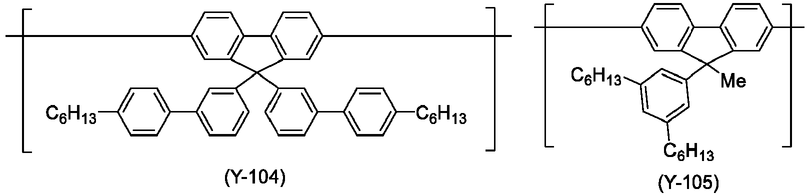

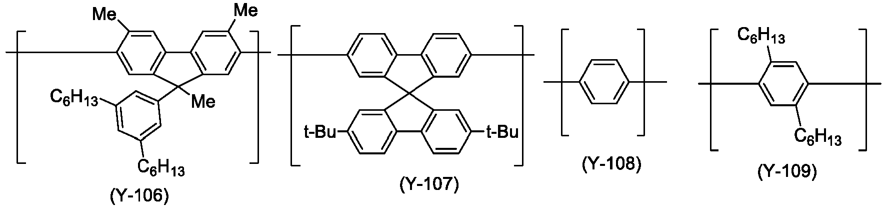

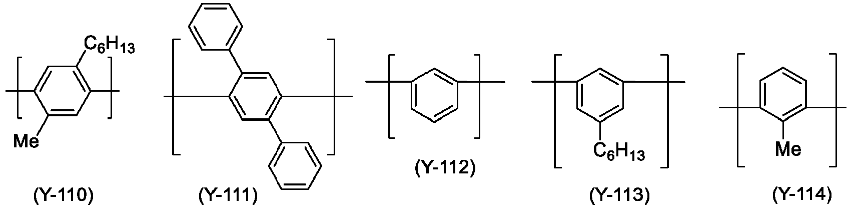

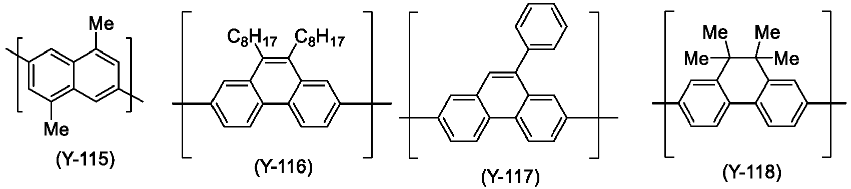

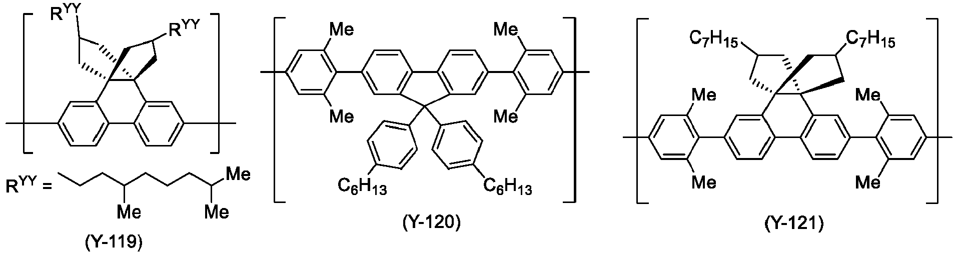

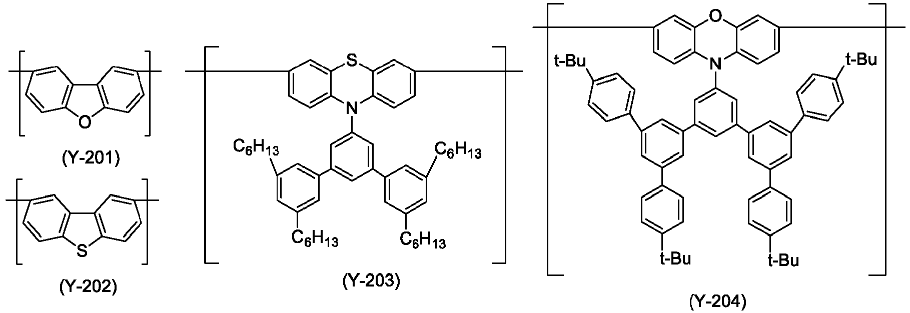

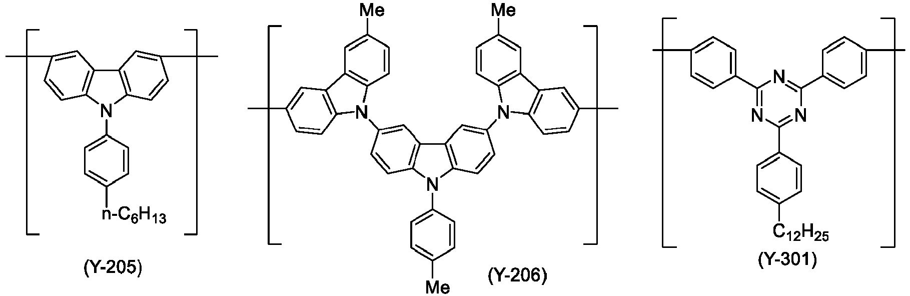

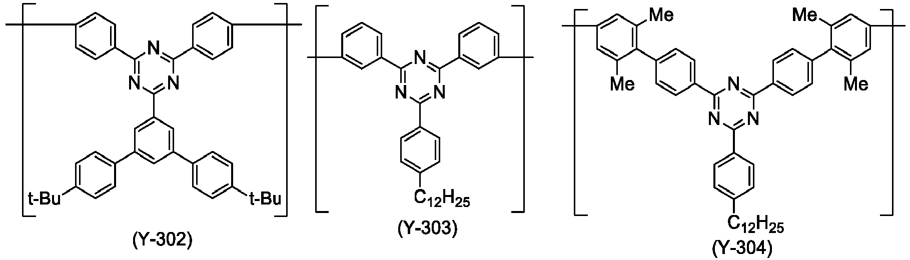

The amount of the constitutional unit represented by the formula (Y) in which Ar^{Y1} is an arylene group is preferably 0.5 to 80 mol%, more preferably 30 to 60 mol% with respect to the total amount of constitutional units contained in a polymer compound, because the luminance life of a light emitting device comprising the composition of the present invention is excellent.

The amount of the constitutional unit represented by the formula (Y) in which Ar^{Y1} is a divalent heterocyclic group or a divalent group in which at least one arylene group and at least one divalent heterocyclic group are bonded directly to each other is preferably 0.5 to 30 mol%, more preferably 3 to 20 mol% with respect to the total amount of constitutional units contained in a polymer compound, because the charge transportability of a light emitting device comprising the composition of the present invention is excellent.

The constitutional unit represented by the formula (Y) may be contained only singly or two or more units thereof may be contained in the polymer host.

It is preferable that the polymer host further comprises a constitutional unit represented by the following formula (X), because hole transportability is excellent. 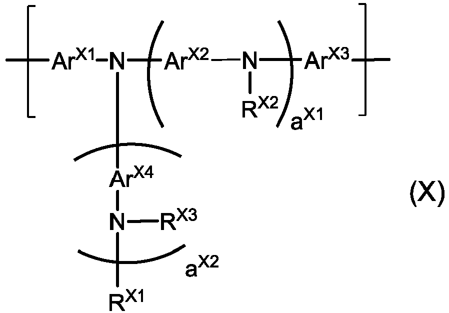 [wherein,
a^{X1} and a^{X2} each independently represent an integer of 0 or more.
Ar^{X1} and Ar^{X3} each independently represent an arylene group or a divalent heterocyclic group, and these groups each optionally have a substituent.
Ar^{X2} and Ar^{X4} each independently represent an arylene group, a divalent heterocyclic group or a divalent group in which at least one arylene group and at least one divalent heterocyclic group are bonded directly to each other, and these groups each optionally have a substituent. When a plurality of Ar^{X2} and Ar^{X4} are present, they may be the same or different at each occurrence.
R^{X1}, R^{X2} and R^{X3} each independently represent a hydrogen atom, an alkyl group, a cycloalkyl group, an aryl group or a monovalent heterocyclic group, and these groups each optionally have a substituent. When a plurality of R^{X2} and R^{X3} are present, they may be the same or different at each occurrence.]

a^{X1} is preferably 2 or less, more preferably 1, because the luminance life of a light emitting device comprising the composition of the present invention is excellent.

a^{X2} is preferably 2 or less, more preferably 0, because the luminance life of a light emitting device comprising the composition of the present invention is excellent.

R^{X1}, R^{X2} and R^{X3} are preferably an alkyl group, a cycloalkyl group, an aryl group or a monovalent heterocyclic group, more preferably an aryl group, and these groups each optionally have a substituent.

The arylene group represented by Ar^{X1} and Ar^{X3} is more preferably a group represented by the formula (A-1) or the formula (A-9), further preferably a group represented by the formula (A-1), and these groups each optionally have a substituent.

The divalent heterocyclic group represented by Ar^{X1} and Ar^{X3} is more preferably a group represented by the formula (AA-1), the formula (AA-2) or the formulae (AA-7) to (AA-26), and these groups each optionally have a substituent.

Ar^{X1} and Ar^{X3} are preferably an arylene group optionally having a substituent.

The arylene group represented by Ar^{X2} and Ar^{X4} is more preferably a group represented by the formula (A-1), the formula (A-6), the formula (A-7), the formulae (A-9) to (A-11) or the formula (A-19), and these groups each optionally have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and the further preferable range of the arylene group and the divalent heterocyclic group in the divalent group in which at least one arylene group and at least one divalent heterocyclic group are bonded directly to each other represented by Ar^{X2} and Ar^{X4} are the same as the more preferable range and the further preferable range of the arylene group and the divalent heterocyclic group represented by Ar^{X1} and Ar^{X3}, respectively.

The divalent group in which at least one arylene group and at least one divalent heterocyclic group are bonded directly to each other represented by Ar^{X2} and Ar^{X4} includes the same groups as the divalent group in which at least one arylene group and at least one divalent heterocyclic group are bonded directly to each other represented by Ar^{Y1} in the formula (Y).

Ar^{X2} and Ar^{X4} are preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups each optionally further have a substituent.

The constitutional unit represented by the formula (X) is preferably a constitutional unit represented by the formulae (X-1) to (X-7), more preferably a constitutional unit represented by the formulae (X-1) to (X-6), further preferably a constitutional unit represented by the formulae (X-3) to (X-6) . 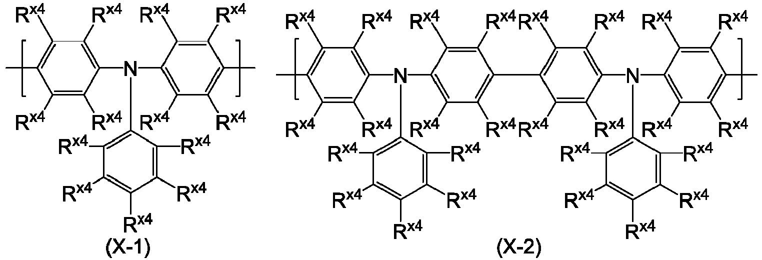 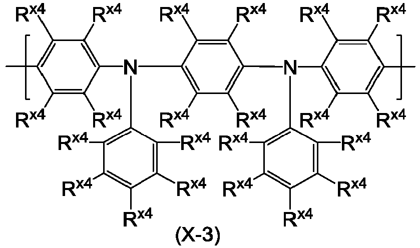 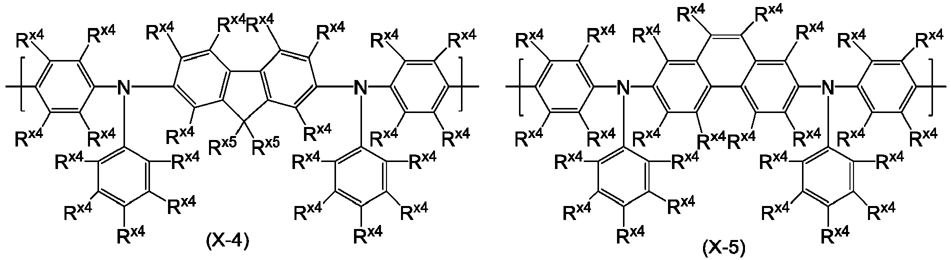 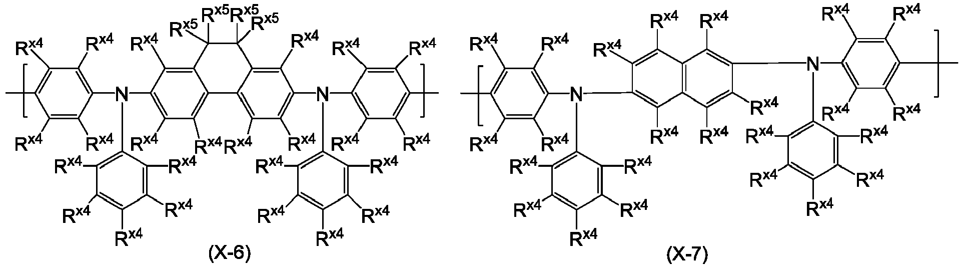 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of R^{X4} may be the same or different. The plurality of R^{X5} may be the same or different, and adjacent groups R^{X5} may be combined together to form a ring together with the carbon atoms to which they are attached.]

The amount of the constitutional unit represented by the formula (X) is preferably 0.1 to 50 mol%, more preferably 1 to 40 mol%, further preferably 5 to 30 mol% with respect to the total amount of constitutional units contained in a polymer host, because the hole transportability of the polymer host is excellent.

The constitutional unit represented by the formula (X) includes, for example, constitutional units represented by the formulae (X1-1) to (X1-11), preferably constitutional units represented by the formulae (X1-3) to (X1-10).

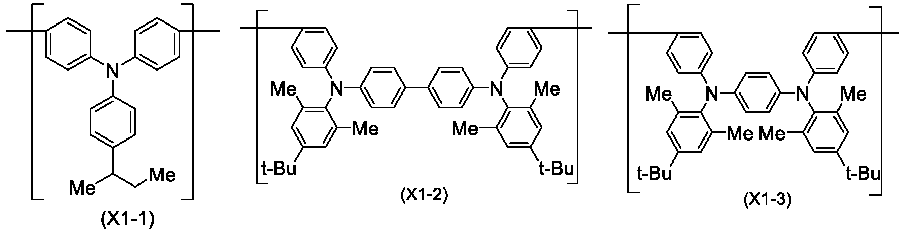

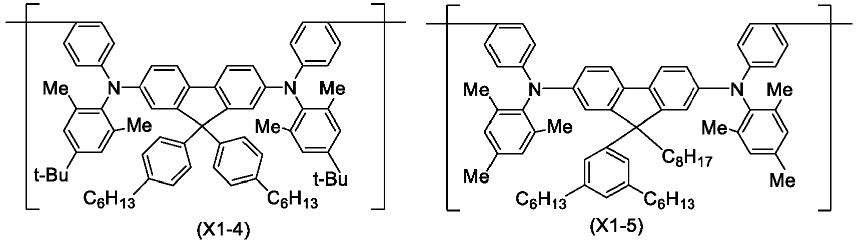

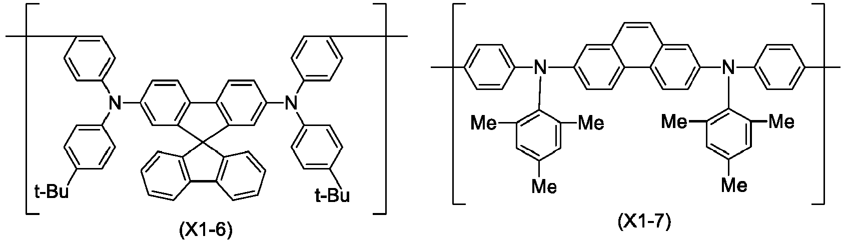

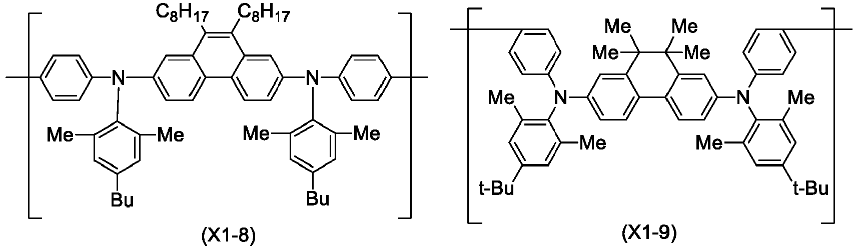

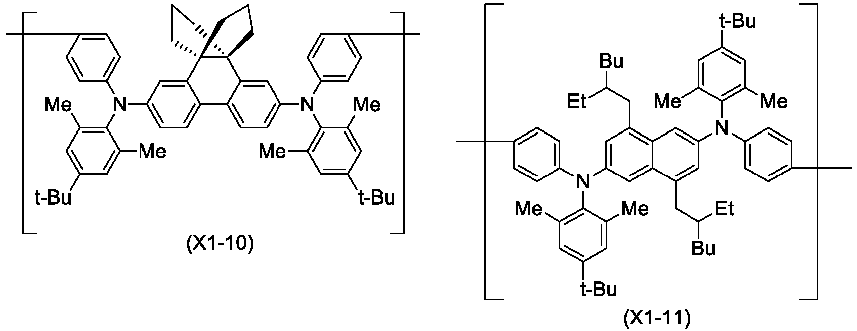

The constitutional unit represented by the formula (X) may be contained only singly or two or more units thereof may be contained in the polymer host.

Examples of the polymer host include polymer compounds (P-1) to (P-6) in Table 17.

**[Table 17]**

| polymer compound | constitutional unit and mole fraction thereof | | | | |
|---|---|---|---|---|---|
| | formula (Y) | | | formula (X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| (P-1) | 0.1 to 99.9 | 0.1 to 99.9 | 0 | 0 | 0 to 30 |
| (P-2) | 0.1 to 99.9 | 0 | 0.1 to 99.9 | 0 | 0 to 30 |
| (P-3) | 0.1 to 99.8 | 0.1 to 99.8 | 0 | 0.1 to 99.8 | 0 to 30 |
| (P-4) | 0.1 to 99.8 | 0.1 to 99.8 | 0.1 to 99.8 | 0 | 0 to 30 |
| (P-5) | 0.1 to 99.8 | 0 | 0.1 to 99.8 | 0.1 to 99.8 | 0 to 30 |
| (P-6) | 0.1 to 99.7 | 0.1 to 99.7 | 0.1 to 99.7 | 0.1 to 99.7 | 0 to 30 |

[In the table, p, q, r, s and t represent the mole fraction of each constitutional unit. p+q+r+s+t = 100, and 100 ≥ p+q+r+s ≥ 70. Other constitutional unit denotes a constitutional unit other than the constitutional unit represented by the formula (Y) and the constitutional unit represented by the formula (X).]

The polymer host may be any of a block copolymer, a random copolymer, an alternating copolymer or a graft copolymer, and may also be another embodiment, and is preferably a copolymer produced by copolymerizing a plurality of raw material monomers.

### [Production method of polymer host]

The polymer host can be produced by using a known polymerization method described in Chem. Rev., vol. 109, pp. 897-1091 (2009) and the like, and examples thereof include methods of causing polymerization by a coupling reaction using a transition metal catalyst such as the Suzuki reaction, the Yamamoto reaction, the Buchwald reaction, the Stille reaction, the Negishi reaction and the Kumada reaction.

In the above-described polymerization method, the method of charging monomers includes a method in which the total amount of monomers is charged in a lump into the reaction system, a method in which monomers are partially charged and reacted, then, the remaining monomers are charged in a lump, continuously or in divided doses, a method in which monomers are charged continuously or in divided doses, and the like.

The transition metal catalyst includes a palladium catalyst, a nickel catalyst and the like.

For the post treatment of the polymerization reaction, known methods, for example, a method of removing water-soluble impurities by liquid-separation, a method in which the reaction solution after the polymerization reaction is added to a lower alcohol such as methanol to cause deposition of a precipitate which is then filtered before drying, and other methods, are used each singly or combined. When the purity of the polymer host is low, the polymer host can be purified by usual methods such as, for example, recrystallization, reprecipitation, continuous extraction with a Soxhlet extractor and column chromatography.

The composition of the present invention comprising a solvent (hereinafter, referred to as "ink") is suitable for fabrication of a light emitting device by using printing methods such as a spin coating method, an inkjet printing method and a nozzle printing method.

The viscosity of the ink may be adjusted depending on the kind of the printing method, and when a solution goes through a discharge apparatus such as in an inkjet printing method, the viscosity is preferably in the range of 1 to 20 mPa·s at 25°C because clogging in discharging and curved aviation are less likely to occur.

As the solvent contained in the ink, those capable of dissolving or uniformly dispersing solid components in the ink are preferable. The solvent includes, for example, chlorine-based solvents such as 1,2-dichloroethane, 1,1,2-trichloroethane, chlorobenzene and o-dichlorobenzene; ether solvents such as THF, dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methylethylketone, cyclohexanone and acetophenone; ester solvents such as ethyl acetate, butyl acetate, ethylcellosolve acetate, methyl benzoate and phenyl acetate; poly-hydric alcohols such as ethylene glycol, glycerin and 1,2-hexanediol and derivatives thereof; alcohol solvents such as isopropylalcohol and cyclohexanol; sulfoxide solvents such as dimethyl sulfoxide; and amide solvents such as N-methyl-2-pyrrolidone and N,N-dimethylformamide. These solvents may be used singly or two or more of them may be used in combination.

In the ink, the compounding amount of the solvent is usually 1000 to 100000 parts by weight, preferably 2000 to 20000 parts by weight when the total content of a phosphorescent compound represented by the formula (1-A1) or (1-A3) and a phosphorescent compound represented by the formula (2-B1) or (2-B2) is 100 parts by weight.

### [Hole transporting material]

The hole transporting material is classified into low molecular weight compounds and polymer compounds, and is preferably polymer compounds, more preferably polymer compounds having a crosslinkable group.

The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene, trinitrofluorenone, preferably fullerene.

In the composition of the present invention, the compounding amount of the hole transporting material is usually 1 to 400 parts by weight, preferably 5 to 150 parts by weight when the total content of a phosphorescent compound represented by the formula (1-A1) or (1-A3) and a phosphorescent compound represented by the formula (2-B1) or (2-B2) is 100 parts by weight.

The hole transporting material may be used singly or two or more hole transporting materials may be used in combination.

### [Electron transporting material]

The electron transporting material is classified into lo w molecular weight compounds and polymer compounds. The elec tron transporting material optionally has a crosslinkable gr oup.

The low molecular weight compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.

The polymer compound includes, for example, polyphenylene, polyfluorene and derivatives thereof. These polymer compounds may be doped with a metal.

In the composition of the present invention, the compounding amount of the electron transporting material is usually 1 to 400 parts by weight, preferably 5 to 150 parts by weight when the total content of a phosphorescent compound represented by the formula (1-A1) or (1-A3) and a phosphorescent compound represented by the formula (2-B1) or (2-B2) is 100 parts by weight.

The electron transporting material may be used singly or two or more electron transporting materials may be used in combination.

### [Hole injection material and electron injection material]

The hole injection material and the electron injection m aterial are each classified into low molecular weight compou nds and polymer compounds. The hole injection material and the electron injection material optionally have a crosslinka ble group.

The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising an aromatic amine structure in the side chain or main chain.

In the composition of the present invention, the compounding amounts of the hole injection material and the electron injection material are each usually 1 to 400 parts by weight, preferably 5 to 150 parts by weight when the total content of a phosphorescent compound represented by the formula (1-A1) or (1-A3) and a phosphorescent compound represented by the formula (2-B1) or (2-B2) is 100 parts by weight.

The hole injection material and the electron injection material may each be used singly or two or more of them may be used in combination.

### [Ion dope]

When the hole injection material or the electron injection material comprises an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with a suitable amount of ions.

The kind of the ion to be doped is an anion for a hole injection material and a cation for an electron injection material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ion to be doped may be used singly or two or more ions to be doped may be used.

### [Light emitting material]

The light emitting material (differing from a phosphorescent compound represented by the formula (1) and a phosphorescent compound represented by the formula (2)) is classified into low molecular weight compounds and polymer compounds. The light emitting material optionally has a crosslinkable group.

The low molecular weight compound includes, for example, naphthalene and derivatives thereof, anthracene and derivatives thereof, perylene and derivatives thereof, and, triplet light emitting complexes having iridium, platinum or europium as the central metal.

The polymer compound includes, for example, polymer compounds comprising a phenylene group, a naphthalenediyl group, a fluorenediyl group, a phenanthrenediyl group, dihydrophenanthrenediyl group, a group represented by the formula (X), a carbazolediyl group, a phenoxazinediyl group, a phenothiazinediyl group, an anthracenediyl group, a pyrenediyl group and the like.

The light emitting material is preferably a triplet light emitting complex or a polymer compound.

The triplet light emitting complex includes, for example, metal complexes listed below.

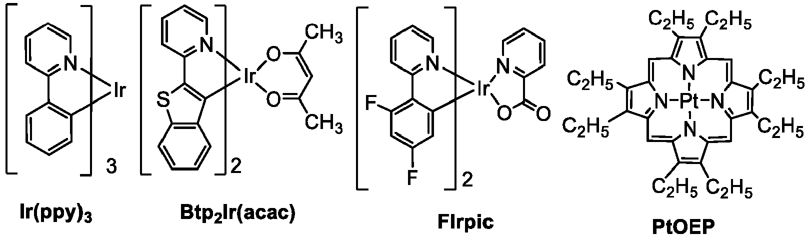

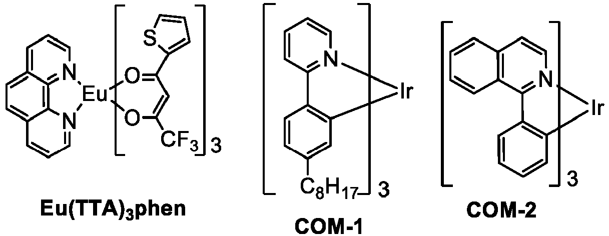

In the composition of the present invention, the compounding amount of the light emitting material is usually 0.001 to 10 parts by weight when the total content of a phosphorescent compound represented by the formula (1-A1) or (1-A3) and a phosphorescent compound represented by the formula (2-B1) or (2-B2) is 100 parts by weight.

### [Antioxidant]

The antioxidant may advantageously be one which is soluble in the same solvent as for the phosphorescent compound represented by the formula (1-A1) or (1-A3) and the phosphorescent compound represented by the formula (2-B1) or (2-B2) and does not disturb light emission and charge transportation, and the examples thereof include phenol antioxidants and phosphorus-based antioxidants.

In the composition of the present invention, the compounding amount of the antioxidant is usually 0.001 to 10 parts by weight when the total content of a phosphorescent compound represented by the formula (1-A1) or (1-A3) and a phosphorescent compound represented by the formula (2-B1) or (2-B2) is 100 parts by weight.

The antioxidant may be used singly or two or more antioxidants may be used in combination.

### <Film>

The film comprises the phosphorescent compound represent ed by the formula (1-A1) or (1-A3) and the phosphorescent co mpound represented by the formula (2-B1) or (2-B2).

The film is suitable as a light emitting layer in a light emitting device.

The film can be fabricated, for example, by using printing methods such as a spin coating method, a casting method, a micro gravure coating method, a gravure coating method, a bar coating method, a roll coating method, a wire bar coating method, a dip coating method, a spray coating method, a screen printing method, a flexo printing method, an offset printing method, an inkjet printing method, a capillary coating method and a nozzle coating method, using the ink.

The thickness of the film is usually 1 nm to 10 µm.

### <Light emitting device>

The light emitting device of the present invention is a light emitting device comprising the composition of the present invention.

The constitution of the light emitting device of the present invention has, for example, electrodes consisting of an anode and a cathode, and a layer comprising the composition of the present invention disposed between the electrodes.

### [Layer constitution]

The layer comprising the composition of the present invention is usually at least one selected from a light emitting layer, a hole transporting layer, a hole injection layer, an electron transporting layer and an electron injection layer, preferably a light emitting layer. These layers comprise a light emitting material, a hole transporting material, a hole injection material, an electron transporting material and an electron injection material, respectively. These layers can be formed by the same method as the above-described film fabrication using inks prepared by dissolving a light emitting material, a hole transporting material, a hole injection material, an electron transporting material and an electron injection material, respectively, in the solvent described above.

The light emitting device comprises a light emitting layer between an anode and a cathode. The light emitting device of the present invention preferably comprises at least one of a hole injection layer and a hole transporting layer between an anode and a light emitting layer from the standpoint of hole injectability and hole transportability, and preferably comprises at least one of an electron injection layer and an electron transporting layer between a cathode and a light emitting layer from the standpoint of electron injectability and electron transportability.

The material of a hole transporting layer, an electron transporting layer, a light emitting layer, a hole injection layer and an electron injection layer includes the above-described hole transporting materials, electron transporting materials, light emitting materials, hole injection materials and electron injection materials, respectively, in addition to the composition of the present invention.

When the material of a hole transporting layer, the material of an electron transporting layer and the material of a light emitting layer are soluble in a solvent which is used in forming a layer adjacent to the hole transporting layer, the electron transporting layer and the light emitting layer, respectively, in fabrication of a light emitting device, it is preferable that the materials have a crosslinkable group to avoid dissolution of the materials in the solvent. After forming the layers using the materials having a crosslinkable group, the layers can be insolubilized by crosslinking the crosslinkable group.

Methods of forming respective layers such as a light emitting layer, a hole transporting layer, an electron transporting layer, a hole injection layer and an electron injection layer in the light emitting device of the present invention include, for example, a method of vacuum vapor deposition from a powder and a method of film formation from solution or melted state when a low molecular weight compound is used, and, for example, a method of film formation from solution or melted state when a polymer compound is used.

The order and the number of layers to be laminated and the thickness of each layer may be controlled in view of light emission efficiency and luminance life.

When the light emitting device of the present invention has a hole transporting layer, the hole transporting material used for forming the hole transporting layer is a polymer compound comprising the above-described constitutional unit represented by the formula (X), and at least one constitutional unit selected from the group consisting of a constitutional unit represented by the formula (3) and a constitutional unit represented by the formula (4) (hereinafter, referred to also as "polymer compound of hole transporting layer") or a low molecular weight compound represented by the formula (Z'') is preferable, and a polymer compound of a hole transporting layer is more preferable.

### [Polymer compound of hole transporting layer]

The polymer compound of a hole transporting layer may further comprise the above-described constitutional unit represented by the formula (Y).

When the light emitting device of the present invention has a hole transporting layer obtained by using a polymer compound of a hole transporting layer, the hole transporting layer may be a layer comprising a polymer compound of a hole transporting layer as it is, or may also be a layer comprising a polymer compound of a hole transporting layer crosslinked intramolecularly or crosslinked intermolecularly, or crosslinked intramolecularly and intermolecularly (crosslinked body), and the layer comprising the crosslinked body of a polymer compound of a hole transporting layer is preferable. The crosslinked body of a polymer compound of a hole transporting layer may also be one in which a polymer compound of a hole transporting layer and other material are crosslinked intermolecularly.

The amount of the above-described constitutional unit represented by the formula (X) is preferably 1 to 99 mol %, more preferably 10 to 80 mol %, further preferably 20 to 70 mol %, with respect to the total amount of constitutional units contained in a polymer compound of a hole transporting layer, because a polymer compound of a hole transporting layer is excellent in hole transportability. 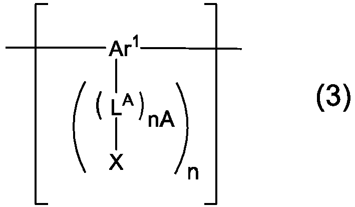 [wherein,
nA represents an integer of 0 to 5, and n represents an integer of 1 to 4.
Ar¹ represents an aromatic hydrocarbon group or a heterocyclic group, and these groups each optionally have a substituent.
L^{A} represents an alkylene group, a cycloalkylene group, an arylene group, a divalent heterocyclic group, a group represented by -NR' -, an oxygen atom or a sulfur atom, and these groups each optionally have a substituent. R' represents a hydrogen atom, an alkyl group, a cycloalkyl group, an aryl group or a monovalent heterocyclic group, and these groups each optionally have a substituent. When a plurality of L^{A} are present, they may be the same or different.
X represents a crosslinkable group represented by any one of the formulae (XL-1) to (XL-17) described above. When a plurality of X are present, they may be the same or different.]

nA is preferably an integer of 0 to 3, more preferably an integer of 0 to 2, because the light emitting device of the present invention is excellent in light emission efficiency.

n is preferably 1 or 2, more preferably 2, because the light emitting device of the present invention is excellent in light emission efficiency.

Ar¹ is preferably an aromatic hydrocarbon group optionally having a substituent, because the light emitting device of the present invention is excellent in light emission efficiency.

The number of carbon atoms of the aromatic hydrocarbon group represented by Ar¹ is usually 6 to 60, preferably 6 to 30, more preferably 6 to 18, not including the number of carbon atoms of a substituent.

The arylene group portion obtained by removing n substituents of the aromatic hydrocarbon group represented by Ar¹ is preferably a group represented by the formula (A-1) to the formula (A-20), more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19).

The number of carbon atoms of the heterocyclic group represented by Ar¹ is usually 2 to 60, preferably 3 to 30, more preferably 4 to 18, not including the number of carbon atoms of a substituent.

The divalent heterocyclic group portion obtained by removing n substituents of the heterocyclic group represented by Ar¹ is preferably a group represented by the formulae (AA-1) to (AA-34).

The aromatic hydrocarbon group and the heterocyclic group represented by Ar¹ each optionally have a substituent. The substituent which the aromatic hydrocarbon group and the heterocyclic group optionally have includes, for example, an alkyl group, a cycloalkyl group, an alkoxy group, a cycloalkoxy group, an aryl group, an aryloxy group, a halogen atom, a monovalent heterocyclic group and a cyano group.

The number of carbon atoms of the alkylene group represented by L^{A} is usually 1 to 20, preferably 1 to 15, more preferably 1 to 10, not including the number of carbon atoms of a substituent. The number of carbon atoms of the cycloalkylene group represented by L^{A} is usually 3 to 20, not including the number of carbon atoms of a substituent.

The alkylene group and the cycloalkylene group optionally have a substituent, and examples thereof include a methylene group, an ethylene group, a propylene group, a butylene group, a hexylene group, a cyclohexylene group and an octylene group.

The alkylene group and the cycloalkylene group represented by L^{A} each optionally have a substituent. The substituent which the alkylene group and the cycloalkylene group optionally have includes, for example, an alkyl group, a cycloalkyl group, an alkoxy group, a cycloalkoxy group, a halogen atom and a cyano group.

The arylene group represented by L^{A} optionally has a substituent. The arylene group is preferably a phenylene group or a fluorenediyl group, more preferably a m-phenylene group, a p-phenylene group, a fluorene-2,7-diyl group or a fluorene-9,9-diyl group. The substituent which the arylene group optionally has includes, for example, an alkyl group, a cycloalkyl group, an alkoxy group, a cycloalkoxy group, an aryl group, an aryloxy group, a monovalent heterocyclic group, a halogen atom, a cyano group and a crosslinkable group selected from Group A of crosslinkable group.

The divalent heterocyclic group represented by L^{A} is preferably a group represented by the formulae (AA-1) to (AA-34).

L^{A} is preferably an arylene group or an alkylene group, more preferably a phenylene group, a fluorenediyl group or an alkylene group, and these groups each optionally have a substituent, because synthesis of a polymer compound of a hole transporting layer is easy.

The crosslinkable group represented by X is preferably a crosslinkable group represented by the formulae (XL-1), (XL-3), (XL-7) to (XL-10), (XL-16) or (XL-17), more preferably a crosslinkable group represented by the formula (XL-1), (XL-3), (XL-9), (XL-16) or (XL-17), further preferably a crosslinkable group represented by the formula (XL-1), (XL-16) or (XL-17), particularly preferably a crosslinkable group represented by the formula (XL-1) or (XL-17), because a polymer compound of a hole transporting layer is excellent in cross-linkability.

The amount of the constitutional unit represented by the formula (3) is preferably 1 to 90 mol %, more preferably 3 to 75 mol %, further preferably 5 to 60 mol %, with respect to the total amount of constitutional units contained in a polymer compound of a hole transporting layer, because a polymer compound of a hole transporting layer is excellent in cross-linkability.

One kind of the constitutional unit represented by the formula (3) may be contained singly or two or more kinds of the constitutional units may be contained in a polymer compound of a hole transporting layer. 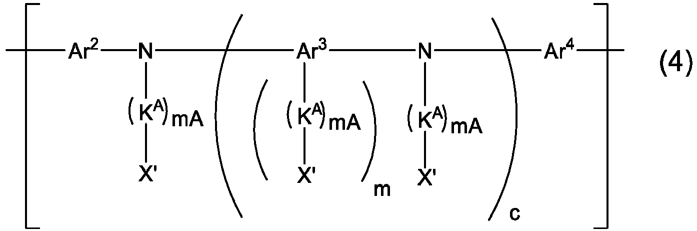 [wherein,
mA represents an integer of 0 to 5, m represents an integer of 1 to 4, and c represents 0 or 1. When a plurality of mA are present, they may be the same or different.
Ar³ represents an aromatic hydrocarbon group, a heterocyclic group or a group in which at least one aromatic hydrocarbon ring and at least one heterocyclic ring are bonded directly to each other, and these groups each optionally have a substituent.
Ar² and Ar⁴ each independently represent an arylene group or a divalent heterocyclic group, and these groups each optionally have a substituent.
Ar², Ar³ and Ar⁴ each may be bonded directly or via an oxygen atom or a sulfur atom to a group other than these groups bonding to the nitrogen atom to which they are attached, thereby forming a ring.
K^{A} is an alkylene group, a cycloalkylene group, an arylene group, a divalent heterocyclic group, a group represented by -NR"-, an oxygen atom or a sulfur atom, and these groups each optionally have a substituent. R" represents a hydrogen atom, an alkyl group, a cycloalkyl group, an aryl group or a monovalent heterocyclic group, and these groups each optionally have a substituent. When a plurality of K^{A} are present, they may be the same or different.
X' is a crosslinkable group represented by any one of the formulae (XL-1) to (XL-17) described above, a hydrogen atom, an alkyl group, a cycloalkyl group, an aryl group or a monovalent heterocyclic group, and these groups each optionally have a substituent. At least one X' is a crosslinkable group represented by any one of the formulae (XL-1) to (XL-17) described above.]

mA is preferably 0 to 2, more preferably 0 or 1, further preferably 0, because the light emitting device of the present invention is excellent in light emission efficiency.

m is preferably 1 or 2, more preferably 2, because the light emitting device of the present invention is excellent in light emission efficiency.

c is preferably 0, because synthesis of a polymer compound of a hole transporting layer is easy and the light emitting device of the present invention is excellent in light emission efficiency.

Ar³ is preferably an aromatic hydrocarbon group optionally having a substituent, because the light emitting device of the present invention is excellent in light emission efficiency.

The definition and examples of the arylene group portion obtained by removing m substituents of the aromatic hydrocarbon group represented by Ar³ are the same as the definition and examples of the arylene group represented by Ar^{X2} in the formula (X) described above.

The definition and examples of the divalent heterocyclic group portion obtained by removing m substituents of the heterocyclic group represented by Ar³ are the same as the definition and examples of the divalent heterocyclic group portion represented by Ar^{X2} in the formula (X) described above.

The definition and examples of the divalent group obtained by removing m substituents of the group in which at least one aromatic hydrocarbon ring and at least one heterocyclic ring are bonded directly to each other represented by Ar³ are the same as the definition and examples of the divalent group in which at least one arylene group and at least one divalent heterocyclic group are bonded directly to each other represented by Ar^{X2} in the formula (X) described above.

Ar² and Ar⁴ represent preferably an arylene group optionally having a substituent, because the light emitting device of the present invention is excellent in luminance life.

The definition and examples of the arylene group represented by Ar² and Ar⁴ are the same as the definition and examples of the arylene group represented by Ar^{X1} and Ar^{X3} in the formula (X) described above.

The definition and examples of the divalent heterocyclic group represented by Ar² and Ar⁴ are the same as the definition and examples of the divalent heterocyclic group represented by Ar^{X1} and Ar^{X3} in the formula (X) described above.

The groups represented by Ar², Ar³ and Ar⁴ each optionally have a substituent, and the substituent includes an alkyl group, a cycloalkyl group, an alkoxy group, a cycloalkoxy group, an aryl group, an aryloxy group, a halogen atom, a monovalent heterocyclic group and a cyano group.

The definitions and examples of the alkylene group, the cycloalkylene group, the arylene group and the divalent heterocyclic group represented by K^{A} are the same as the definitions and examples of the alkylene group, the cycloalkylene group, the arylene group and the divalent heterocyclic group represented by L^{A}, respectively.

K^{A} is preferably a phenylene group or an alkylene group, and these groups each optionally have a substituent, because synthesis of a polymer compound of a hole transporting layer is easy.

The definition and examples of the crosslinkable group represented by X' are the same as the definition and examples of the crosslinkable group represented by X described above.

The amount of the constitutional unit represented by the formula (4) is preferably 1 to 90 mol %, more preferably 3 to 50 mol %, further preferably 5 to 20 mol %, with respect to the total amount of constitutional units contained in a polymer compound of a hole transporting layer, because a polymer compound of a hole transporting layer is excellent in cross-linkability.

One kind of the constitutional unit represented by the formula (4) may be contained singly or two or more kinds of the constitutional units may be contained in a polymer compound of a hole transporting layer.

The constitutional unit represented by the formula (3) includes, for example, constitutional units represented by the formula (3-1) to the formula (3-30), and the constitutional unit represented by the formula (4) includes, for example, constitutional units represented by the formula (4-1) to the formula (4-9). Of them, preferable are constitutional units represented by the formula (3-1) to the formula (3-30), more preferable are constitutional units represented by the formula (3-1) to the formula (3-15), the formula (3-19), the formula (3-20), the formula (3-23), the formula (3-25) or the formula (3-30), further preferable are constitutional units represented by the formula (3-1) to the formula (3-13) or the formula (3-30), particularly preferable are constitutional units represented by the formula (3-1) to the formula (3-9) or the formula (3-30), because a polymer compound of a hole transporting layer is excellent in cross-linkability.

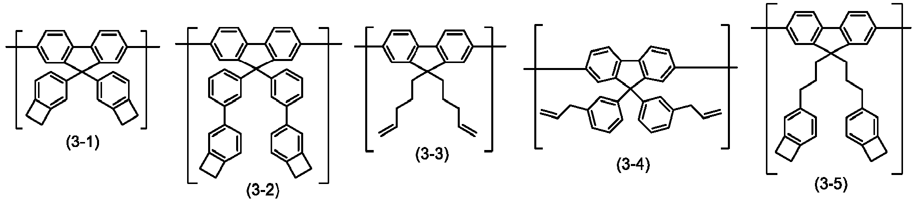

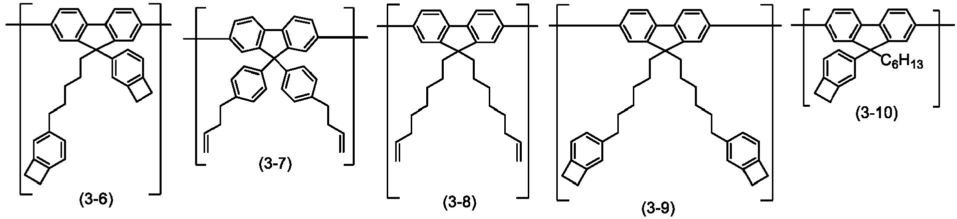

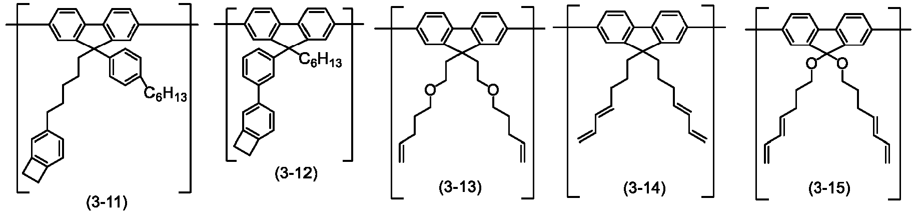

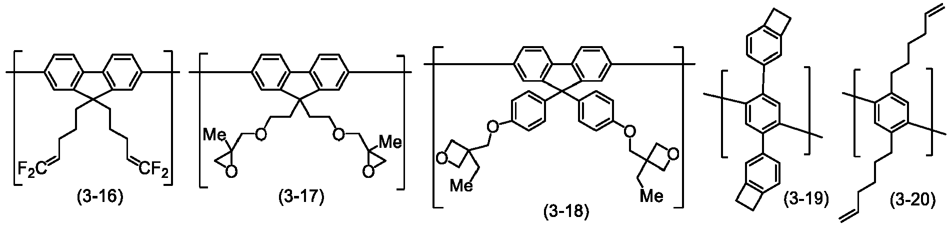

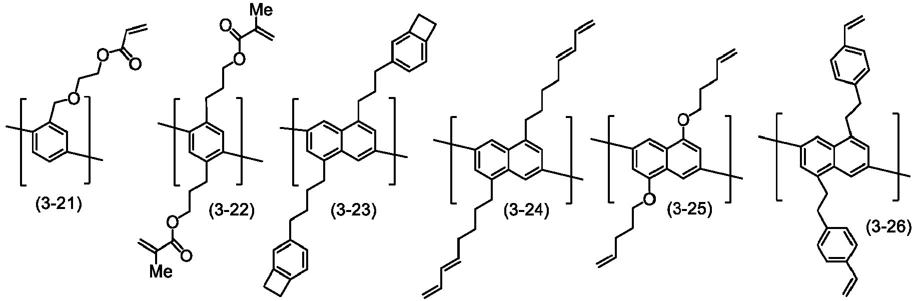

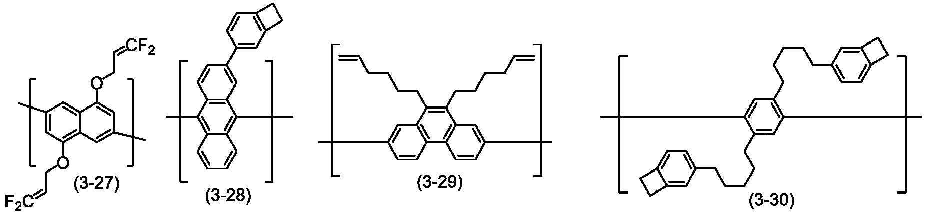

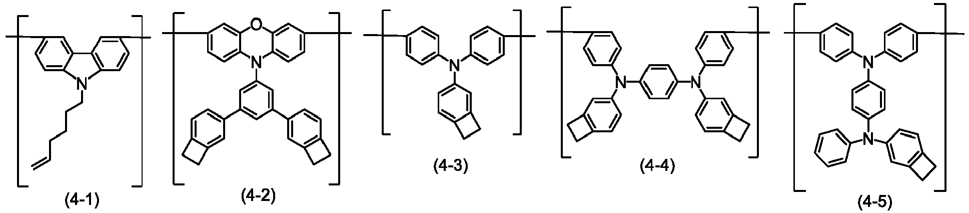

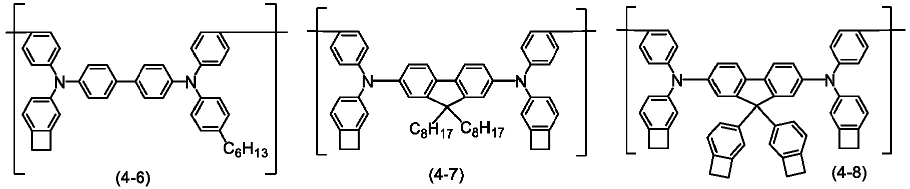

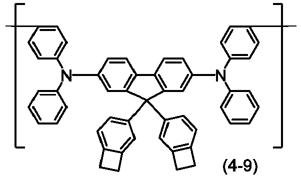

The polymer compound of a hole transporting layer may be any of a block copolymer, a random copolymer, an alternate copolymer and a graft copolymer, and may be in the form of other embodiment, and a copolymer obtained by copolymerizing several kinds of raw material monomers is preferable.

The polymer compound of a hole transporting layer can be produced by the same method as the production method of a polymer host described above.

### [Low molecular weight compound represented by the formula (Z")]

When the light emitting device of the present invention comprises a hole transporting layer obtained by using a low molecular weight compound represented by the formula (Z"), the hole transporting layer may be a layer comprising a low molecular weight compound represented by the formula (Z") as it is, or may also be a layer comprising a low molecular weight compound represented by the formula (Z") crosslinked intramolecularly or crosslinked intermolecularly, or crosslinked intramolecularly and intermolecularly (crosslinked body), and the layer comprising the crosslinked body of a low molecular weight compound represented by the formula (Z") is preferable. The crosslinked body of a low molecular weight compound represented by the formula (Z") may also be one in which a low molecular weight compound represented by the formula (Z") and other material are crosslinked intermolecularly. 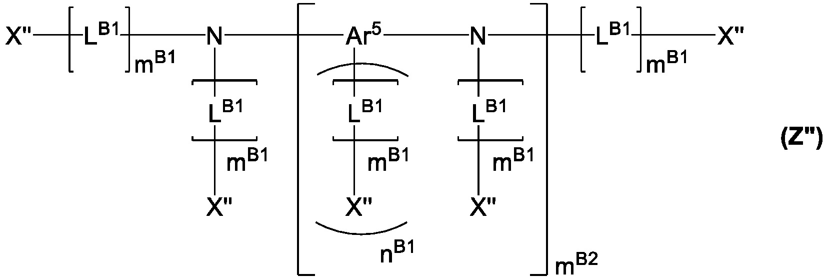 [wherein,
m^{B1} and m^{B2} each independently represent an integer of 0 or more. The plurality of m^{B1} may be the same or different.
n^{B1} represents an integer of 0 or more. When a plurality of n^{B1} are present, they may be the same or different.
Ar⁵ represents an aromatic hydrocarbon group, a heterocyclic group, or a group in which at least one aromatic hydrocarbon ring and at least one heterocyclic ring are bonded directly to each other, and these groups each optionally have a substituent. When a plurality of Ar⁵ are present, they may be the same or different.
L^{B1} represents an alkylene group, a cycloalkylene group, an arylene group, a divalent heterocyclic group, a group represented by -NR'''-, an oxygen atom or a sulfur atom, and these groups each optionally have a substituent. R''' represents a hydrogen atom, an alkyl group, a cycloalkyl group, an aryl group or a monovalent heterocyclic group, and these groups each optionally have a substituent. When a plurality of L^{B1} are present, they may be the same or different.
X" represents a crosslinkable group represented by any one of the formulae (XL-1) to (XL-17) described above, a hydrogen atom, an alkyl group, a cycloalkyl group, an aryl group or a monovalent heterocyclic group, and these groups each optionally have a substituent. The plurality of X" may be the same or different. At least one of the plurality of X" is a crosslinkable group represented by any one of the formulae (XL-1) to (XL-17) described above.]

m^{B1} is usually an integer of 0 to 10, preferably an integer of 0 to 5, more preferably an integer of 0 to 2, further preferably 0 or 1, particularly preferably 0, because synthesis of a low molecular weight compound of a hole transporting layer becomes easy.

m^{B2} is usually an integer of 0 to 10, and it is preferably an integer of 1 to 5, more preferably an integer of 1 to 3, further preferably 1 or 2, particularly preferably 1, because synthesis of a low molecular weight compound of a hole transporting layer is easy and the external quantum efficiency of the light emitting device of the present invention is more excellent.

n^{B1} is usually an integer of 0 to 5, preferably an integer of 0 to 4, more preferably an integer of 0 to 2, further preferably 0, because synthesis of a low molecular weight compound of a hole transporting layer becomes easy.

The definition and examples of the arylene group portion obtained by removing n^{B1} substituents of the aromatic hydrocarbon group represented by Ar⁵ are the same as the definition and examples of the arylene group represented by Ar^{X2} in the formula (X) described above.

The definition and examples of the divalent heterocyclic group portion obtained by removing n^{B1} substituents of the heterocyclic group represented by Ar⁵ are the same as the definition and examples of the divalent heterocyclic group portion represented by Ar^{X2} in the formula (X) described above.

The definition and examples of the divalent group obtained by removing n^{B1} substituents of the group in which at least one aromatic hydrocarbon ring and at least one heterocyclic ring are bonded directly to each other represented by Ar⁵ are the same as the definition and examples of the divalent group in which at least one arylene group and at least one divalent heterocyclic group are bonded directly to each other represented by Ar^{X2} in the formula (X) described above.

Ar⁵ is preferably an aromatic hydrocarbon group, because the external quantum efficiency of the light emitting device of the present invention is excellent.

The definitions and examples of the alkylene group, the cycloalkylene group, the arylene group and the divalent heterocyclic group represented by L^{B1} are the same as the definitions and examples of the alkylene group, the cycloalkylene group, the arylene group and the divalent heterocyclic group represented by L^{A}, respectively.

L^{B1} is preferably an alkylene group, an arylene group or an oxygen atom, more preferably an alkylene group or an arylene group, further preferably a phenylene group, a fluorenediyl group or an alkylene group, particularly preferably a phenylene group or an alkylene group, and these groups each optionally have a substituent, because synthesis of a low molecular weight compound of a hole transporting layer becomes easy.

X" is preferably a crosslinkable group selected from Group A of crosslinkable group, an aryl group or a monovalent heterocyclic group, more preferably a crosslinkable group represented by the formulae (BX-1) to (BX-13) or an aryl group, further preferably a crosslinkable group represented by the formulae (BX-1), (BX-3) or (BX-9) to (BX-13), a phenyl group, a naphthyl group or a fluorenyl group, particularly preferably a crosslinkable group represented by the formula (BX-1) or (BX-9), a phenyl group or a naphthyl group, and these groups each optionally have a substituent.

The low molecular weight compound of a hole transporting layer includes, for example, low molecular weight compounds represented by the formulae (Z"-1) to (Z"-16), and is preferably a low molecular weight compound represented by the formulae (Z"-1) to (Z"-10), more preferably a low molecular weight compound represented by the formulae (Z"-5) to (Z"-9).

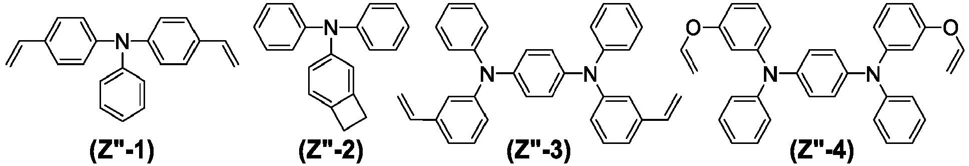

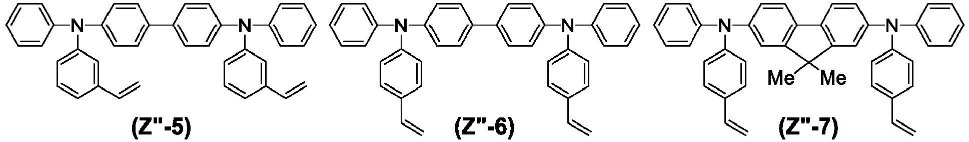

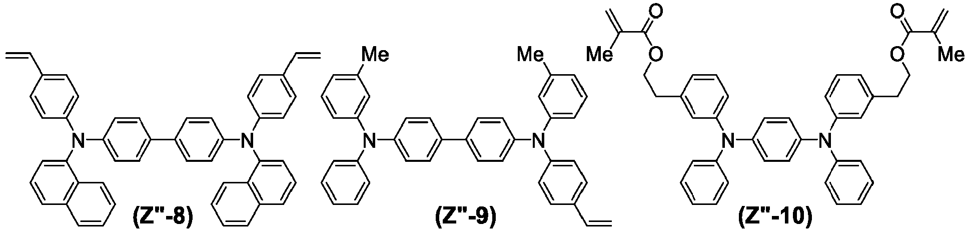

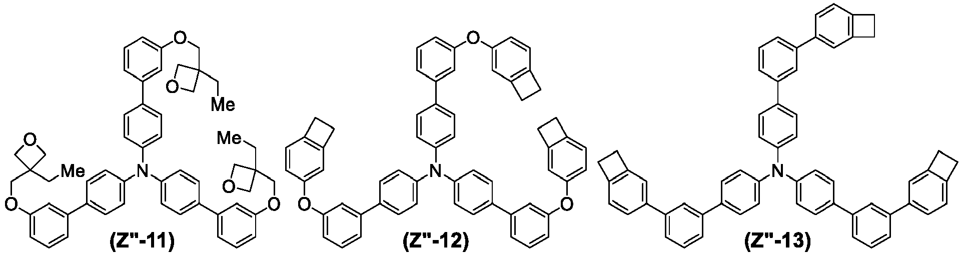

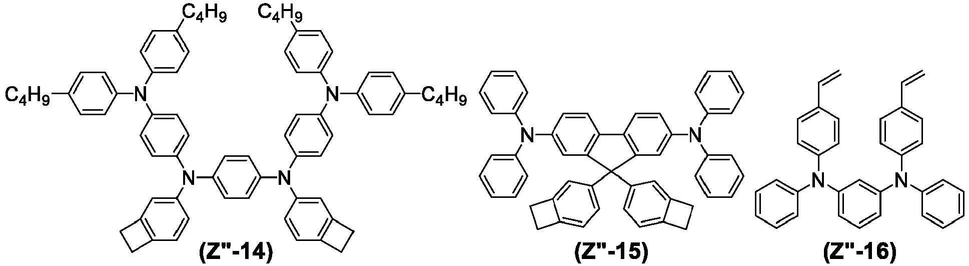

The low molecular weight compound of a hole transporting layer is available from Aldrich, Luminescence Technology Corp., American Dye Source, and the like.

Further, the low molecular weight compound can be synthesized according to methods described, for example, in International Publication WO 1997/033193, International Publication WO 2005/035221 and International Publication WO 2005/049548, in addition to the above-described means.

When the light emitting device of the present invention has an electron transporting layer, a polymer compound comprising at least one constitutional unit selected from the group consisting of a constitutional unit represented by the formula (ET-1) and a constitutional unit represented by the formula (ET-2) (hereinafter, referred to also as "polymer compound of electron transporting layer") is preferable as the electron transporting material contained in the electron transporting layer. 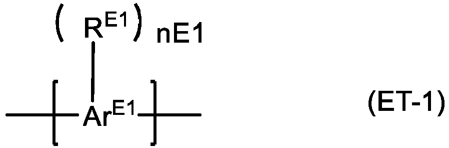 [wherein,
nE1 represents an integer of 1 or more.
Ar^{E1} represents an aromatic hydrocarbon group or a heterocyclic group, and these groups each optionally have a substituent other than R^{E1}.
R^{E1} represents a group represented by the formula (ES-1) . When a plurality of R^{E1} are present, they may be the same or different.]

-R^{E3}-{(Q^{E1})_{nE3}-Y^{E1}(M^{E1})_{aE1}(Z^{E1})_{bE1}}_{mE1} (ES-1)

[wherein,
nE3 represents an integer of 0 or more, aE1 represents an integer of 1 or more, bE1 represents an integer of 0 or more and mE1 represents an integer of 1 or more. When a plurality of nE3, aE1 and bE1 are present, they may be the same or different at each occurrence. When R^{E3} is a single bond, mE1 is 1. Further, aE1 and bE1 are selected so that the charge of a group represented by the formula (ES-1) is 0.
R^{E3} represents a single bond, a hydrocarbon group, a heterocyclic group or -O-R^{E3}' (R^{E3}' represents a hydrocarbon group or a heterocyclic group), and these groups each optionally have a substituent.
Q^{E1} represents an alkylene group, a cycloalkylene group, an arylene group, an oxygen atom or a sulfur atom, and these groups optionally have a substituent. When a plurality of Q^{E1} are present, they may be the same or different.
Y^{E1} represents -CO₂⁻, -SO₃⁻, -SO₂⁻ or PO₃²⁻. When a plurality of Y^{E1} are present, they may be the same or different.
M^{E1} represents an alkali metal cation, an alkaline earth metal cation or an ammonium cation, and this ammonium cation optionally has a substituent. When a plurality of M^{E1} are present, they may be the same or different.
Z^{E1} represents F⁻, Cl⁻, Br⁻, I⁻, OH⁻, B(R^{E4})₄⁻, R^{E4}SO₃⁻, R^{E4}COO⁻, NO₃⁻, SO₄²⁻, HSO₄⁻, PO₄³⁻, HPO₄²⁻, H₂PO₄⁻, BF₄⁻ or PF₆⁻ . R^{E4} represents an alkyl group, a cycloalkyl group or an aryl group, and these groups each optionally have a substituent. When a plurality of Z^{E1} are present, they may be the same or different.]

nE1 is usually an integer of 1 to 4, preferably 1 or 2.

The aromatic hydrocarbon group or the heterocyclic group represented by Ar^{E1} is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2, 7-carbazolediyl group nE1 hydrogen atoms bonding directly to atoms constituting its ring, and optionally has a substituent other than R^{E1}.

The substituent other than R^{E1} which Ar^{E1} optionally has includes a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group and a group represented by the formula (ES-3) .

-O-(C_{n'}H_{2n'}O)ₙₓ-C_{m'}H_{2m'+1} (ES-3)

[wherein, n' , m' and nx each independently represent an integer of 1 or more.]

nE3 is usually an integer of 0 to 10, preferably an integer of 0 to 8, more preferably an integer of 0 to 2.

aE1 is usually an integer of 1 to 10, preferably an integer of 1 to 5, more preferably 1 or 2.

bE1 is usually an integer of 0 to 10, preferably an integer of 0 to 4, more preferably 0 or 1.

mE1 is usually an integer of 1 to 5, preferably 1 or 2, more preferably 0 or 1.

When R^{E3} is -O-R^{E3}', the group represented by the formula (ES-1) is a group represented by the following formula.

-O-R^{E3}'-{(Q^{E1})_{nE3}-Y^{E1}(M^{E1})_{aE1}(Z^{E1})_{bE1}}_{mE1}

R^{E3} is preferably a hydrocarbon group or a heterocyclic group, more preferably an aromatic hydrocarbon group or an aromatic heterocyclic group, further preferably an aromatic hydrocarbon group.

The substituent which R^{E3} optionally has includes an alkyl group, a cycloalkyl group, an aryl group, a monovalent heterocyclic group and a group represented by the formula (ES-3), and is preferably a group represented by the formula (ES-3) .

Q^{E1} is preferably an alkylene group, an arylene group or an oxygen atom, more preferably an alkylene group or an oxygen atom.

Y^{E1} is preferably -CO₂⁻, -SO₂⁻ or PO₃²⁻, more preferably -CO₂⁻.

The alkali metal cation represented by M^{E1} includes, for example, Li⁺, Na⁺, K⁺, Rb⁺ and Cs⁺, and is preferably K⁺, Rb⁺ or Cs⁺, more preferably Cs⁺.

The alkaline earth metal cation represented by M^{E1} includes, for example, Be²⁺, Mg²⁺, Ca²⁺, Sr²⁺ and Ba²⁺, and is preferably Mg²⁺, Ca²⁺, Sr²⁺ or Ba²⁺, more preferably Ba²⁺.

M^{E1}is preferably an alkali metal cation or an alkaline earth metal cation, more preferably an alkali metal cation.

Z^{E1} is preferably F⁻, Cl⁻, Br⁻, I⁻, OH⁻, B(R^{E4})₄⁻, R^{E4}SO₃⁻, R^{E4}COO⁻ or NO₃⁻, more preferably F⁻, Cl⁻ , Br⁻ , I⁻ , OH⁻, R^{E4}SO₃⁻ or R^{E4}COO⁻. R^{E4} is preferably an alkyl group.

The group represented by the formula (ES-1) includes, for example, groups represented by the following formulae. 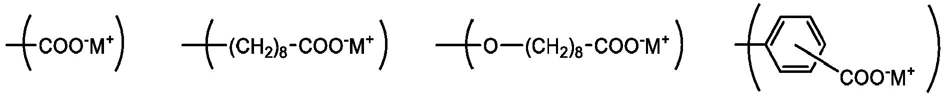 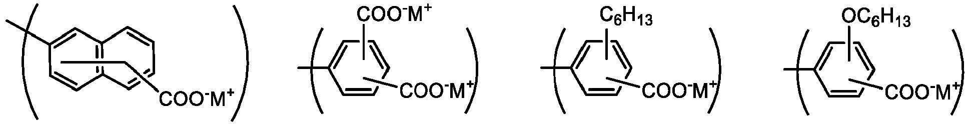 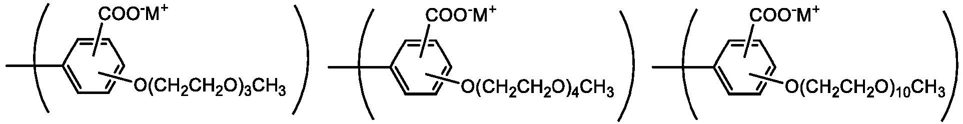 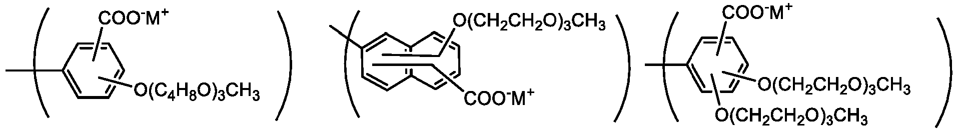 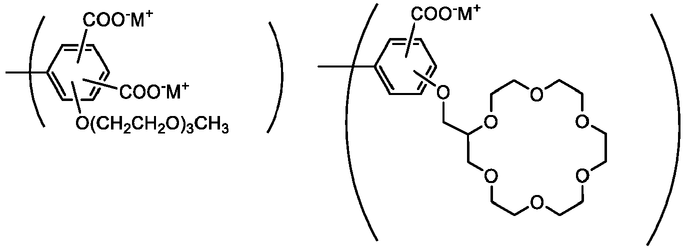 [wherein, M⁺ represents Li⁺, Na⁺, K⁺, Cs⁺ or N(CH₃)₄⁺. When a plurality of M⁺ are present, they may be the same or different.]. 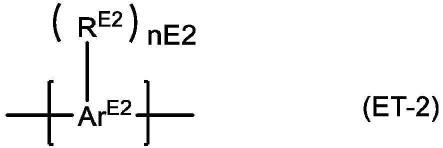 [wherein,
nE2 represents an integer of 1 or more.
Ar^{E2} represents an aromatic hydrocarbon group or a heterocyclic group, and these groups each optionally have a substituent other than R^{E2}.
R^{E2} represents a group represented by the formula (ES-2). When a plurality of R^{E2} are present, they may be the same or different.]

-R^{E5}-{(Q^{E2})_{nE}4-Y^{E2}(M^{E2})_{aE2}(Z^{E2})_{bE2}}_{mE2} (ES-2)

[wherein,
nE4 represents an integer of 0 or more, aE2 represents an integer of 1 or more, bE2 represents an integer of 0 or more and mE2 represents an integer of 1 or more. When a plurality of nE4, aE2 and bE2 are present, they may be the same or different at each occurrence. When R^{E5} is a single bond, mE2 is 1. Further, aE2 and bE2 are selected so that the charge of a group represented by the formula (ES-2) is 0.
R^{E5} represents a single bond, a hydrocarbon group, a heterocyclic group or -O-R^{E5}' (R^{E5}' represents a hydrocarbon group or a heterocyclic group), and these groups each optionally have a substituent.
Q^{E2} represents an alkylene group, a cycloalkylene group, an arylene group, an oxygen atom or a sulfur atom, and these groups each optionally have a substituent. When a plurality of Q^{E2} are present, they may be the same or different.
Y^{E2} represents -C⁺R^{E6}₂, -N⁺R^{E6}₃, -P⁺R^{E6}₃, -S⁺R^{E6}₂ or -I⁺R^{E6}₂. R^{E6} represents a hydrogen atom, an alkyl group, a cycloalkyl group or an aryl group, and these groups each optionally have a substituent. The plurality of R^{E6} may be the same or different. When a plurality of Y^{E2} are present, they may be the same or different.
M^{E2} represents F⁻, Cl-, Br-, I⁻, OH-, B(R^{E7})₄-, R^{E7}SO₃⁻, R^{E7}COO⁻, BF₄-, SbCl₆- or SbF₆- . R^{E7} represents an alkyl group, a cycloalkyl group or an aryl group, and these groups each optionally have a substituent. When a plurality of M^{E2} are present, they may be the same or different.
Z^{E2} represents an alkali metal cation or an alkaline earth metal cation. When a plurality of Z^{E2} are present, they may be the same or different.]

nE2 is usually an integer of 1 to 4, preferably 1 or 2.

The aromatic hydrocarbon group or heterocyclic group represented by Ar^{E2} is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, 2,7-phenanthrenediyl group or a 2,7-carbazolediyl group nE2 hydrogen atoms bonding directly to atoms constituting its ring, and optionally has a substituent other than R^{E2}.

The substituent other than R^{E2} which Ar^{E2} optionally has is the same as the substituent other than R^{E1} which Ar^{E1} optionally has.

nE4 is usually an integer of 0 to 10, preferably an integer of 0 to 8, more preferably an integer of 0 to 2.

aE2 is usually an integer of 1 to 10, preferably an integer of 1 to 5, more preferably 1 or 2.

bE2 is usually an integer of 0 to 10, preferably an integer of 0 to 4, more preferably 0 or 1.

mE2 is usually an integer of 1 to 5, preferably 1 or 2, more preferably 0 or 1.

When R^{E5} is -O-R^{E5}', the group represented by the formula (ES-2) is a group represented by the following formula.

-O-R^{E5}'-{(Q^{E1})_{nE3}-Y^{E1}(M^{E1})_{aE1}(Z^{E1})_{bE1}}_{mE1}

R^{E5} is preferably a hydrocarbon group or a heterocyclic group, more preferably an aromatic hydrocarbon group or an aromatic heterocyclic ring, further preferably an aromatic hydrocarbon group.

The substituent which R^{E5} optionally has includes an alkyl group, a cycloalkyl group, an aryl group, a monovalent heterocyclic group and a group represented by the formula (ES-3), and is preferably a group represented by the formula (ES-3) .

Q^{E2} is preferably an alkylene group, an arylene group or an oxygen atom, more preferably an alkylene group or an oxygen atom.

Y^{E2} is preferably -C⁺R^{E6}₂, -N⁺R^{E6}₃, -P⁺R^{E6}₃ or S⁺R^{E6}₂, more preferably -N⁺R^{E6}₃. R^{E6} is preferably a hydrogen atom, an alkyl group or an aryl group, more preferably a hydrogen atom or an alkyl group.

M^{E2} is preferably F⁻, Cl⁻, Br⁻, I⁻ , B(R^{E7})₄⁻, R^{E7}SO₃⁻, R^{E7}COO⁻, BF₄⁻ or SbF⁶⁻, more preferably Br⁻, I⁻, B(R^{E7})₄⁻, R^{E7}COO⁻ or SbF⁶⁻. R^{E7} is preferably an alkyl group.

The alkali metal cation represented by Z^{E2} includes, for example, Li⁺, Na⁺, K⁺, Rb⁺ and Cs⁺, and is preferably Li⁺, Na⁺ or K⁺.

The alkaline earth metal cation represented by Z^{E2} includes, for example, Be²⁺, Mg²⁺, Ca²⁺, Sr²⁺ and Ba²⁺, and is preferably Mg²⁺ or Ca²⁺.

Z^{E2} is preferably an alkali metal cation.

The group represented by the formula (ES-2) includes, for example, groups represented by the following formulae. 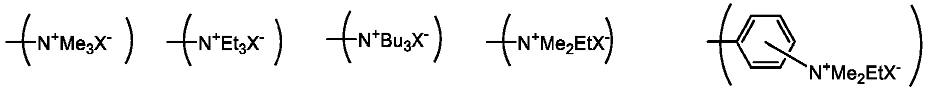 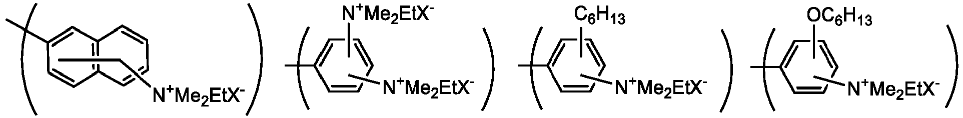 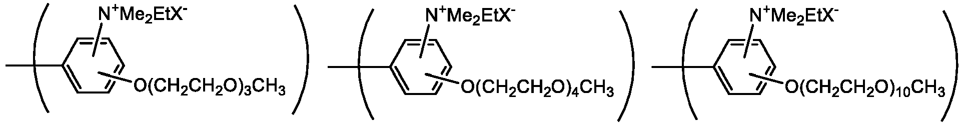 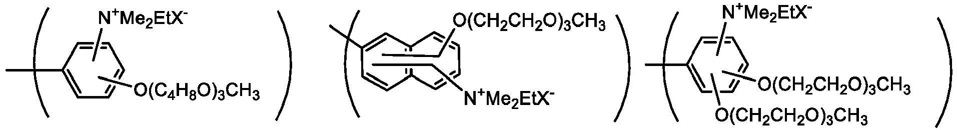 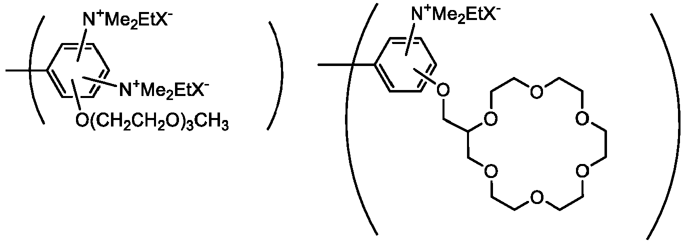 [wherein, X⁻ represents F⁻, Cl⁻, Br⁻, I⁻ , B(C₆H₅)₄⁻, CH₃COO⁻ or CF₃SO₃⁻. When a plurality of X⁻ are present, they may be the same or different.]

The constitutional unit represented by the formula (ET-1) and the formula (ET-2) includes, for example, constitutional units represented by the formula (ET-31) to the formula (ET-34) described below.

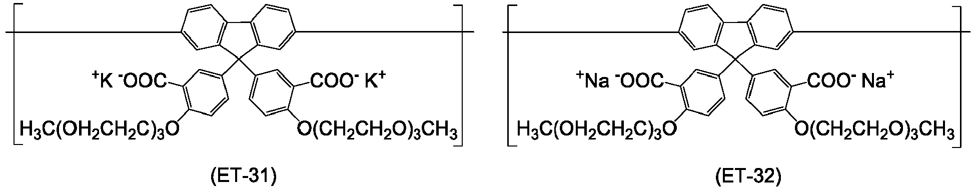

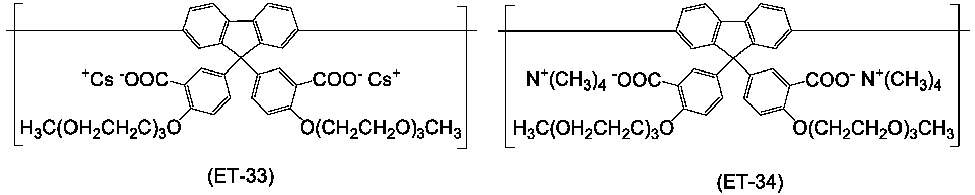

The polymer compound in an electron transporting layer can be synthesized, for example, according to methods described in JP-A No. 2009-239279, JP-A No. 2012-033845, JP-A No. 2012-216821, JP-A No. 2012-216822 and JP-A No. 2012-216815.

### [Substrate/electrode]

The substrate in the light emitting device may advantageously be a substrate on which an electrode can be formed and which does not chemically change in forming an organic layer, and is a substrate made of a material such as, for example, glass, plastic and silicon. In the case of an opaque substrate, it is preferable that an electrode most remote from the substrate is transparent or semi-transparent.

The material of the anode includes, for example, electrically conductive metal oxides and semi-transparent metals, preferably, indium oxide, zinc oxide and tin oxide; electrically conductive compounds such as indium▪tin▪oxide (ITO) and indium▪zinc▪oxide; a composite of silver, palladium and copper (APC); NESA, gold, platinum, silver and copper.

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode may each take a lamination structure composed of two or more layers.

### [Use]

For producing planar light emission by using a light emitting device, a planar anode and a planar cathode are disposed so as to overlap with each other. Patterned light emission can be produced by a method of placing a mask with a patterned window on the surface of a planer light emitting device, a method of forming extremely thick a layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross orthogonally with each other. Partial color display and multi-color display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light emitting device can be suitably used as a planer light source for backlight of a liquid crystal display or as a planar light source for illumination. If a flexible substrate is used, it can be used also as a curved light source and a curved display.

### EXAMPLES

The present invention will be illustrated further in detail by examples below, but the present invention is not limited to these examples. Examples falling outside of the scope of the claims are included for reference purposes only.

In the present examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as described below.

### [Measurement condition]

The polymer compound to be measured was dissolved in THF at a concentration of about 0.05 wt%, and 10 µL of the solut ion was injected into SEC. As the mobile phase of SEC, THF w as used and allowed to flow at a flow rate of 2.0 mL/min. A s the column, PLgel MIXED-B (manufactured by Polymer Laborat ories) was used. As the detector, UV-VIS detector (manufact ured by Shimadzu Corp., trade name: SPD-10Avp) was used.

In the present examples, measurement of NMR was carried out according to the following method.

5 to 10 mg of a measurement sample was dissolved in about 0.5 mL of deuterated chloroform (CDCl₃), deuterated tetrahydrofuran (THF-ds), deuterated dimethyl sulfoxide (DMSO-d₆), deuterated acetone ((CD₃)₂CO-d₆), deuterated N,N-dimethylformamide (DMF-d₇), deuterated toluene (C₆D₅-CD₃), deuterated methanol (CD₃OD), deuterated ethanol (CD₃ CD₂OD), deuterated 2-propanol (CD₃ -CDOD-CD₃) or deuterated dichloromethane (CD₂Cl₂), and measurement was performed using an NMR apparatus (manufactured by Agilent, Inc., trade name: INOVA 300 or MERCURY 400VX).

In the present examples, the maximum peak wavelength of the emission spectrum of a phosphorescent compound was measured by a spectrophotometer (manufactured by JASCO Corporation, FP-6500) at room temperature. A xylene solution prepared by dissolving a phosphorescent compound in xylene at a concentration of about 0.8×10⁻⁴ wt% was used as a sample. As the excitation light, an UV light having a wavelength of 325 nm was used.

### <Synthesis Examples B1 to B6> Synthesis of compounds B1 to B6

A compound B1 was synthesized based on a method described in US Patent Application Publication No. 2014/0151659.

A compound B2 was synthesized based on a method described in International Publication WO 2006/121811.

A compound B3 was synthesized based on methods described in International Publication WO 2006/121811 and JP-A No. 2013-048190.

A compound B4 was synthesized according to a method described in US Patent Application Publication No. 2014/0151659.

Compounds B5 and B6 were synthesized according to a method described in JP-A No. 2013-147551.

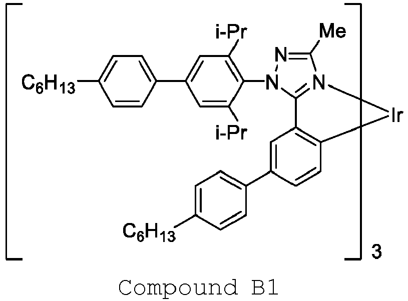

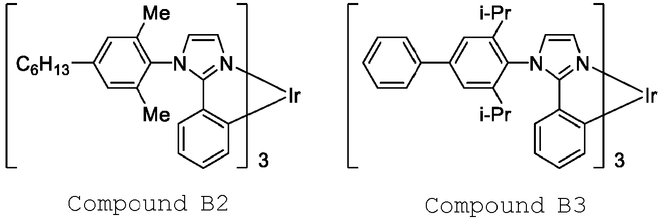

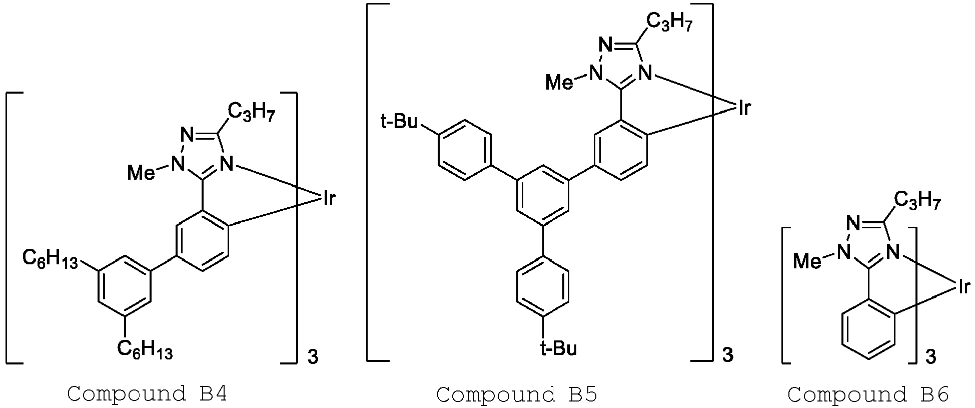

### <Synthesis Example B7> Synthesis of compound B7

### (Synthesis Example B7-1) Synthesis of compound L1

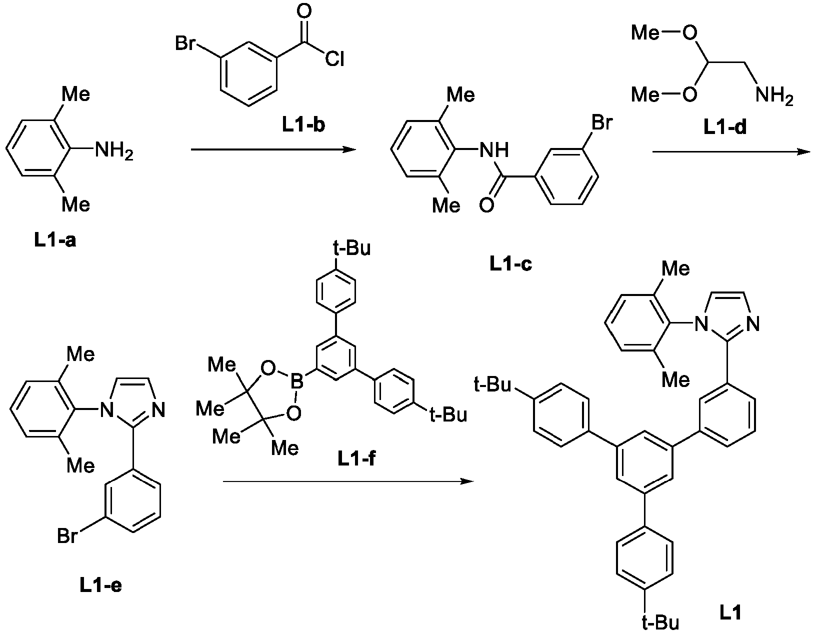

An argon gas atmosphere was prepared in a reaction vessel, then, a compound L1-a (5.75 g), pyridine (120 mL) and a compound L1-b (13.5 g) were added, and stirred at room temperature for 16 hours, then, the resultant reaction solution was concentrated under reduced pressure, to obtain a white solid. The resultant white solid was added to water, then, filtrated under reduced pressure, to obtain a solid. The resultant solid was purified by silica gel chromatography (dichloromethane), to obtain a compound L1-c (14.4 g, yield: 71%, white solid).

¹H-NMR (400 MHz, CDCl₃): δ (ppm) = 8.06 (t, 1H), 7.83 (d, 1H), 7.69 (d, 1H), 7.38 (t, 1H), 7.31 (m, 1H), 7.17-7.10 (m, 3H), 2.28 (m, 6H).

An argon gas atmosphere was prepared in a reaction vessel, then, the compound L1-c (6.88 g) and phosphorus pentachloride (4.64 g) were added. Into this was dropped phosphoryl chloride (60 mL), then, the mixture was stirred for 16 hours under reflux with heating. Thereafter, the mixture was cooled down to room temperature, and phosphoryl chloride was concentrated under reduced pressure. Thereafter, to this were added 2-propanol (60 mL) and a compound L1-d (48 mL), and the mixture was stirred for 16 hours. Thereafter, into this was dropped 12M hydrochloric acid, and the mixture was stirred for 20 hours under reflux with heating. Thereafter, the mixture was cooled down to room temperature, and the deposited black solid was removed by filtration. To the resultant filtrate was added a sodium hydroxide aqueous solution to adjust pH to around 12, then, toluene was added and extraction was performed. The resultant organic layer was concentrated under reduced pressure, to obtain a black oil. The resultant black oil was purified by silica gel chromatography (ethyl acetate/dichloromethane), to obtain a compound L1-e (4.73 g, yield: 64%, pale yellow powder) . This operation was conducted repeatedly, to obtain a necessary amount of the compound L1-e.

¹H-NMR (400 MHz, CDCl₃) : δ (ppm) = 7.69 (t, 1H), 7.36-7.25 (m, 3H), 7.17-7.14 (m, 3H), 7.03 (t, 1H), 6.93 (d, 1H), 1.96 (s, 6H).

An argon gas atmosphere was prepared in a reaction vessel, then, the compound L1-e (5.70 g), a compound L1-f (16.3 g), triphenylphosphine (0.91 g), toluene (30 mL), ethanol (15 mL), a 2M sodium carbonate aqueous solution (30 mL) and bis (triphenylphosphine) palladium(II) dichloride (0.61 g) were added, and the mixture was stirred for 16 hours under reflux with heating. Thereafter, the mixture was cooled down to room temperature, and toluene was added and extraction was performed. The resultant organic layer was washed with ion exchanged water, then, concentrated under reduced pressure, to obtain a solid. The resultant solid was purified by silica gel chromatography (ethyl acetate/dichloromethane), to obtain a compound L1 (9.93 g, yield: 99%).

¹H-NMR (400 MHz, (CD₃)₂CO-d₆) : δ (ppm) =7.82 (t, 1H), 7.79 (dt, 1H), 7.75 (m, 1H), 7.70 (m, 4H), 7.60 (m, 4H), 7.52 (t, 1H), 7.50 (d, 2H), 7.46 (t, 1H), 7.30 (d, 1H), 7.28-7.20 (m, 3H), 7.18 (d, 1H), 2.00 (s, 6H), 1.39 (s, 18H).

### (Synthesis Example B7-2) Synthesis of compound B7

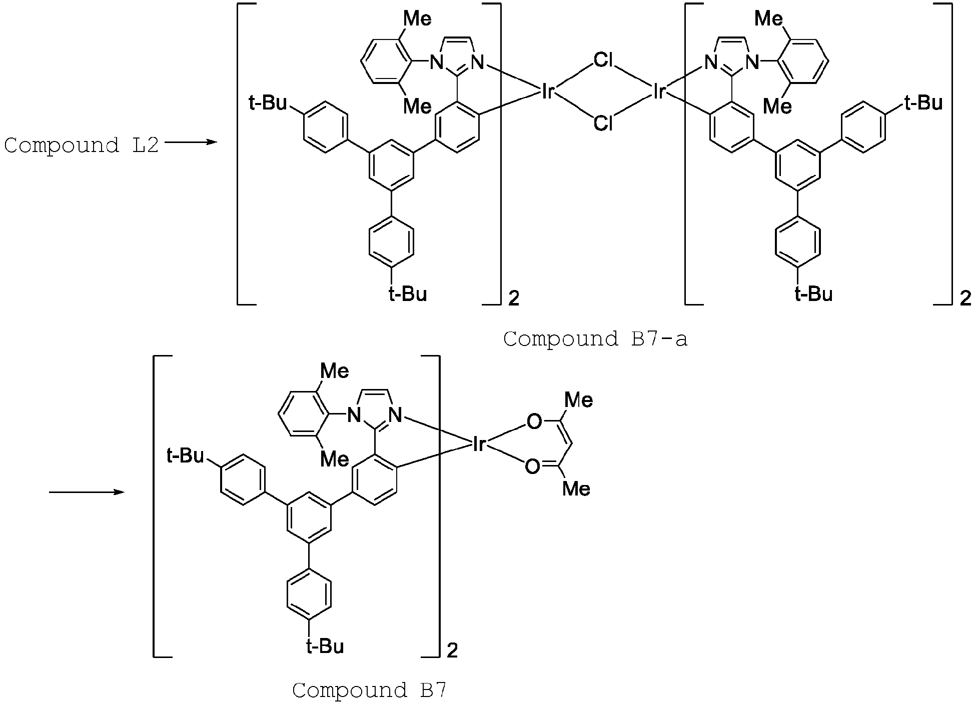

An argon gas atmosphere was prepared in a reaction vessel, then, the compound L1 (1.5 g), iridium chloride hydrate (400 mg) , 2-ethoxyethanol (36 mL) and water (18 mL) were added, the mixture was stirred for 16 hours under reflux with heating. Thereafter, the mixture was cooled down to room temperature, and the resultant reaction solution was concentrated under reduced pressure. Thereafter, to this was added water (20 mL), the deposited yellow-green solid was filtrated, and the resultant solid was washed with water and methanol in series. The resultant solid was dried under reduced pressure, to obtain a compound B7-a (1.6 g, yellow-green powder).

An argon gas atmosphere was prepared in a reaction vessel, then, the compound B7-a (1.6 g), silver trifluoromethanesulfonate (310 mg), dichloromethane (57 mL) and methanol (57 mL) were added, and the mixture was stirred for 4 hours under reflux with heating. Thereafter, the mixture was cooled down to room temperature, and the solvent was concentrated under reduced pressure. Thereafter, to this were added sodium acetylacetonate (0.69 g) and acetonitrile (100 mL), and the mixture was stirred for 16 hours under reflux with heating. Thereafter, the mixture was cooled down to room temperature, and the solvent was concentrated under reduced pressure. Thereafter, to this was added dichloromethane (100 mL), and filtration was performed. The resultant filtrate was concentrated under reduced pressure, to obtain a brown solid. The resultant brown solid was purified by silica gel column chromatography (dichloromethane), to obtain a compound B7 (0.94 g, yield: 57%, yellow powder).

¹H-NMR (400 MHz, (CD₃)₂CO-d₆) : δ (ppm) = 7.64-7.59 (m, 10H), 7.56-7.53 (m, 8H), 7.47 (s, 6H), 7.42 (d, 2H), 7.35 (d, 4H), 7.33 (d, 2H), 7.04 (dd, 2H), 6.75 (d, 2H), 6.55 (d, 2H), 5.29 (s, 1H), 2.26 (s, 6H), 2.15 (s, 6H), 1.77 (s, 6H), 1.37 (s, 36H) .

The maximum peak wavelength of the emission spectrum of the compound B1 was 474 nm.

The maximum peak wavelength of the emission spectrum of the compound B2 was 469 nm.

The maximum peak wavelength of the emission spectrum of the compound B3 was 471 nm.

The maximum peak wavelength of the emission spectrum of the compound B4 was 469 nm.

The maximum peak wavelength of the emission spectrum of the compound B5 was 475 nm.

The maximum peak wavelength of the emission spectrum of the compound was 450 nm.

The maximum peak wavelength of the emission spectrum of the compound B7 was 492 nm.

### <Synthesis Examples G1 and G2> Synthesis of compounds G1 and G2

A compound G1 was synthesized according to a method described in JP-A No. 2013-237789.

A compound G2 was synthesized based on a method described in International Publication WO 2004/026886.

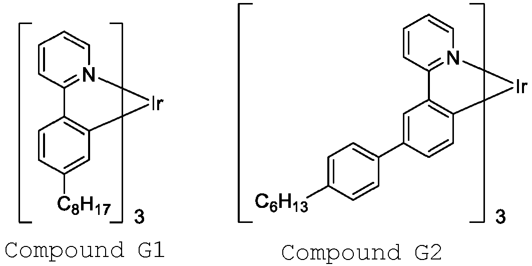

The maximum peak wavelength of the emission spectrum of the compound G1 was 508 nm.

The maximum peak wavelength of the emission spectrum of the compound G2 was 518 nm.

### <Synthesis Examples R1 to R3> Synthesis of compounds R1 to R3

A compound R1 was synthesized based on a method described in International Publication WO 2002/44189.

A compound R2 was synthesized based on a method described in JP-A No. 2006-188673.

A compound R3 was synthesized based on a method described in JP-A No. 2006-188673.

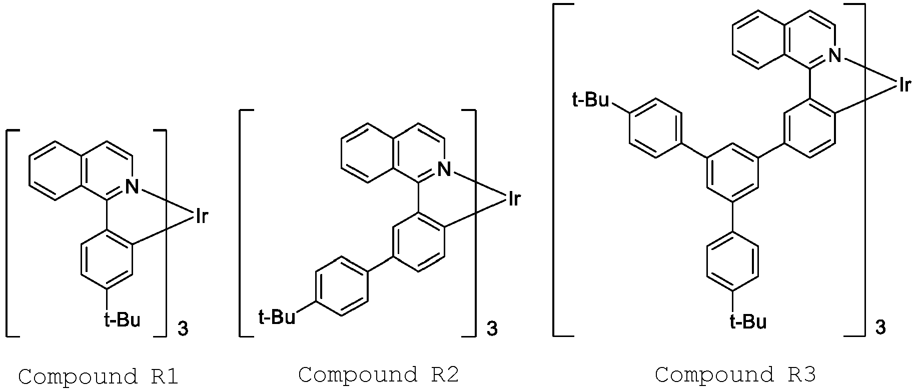

The maximum peak wavelength of the emission spectrum of the compound R1 was 617 nm.

The maximum peak wavelength of the emission spectrum of the compound R2 was 626 nm.

The maximum peak wavelength of the emission spectrum of the compound R3 was 619 nm.

### <Synthesis Examples M1 to M8> Synthesis of compounds M1 to M8

A compound M1 was synthesized according to a method described in JP-A No. 2010-189630.

A compound M2 and a compound M3 were synthesized according to a method described in International Publication WO 2013/191088.

A compound M4 and a compound M5 were synthesized according to a method described in International Publication WO 2013/146806.

A compound M6 was synthesized according to a method described in International Publication WO 2002/045184.

A compound M7 was synthesized according to a method described in International Publication WO 2005/049546.

A compound M8 was synthesized according to a method described in International Publication WO 2011/049241.

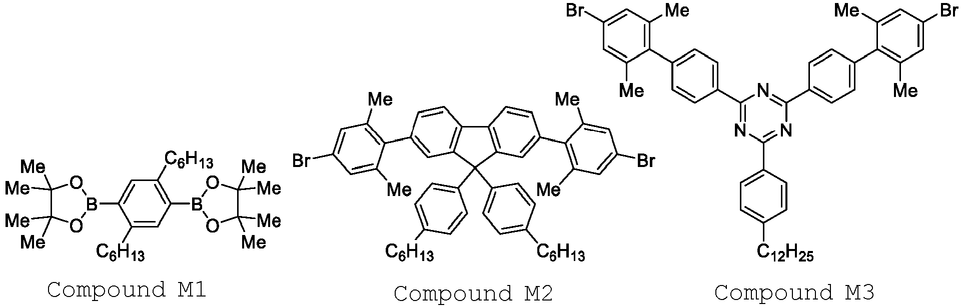

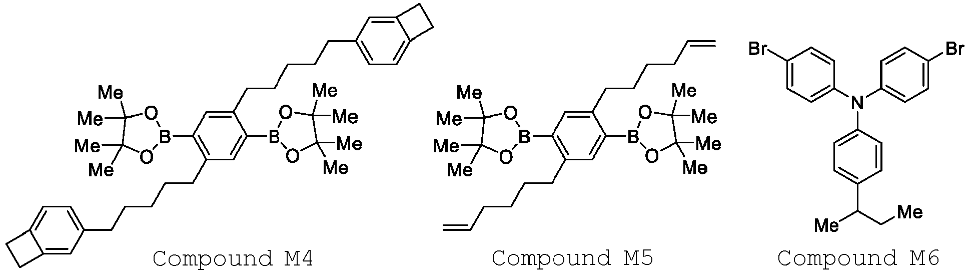

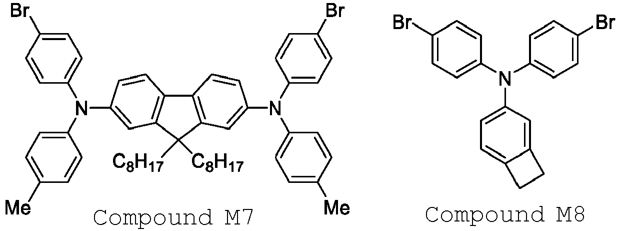

### <Synthesis Example P1> Synthesis of polymer compound HP-1

A polymer compound HP-1 was synthesized according to a method described in International Publication WO 2013/191088, using the compound M1, the compound M2 and the compound M3.

The polymer compound HP-1 had a polystyrene-equivalent number-average molecular weight (Mn) and a polystyrene-equivalent weight-average molecular weight (Mw) of Mn=8.5×10⁴ and Mw=2.2×10⁵, respectively.

The polymer compound HP-1 is copolymer constituted of a constitutional unit derived from the compound M1, a constitutional unit derived from the compound M2 and a constitutional unit derived from the compound M3 at a molar ratio of 50:26:24 according to the theoretical values calculated from the amounts of the charged raw materials.

### <Synthesis Example P2> Synthesis of polymer compound HTL-1

(Step 1) An inert gas atmosphere was prepared in a reaction vessel, then, the compound M4 (1.07g), the compound M5 (0.198 g), the compound M6 (0.919 g), dichlorobis[tris(2-methoxyphenyl)phosphine]palladium (1.8 mg) and toluene (50 mL) were added, and the mixture was heated at 100°C.

(Step 2) Into the resultant reaction liquid was dropped a 20 wt% tetraethylammonium hydroxide aqueous solution (8.7 mL), and the mixture was refluxed for 6 hours.

(Step 3) Thereafter, to this were added 2-ethylphenylboronic acid (60.0 mg), a 20 wt% tetraethylammonium hydroxide aqueous solution (8.7 mL) and dichlorobis[tris(2-methoxyphenyl)phosphine]palladium (1.8 mg), and the mixture was refluxed for 16 hours.

(Step 4) Thereafter, to this was added a sodium diethyldithiacarbamate aqueous solution, and the mixture was stirred at 80°C for 2 hours. The resultant reaction liquid was cooled, then, washed with 3.6 wt% hydrochloric acid twice, with a 2.5 wt% ammonia aqueous solution twice and with water 6 times, and the resultant solution was dropped into methanol, to find generation of a precipitate. The resultant precipitate was dissolved in toluene, and purified by passing the solution through an alumina column and a silica gel column in this order. The resultant solution was dropped into methanol, and the liquid was stirred, to find generation of a precipitate. The resultant precipitate was isolated by filtration and dried, to obtain 1.14 g of a polymer compound HTL-1. The polymer compound HTL-1 had a Mn of 3.6×10⁴ and a Mw of 2.0×10⁵.

The polymer compound HTL-1 is copolymer constituted of a constitutional unit derived from the compound M4, a constitutional unit derived from the compound M5 and a constitutional unit derived from the compound M6 at a molar ratio of 40:10:50 according to the theoretical values calculated from the amounts of the charged raw materials.

### <Synthesis Example P3> Synthesis of polymer compound HTL-2

A nitrogen gas atmosphere was prepared in a reaction vessel, then, the compound M1 (1.73 g), the compound M7 (2.68 g), the compound M8 (0.223 g) and toluene (73 mL) were added, and the mixture was heated at about 80°C. Thereafter, to this were added palladium acetate (0.77 mg), tris(2-methoxyphenyl)phosphine (4.90 mg) and a 20 wt% tetraethylammonium hydroxide aqueous solution (12.3 g), and the mixture was stirred under reflux for about 4 hours. Thereafter, to this were added phenylboronic acid (85.6 mg), palladium acetate (0.72 mg), tris(2-methoxyphenyl)phosphine (4.89 mg) and a 20 wt% tetraethylammonium hydroxide aqueous solution (12.3 g), and the mixture was further stirred under reflux for about 19.5 hours. Thereafter, to this was added a solution prepared by dissolving sodium N,N-diethyldithiocarbamate trihydrate (0.98 g) in ion exchanged water (20 mL), and the mixture was stirred for 2 hours while heating at 85°C. The resultant organic layer was washed with 3.6 wt% hydrochloric acid twice, with a 2.5 wt% ammonia aqueous solution twice and with ion exchanged water 5 times in series. The resultant organic layer was dropped into methanol to cause generation of a precipitate, which was then isolated by filtration and dried, to obtain a solid. The resultant solid was dissolved in toluene, and the solution was allowed to pass through a silica gel column and an alumina column through which toluene had passed previously. The resultant solution was dropped into methanol to cause generation of a precipitate, which was then isolated by filtration and dried, to obtain a polymer compound HTL-2 (2.91 g). The polymer compound HTL-2 had a polystyrene-equivalent number-average molecular weight (Mn) and a polystyrene-equivalent weight-average molecular weight (Mw) of Mn=1.9×10⁴ and Mw=9.9×10⁴, respectively.

The polymer compound HTL-2 is copolymer constituted of a constitutional unit derived from the compound M1, a constitutional unit derived from the compound M7 and a constitutional unit derived from the compound M8 at a molar ratio of 50:42.5:7.5 according to the theoretical values calculated from the charged amounts of the monomers.

### <Synthesis Example P4> Synthesis of polymer compound ET1

### (Synthesis of polymer compound ET1a)

The polymer compound ET1a was synthesized according to a synthesis method described in JP-A No. 2012-33845, using a compound ET1-1 synthesized according to a method described in JP-A No. 2012-33845 and a compound ET1-2 synthesized according to a method described in JP-A No. 2012-33845.

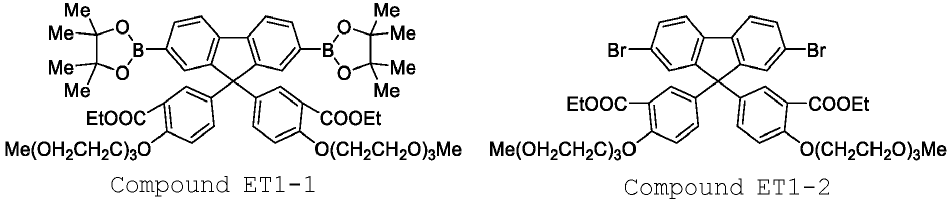

The polymer compound ET1a had a Mn of 5.2×10⁴.

The polymer compound ET1a is copolymer constituted of a constitutional unit derived from the compound ET1-1 and a constitutional unit derived from the compound ET1-2 at a molar ratio of 50:50 according to the theoretical values calculated from the amounts of the charged raw materials.

### (Synthesis of polymer compound ET1)

An inert gas atmosphere was prepared in a reaction vessel, then, the polymer compound ET1a (200 mg), tetrahydrofuran (20 mL) and ethanol (20 mL) were added, and the mixture was heated at 55°C. Thereafter, to this was added cesium hydroxide (200 mg) dissolved in water (2 mL), and the mixture was stirred at 55°C for 6 hours. Thereafter, the mixture was cooled down to room temperature, then, concentrated under reduced pressure, to obtain a solid. The resultant solid was washed with water, then, dried under reduced pressure, to obtain a polymer compound ET1 (150 mg, pale yellow solid). It was confirmed by the NMR spectrum of the resultant polymer compound ET1 that a signal derived from an ethyl group of an ethyl ester portion of the polymer compound ET1a disappeared completely.

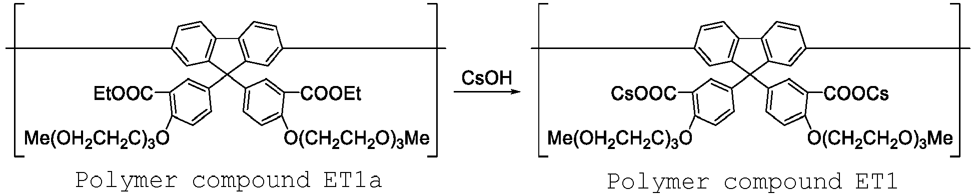

### <Synthesis Example P5> Synthesis of polymer compound ET2

(Step 1) An inert gas atmosphere was prepared in a reaction vessel, then, the compound ET1-2 (9.23 g), the compound M1 (4.58 g), dichlorobis(triso-methoxyphenylphosphine)palladium (8.6 mg), methyltrioctylammonium chloride (manufactured by Sigma Aldrich, trade name: Aliquat336 (registered trademark)) (0.098 g) and toluene (175 mL) were added, and the mixture was heated at 105°C.

(Step 2) Thereafter, into this was dropped a 12 wt% sodium carbonate aqueous solution (40.3 mL), and the liquid was refluxed for 29 hours.

(Step 3) Thereafter, to this were added phenylboronic acid (0.47 g) and dichlorobis(tris-o-methoxyphenylphosphine)palladium (8.7 mg), and the mixture was refluxed for 14 hours.

(Step 4) Thereafter, to this was added a sodium diethyldithiacarbamate aqueous solution, and the mixture was stirred at 80°C for 2 hours. The resultant reaction liquid was cooled, then, dropped into methanol, to find generation of a precipitate. The precipitate was isolated by filtration, and washed with methanol and water, then, dried, to obtain a solid, which was then dissolved in chloroform, and purified by passing the solution through an alumina column and a silica gel column in series through which chloroform had passed previously. The resultant purified liquid was dropped into methanol, and the liquid was stirred, to find generation of a precipitate. The precipitate was isolated by filtration and dried, to obtain a polymer compound ET2a (7.15 g). The polymer compound ET2a had a Mn of 3.2×10⁴ and a Mw of 6.0×10⁴.

The polymer compound ET2a is copolymer constituted of a constitutional unit derived from the compound ET1-2 and a constitutional unit derived from the compound M1 at a molar ratio of 50:50 according to the theoretical values calculated from the amounts of the charged raw materials.

(Step 5) An argon gas atmosphere was prepared in a reaction vessel, then, the polymer compound ET2a (3.1 g), tetrahydrofuran (130 mL), methanol (66 mL), cesium hydroxide monohydrate (2.1 g) and water (12.5 mL) were added, and the mixture was stirred at 60°C for 3 hours.

(Step 6) Thereafter, to this was added methanol (220 mL), and the mixture was stirred for 2 hours. The resultant reaction mixture was concentrated, then, dropped into isopropyl alcohol, and the liquid was stirred, to find generation of a precipitate. The precipitate was isolated by filtration and dried, to obtain a polymer compound ET2 (3.5 g). It was confirmed by ¹H-NMR analysis of the polymer compound ET2 that a signal of an ethyl ester portion in the polymer compound ET2 disappeared and the reaction was completed.

The polymer compound ET2 is copolymer constituted of a constitutional unit represented by the following formula and a constitutional unit derived from the compound M1 at a molar ratio of 50:50 according to the theoretical values calculated from the amounts of the charged raw materials.

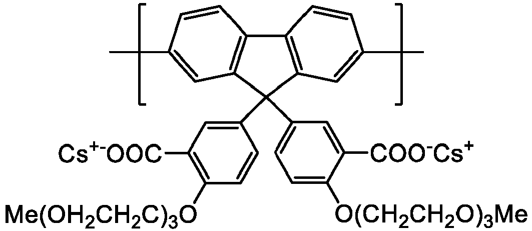

The elemental analysis values of the polymer compound ET2 were C, 54.1 wt%; H, 5.6 wt%; N, <0.3 wt%; Cs, 22.7 wt% (theoretical value: C, 57.29 wt%; H, 5.70 wt%; Cs, 21.49 wt%; O, 15.52 wt%) .

### <Example D1> Fabrication and evaluation of light emitting device D1

### (Fabrication of light emitting device D1)

### (Formation of anode and hole injection layer)

An ITO film was attached with a thickness of 45 nm to a glass substrate by a sputtering method, to form an anode on the substrate. A film of a polythiophene-sulfonic acid-type hole injection agent AQ-1200 (manufactured by Plextronics) was formed with a thickness of 35 nm on the anode by a spin coat method, and heated on a hot plate at 170°C for 15 minutes under an air atmosphere, to form a hole injection layer.

### (Formation of hole transporting layer)

The polymer compound HTL-1 was dissolved at a concentration of 0.7 wt% in xylene. A film was formed with a thickness of 20 nm using the resultant xylene solution on the hole injection layer by a spin coat method, and heated on a hot plate at 180°C for 60 minutes under a nitrogen gas atmosphere, to form a hole transporting layer.

### (Formation of light emitting layer)

The low molecular weight compound HM-1 (manufactured by Luminescense Technology), the compound B2, the compound G2 and the compound R2 (low molecular weight compound HM-1/compound B2/compound G2/compound R2 = 62.05 wt%/37.5 wt%/0.25 wt%/0.2 wt%) were dissolved in toluene at a concentration of 2.2 wt%. A film was formed with a thickness of 75 nm using the resultant toluene solution on the hole transporting layer by a spin coat method, and heated at 150°C for 10 minutes under a nitrogen gas atmosphere, to form a light emitting layer.

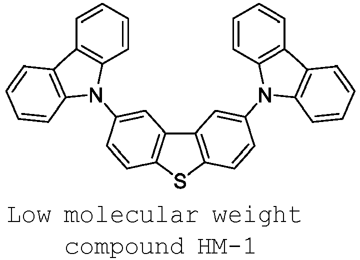

### (Formation of electron transporting layer)

The polymer compound ET1 was dissolved in 2,2,3,3,4,4,5,5-octafluoro-1-pentanol at a concentration of 0.25 wt%. A film was formed with a thickness of 10 nm using the resultant 2,2,3,3,4,4,5,5-octafluoro-1-pentanol solution on the light emitting layer by a spin coat method, and heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure in the vapor deposition machine was reduced to 1.0×10⁻⁴ Pa or lower, then, as a cathode, sodium fluoride was vapor-deposited with a thickness of about 4 nm on the electron transporting layer and aluminum was vapor-deposited with a thickness of about 80 nm on the sodium fluoride layer. After vapor deposition, sealing with a glass substrate was performed, to fabricate a light emitting device D1.

### (Evaluation of light emitting device)

When voltage was applied to the light emitting device D1, EL emission was observed. At 6000 cd/m², the driving voltage was 11.2 [V] and the CIE chromaticity coordinate (x, y) was (0.26, 0.47).

### <Example D2> Fabrication and evaluation of light emitting device D2

A light emitting device D2 was fabricated in the same manner as in Example D1, excepting that the low molecular weight compound HM-1, the compound B3, the compound G2 and the compound R2 (low molecular weight compound HM-1/compound B3/compound G2/compound R2 = 62.05 wt%/37.5 wt%/0.25 wt%/0.2 wt%) were used instead of the low molecular weight compound HM-1, the compound B2, the compound G2 and the compound R2 (low molecular weight compound HM-1/compound B2/compound G2/compound R2 = 62.05 wt%/37.5 wt%/0.25 wt%/0.2 wt%) in Example D1.

When voltage was applied to the light emitting device D2, EL emission was observed. At 6000 cd/m², the driving voltage was 10.4 [V] and the CIE chromaticity coordinate (x, y) was (0.26, 0.48).

### <Comparative Example CD1> Fabrication and evaluation of light emitting device CD1

A light emitting device CD1 was fabricated in the same manner as in Example D1, excepting that the low molecular weight compound HM-1, the compound B2, the compound G1 and the compound R1 (low molecular weight compound HM-1/compound B2/compound G1/compound R1 = 62.05 wt%/37. 5 wt%/0. 25 wt%/0. 2 wt%) were used instead of the low molecular weight compound HM-1, the compound B2, the compound G2 and the compound R2 (low molecular weight compound HM-1/compound B2/compound G2/compound R2 = 62.05 wt%/37.5 wt%/0.25 wt%/0.2 wt%) in Example D1.

When voltage was applied to the light emitting device CD1, EL emission was observed. At 6000 cd/m², the driving voltage was 11.7 [V] and the CIE chromaticity coordinate (x, y) was (0.29, 0.46).

**[Table 18]**

| | light emitting device | light emitting layer | | driving voltage (V) (6000 cd/m²) |
|---|---|---|---|---|
| | | composition | composition ratio (wt%) | |
| Example D1 | D1 | HM-1/B2/G2/R2 | 62.05/37.5/0.25/0.20 | 11.2 |
| Example D2 | D2 | HM-1/B3/G2/R2 | 62.05/37.5/0.25/0.20 | 10.4 |
| Comparative Example CD1 | CD1 | HM-1/B2/G1/R1 | 62.05/37.5/0.25/0.20 | 11.7 |

### <Example D3> Fabrication and evaluation of light emitting device D3

### (Fabrication of light emitting device D3)

### (Formation of anode and hole injection layer)

An ITO film was attached with a thickness of 45 nm to a glass substrate by a sputtering method, to form an anode on the substrate. A film of a polythiophene-sulfonic acid-type hole injection agent AQ-1200 (manufactured by Plextronics) was formed with a thickness of 35 nm on the anode by a spin coat method, and heated on a hot plate at 170°C for 15 minutes under an air atmosphere, to form a hole injection layer.

### (Formation of hole transporting layer)

The polymer compound HTL-2 was dissolved in xylene at a concentration of 0.7 wt%. A film was formed with a thickness of 20 nm using the resultant xylene solution on the hole injection layer by a spin coat method, and heated on a hot plate at 180°C for 60 minutes under a nitrogen gas atmosphere, to form a hole transporting layer.

### (Formation of light emitting layer)

The polymer compound HP-1, the compound B1, the compound G2 and the compound R2 (polymer compound HP-1/compound B1/compound G2/compound R2 = 62.05 wt%/37.5 wt%/0.25 wt%/0.2 wt%) were dissolved in toluene at a concentration of 1.2 wt%. A film was formed with a thickness of 75 nm using the resultant toluene solution on the hole transporting layer by a spin coat method, and heated at 150°C for 10 minutes under a nitrogen gas atmosphere, to form a light emitting layer.

### (Formation of electron transporting layer)

The polymer compound ET1 was dissolved in 2,2,3,3,4,4,5,5-octafluoro-1-pentanol at a concentration of 0.25 wt%. A film was formed with a thickness of 10 nm using the resultant 2,2,3,3,4,4,5,5-octafluoro-1-pentanol solution on the light emitting layer by a spin coat method, and heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure in the vapor deposition machine was reduced to 1.0×10⁻⁴ Pa or lower, then, as a cathode, sodium fluoride was vapor-deposited with a thickness of about 4 nm on the electron transporting layer and aluminum was vapor-deposited with a thickness of about 80 nm on the sodium fluoride layer. After vapor deposition, sealing with a glass substrate was performed, to fabricate a light emitting device D3.

### (Evaluation of light emitting device)

When voltage was applied to the light emitting device D3, EL emission was observed. At 6000 cd/m², the driving voltage was 8.0 [V] and the CIE chromaticity coordinate (x, y) was (0.25, 0.35) .

### <Comparative Example CD2> Fabrication and evaluation of light emitting device CD2

A light emitting device CD2 was fabricated in the same manner as in Example D3, excepting that "The polymer compound HP-1, the compound B6, the compound G1 and the compound R1 (polymer compound HP-1/compound B6/compound G1/compound R1 = 62.05 wt%/37.5 wt%/0.25 wt%/0.2 wt%) were dissolved in toluene at a concentration of 1.3 wt%." instead of the operation "The polymer compound HP-1, the compound B1, the compound G2 and the compound R2 (polymer compound HP-1/compound B1/compound G2/compound R2 = 62.05 wt%/37.5 wt%/0.25 wt%/0.2 wt%) were dissolved in toluene at a concentration of 1.2 wt%." in (Formation of light emitting layer) in Example D3.

When voltage was applied to the light emitting device CD2, EL emission was observed. At 6000 cd/m², the driving voltage was 9.4 [V] and the CIE chromaticity coordinate (x, y) was (0.31, 0.41) .

### <Example D4> Fabrication and evaluation of light emitting device D4

A light emitting device D4 was fabricated in the same manner as in Example D3, excepting that the polymer compound HP-1, the compound B1 and the compound R2 (polymer compound HP-1/compound B1/compound R2 = 59.6 wt%/40.0 wt%/0.4 wt%) were used instead of the polymer compound HP-1, the compound B1, the compound G2 and the compound R2 (polymer compound HP-1/compound B1/compound G2/compound R2 = 62.05 wt%/37.5 wt%/0.25 wt%/0.2 wt%) in Example D3.

When voltage was applied to the light emitting device D4, EL emission was observed. At 6000 cd/m², the driving voltage was 7.8 [V] and the CIE chromaticity coordinate (x, y) was (0.26, 0.31) .

### <Comparative Example CD3> Fabrication and evaluation of light emitting device CD3

A light emitting device CD3 was fabricated in the same manner as in Comparative Example CD2, excepting that "The polymer compound HP-1, the compound B6 and the compound R1 (polymer compound HP-1/compound B6/compound R1 = 59.6 wt%/40.0 wt%/0.4 wt%)" were used instead of "The polymer compound HP-1, the compound B6, the compound G1 and the compound R1 (polymer compound HP-1/compound B6/compound G1/compound R1 = 62.05 wt%/37.5 wt%/0.25 wt%/0.2 wt%)" in Comparative Example CD2.

When voltage was applied to the light emitting device CD3, EL emission was observed. At 6000 cd/m², the driving voltage was 11.7 [V] and the CIE chromaticity coordinate (x, y) was (0.50, 0.32).

### <Comparative Example CD4> Fabrication and evaluation of light emitting device CD4

A light emitting device CD4 was fabricated in the same manner as in Example D3, excepting that "The polymer compound HP-1, the compound B5 and the compound R3 (polymer compound HP-1/compound B5/compound R3 = 59.6 wt%/40.0 wt%/0.4 wt%)" were used instead of "The polymer compound HP-1, the compound B1, the compound G2 and the compound R2 (polymer compound HP-1/compound B1/compound G2/compound R2 = 62.05 wt%/37.5 wt%/0.25 wt%/0.2 wt%)" in Example D3.

When voltage was applied to the light emitting device CD4, EL emission was observed. At 6000 cd/m², the driving voltage was 10.1 [V] and the CIE chromaticity coordinate (x, y) was (0.27, 0.31).

**[Table 19]**

| | light emitting device | light emitting layer | | driving voltage (V) (6000 cd/m²) |
|---|---|---|---|---|
| | | composition | composition ratio (wt%) | |
| Example D3 | D3 | HP-1/B1/G2/R2 | 62.05/37.5/0.25/0.20 | 8.0 |
| Comparative Example CD2 | CD2 | HP-1/B6/G1/R1 | 62.05/37.5/0.25/0.20 | 9.4 |
| Example D4 | D4 | HP-1/B1/R2 | 59.6/40.0/0.4 | 7.8 |
| Comparative Example CD3 | CD3 | HP-1/B6/R1 | 59.6/40.0/0.4 | 11.7 |
| Comparative Example CD4 | CD4 | HP-1/B5/R3 | 59.6/40.0/0.4 | 10.1 |

### <Example D5> Fabrication and evaluation of light emitting device D5

### (Fabrication of light emitting device D5)

### (Formation of anode and hole injection layer)

An ITO film was attached with a thickness of 45 nm to a glass substrate by a sputtering method, to form an anode on the substrate. A film of a hole injection material ND-3202 (manufactured by Nissan Chemical Industries, Ltd.) was formed with a thickness of 35 nm on the anode by a spin coat method. Under an air atmosphere, the film was heated on a hot plate at 50°C for 3 minutes and further heated at 230°C for 15 minutes, to form a hole injection layer.

### (Formation of hole transporting layer)

The polymer compound HTL-2 was dissolved in xylene at a concentration of 0.7 wt%. A film was formed with a thickness of 20 nm using the resultant xylene solution on the hole injection layer by a spin coat method, and heated on a hot plate at 180°C for 60 minutes under a nitrogen gas atmosphere, to form a hole transporting layer.

### (Formation of light emitting layer)

The polymer compound HP-1, the compound B4, the compound G1 and the compound R2 (polymer compound HP-1/compound B4/compound G1/compound R2 = 62.05 wt%/37.5 wt%/0.25 wt%/0.2 wt%) were dissolved in toluene at a concentration of 1.2 wt%. A film was formed with a thickness of 75 nm using the resultant toluene solution on the hole transporting layer by a spin coat method, and heated at 150°C for 10 minutes under a nitrogen gas atmosphere, to form a light emitting layer.

### (Formation of electron transporting layer)

The polymer compound ET1 was dissolved in 2,2,3,3,4,4,5,5-octafluoro-1-pentanol at a concentration of 0.25 wt%. A film was formed with a thickness of 10 nm using the resultant 2,2,3,3,4,4,5,5-octafluoro-1-pentanol solution on the light emitting layer by a spin coat method, and heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure in the vapor deposition machine was reduced to 1.0×10⁻⁴ Pa or lower, then, as a cathode, sodium fluoride was vapor-deposited with a thickness of about 4 nm on the electron transporting layer and aluminum was vapor-deposited with a thickness of about 80 nm on the sodium fluoride layer. After vapor deposition, sealing with a glass substrate was performed, to fabricate a light emitting device D5.

### (Evaluation of light emitting device)

When voltage was applied to the light emitting device D5, EL emission was observed. At 6000 cd/m², the driving voltage was 8.0 [V] and the CIE chromaticity coordinate (x, y) was (0.24, 0.35) .

### <Example D6> Fabrication and evaluation of light emitting device D6

A light emitting device D6 was fabricated in the same manner as in Example D5 excepting that "The polymer compound HP-1, the compound B1, the compound G2 and the compound R1 (polymer compound HP-1/compound B1/compound G2/compound R1 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device D6, EL emission was observed. At 6000 cd/m², the driving voltage was 8.1 [V] and the CIE chromaticity coordinate (x, y) was (0.26, 0.47) .

### <Example D7> Fabrication and evaluation of light emitting device D7

A light emitting device D7 was fabricated in the same manner as in Example D5 excepting that "The polymer compound HP-1, the compound B4, the compound G2 and the compound R1 (polymer compound HP-1/compound B4/compound G2/compound R1 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device D7, EL emission was observed. At 6000 cd/m², the driving voltage was 7.1 [V] and the CIE chromaticity coordinate (x, y) was (0.28, 0.48) .

### <Example D8> Fabrication and evaluation of light emitting device D8

A light emitting device D8 was fabricated in the same manner as in Example D5, excepting that "The polymer compound HP-1, the compound B1, the compound G2 and the compound R2 (polymer compound HP-1/compound B1/compound G2/compound R2 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device D8, EL emission was observed. At 6000 cd/m², the driving voltage was 7.7 [V] and the CIE chromaticity coordinate (x, y) was (0.26, 0.44) .

### <Example D9> Fabrication and evaluation of light emitting device D9

A light emitting device D9 was fabricated in the same manner as in Example D5, excepting that "The polymer compound HP-1, the compound B4, the compound G2 and the compound R2 (polymer compound HP-1/compound B4/compound G2/compound R2 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device D9, EL emission was observed. At 6000 cd/m², the driving voltage was 7.4 [V] and the CIE chromaticity coordinate (x, y) was (0.28, 0.45) .

### <Comparative Example CD5> Fabrication and evaluation of light emitting device CD5

A light emitting device CD5 was fabricated in the same manner as in Example D5, excepting that "The polymer compound HP-1, the compound B5, the compound G2 and the compound R2 (polymer compound HP-1/compound B5/compound G2/compound R2 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device CD5, EL emission was observed. At 6000 cd/m², the driving voltage was 9.1 [V] and the CIE chromaticity coordinate (x, y) was (0.29, 0.47) .

### <Comparative Example CD6> Fabrication and evaluation of light emitting device CD6

A light emitting device CD6 was fabricated in the same manner as in Example D5, excepting that "The polymer compound HP-1, the compound B6, the compound G2 and the compound R2 (polymer compound HP-1/compound B6/compound G2/compound R2 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device CD6, EL emission was observed. At 6000 cd/m², the driving voltage was 10.1 [V] and the CIE chromaticity coordinate (x, y) was (0.35, 0.52).

### <Comparative Example CD7> Fabrication and evaluation of light emitting device CD7

A light emitting device CD7 was fabricated in the same manner as in Example D5, excepting that "The polymer compound HP-1, the compound B6, the compound G1 and the compound R1 (polymer compound HP-1/compound B6/compound G1/compound R1 = 62.05 wt%/37.5 wt%/0.25 wt%/0.2 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device CD7, EL emission was observed. At 6000 cd/m², the driving voltage was 10.8 [V] and the CIE chromaticity coordinate (x, y) was (0.33, 0.42).

**[Table 20]**

| | light emitting device | light emitting layer | | driving voltage (V) (6000 cd/m² ) |
|---|---|---|---|---|
| | | composition | composition ratio (wt%) | |
| Example D5 | D5 | HP-1/B4/G1/R2 | 62.05/37.5/0.25/0.20 | 8.0 |
| Example D6 | D6 | HP-1/B1/G2/R1 | 62.05/37.5/0.25/0.20 | 8.1 |
| Example D7 | D7 | HP-1/B4/G2/R1 | 62.05/37.5/0.25/0.20 | 7.1 |
| Example D8 | D8 | HP-1/B1/G2/R2 | 62.05/37.5/0.25/0.20 | 7.7 |
| Example D9 | D9 | HP-1/B4/G2/R2 | 62.05/37.5/0.25/0.20 | 7.4 |
| Comparative Example CD5 | CD5 | HP-1/B5/G2/R2 | 62.05/37.5/0.25/0.20 | 9.1 |
| Comparative Example CD6 | CD6 | HP-1/B6/G2/R2 | 62.05/37.5/0.25/0.20 | 10.1 |
| Comparative Example CD7 | CD7 | HP-1/B6/G1/R1 | 62.05/37.5/0.25/0.20 | 10.8 |

### <Example D10> Fabrication and evaluation of light emitting device D10

A light emitting device D10 was fabricated in the same manner as in Example D5, excepting that "The polymer compound HP-1, the compound B1 and the compound R2 (polymer compound HP-1/compound B1/compound R2 = 59.6 wt%/40.0 wt%/0.4 wt%)" were used instead of "The polymer compound HP-1, the compound B4, the compound G1 and the compound R2 (polymer compound HP-1/compound B4/compound Gl/compound R2 = 62.05 wt%/37.5 wt%/0.25 wt%/0.2 wt%)" in Example D5.

When voltage was applied to the light emitting device D10, EL emission was observed. At 1000 cd/m², the driving voltage was 6.3 [V] and the CIE chromaticity coordinate (x, y) was (0.31, 0.32) .

### <Example D11> Fabrication and evaluation of light emitting device D11

A light emitting device D11 was fabricated in the same manner as in Example D5, excepting that "The polymer compound HP-1, the compound B4 and the compound R2 (polymer compound HP-1/compound B4/compound R2 = 59.6 wt%/40.0 wt%/0.4 wt%)" were used instead of "The polymer compound HP-1, the compound B4, the compound G1 and the compound R2 (polymer compound HP-1/compound B4/compound Gl/compound R2 = 62.05 wt%/37.5 wt%/0.25 wt%/0.2 wt%)" in Example D5.

When voltage was applied to the light emitting device D11, EL emission was observed. At 1000 cd/m², the driving voltage was 6.1 [V] and the CIE chromaticity coordinate (x, y) was (0.34, 0.29) .

### <Comparative Example CD8> Fabrication and evaluation of light emitting device CD8

A light emitting device CD8 was fabricated in the same manner as in Example D5, excepting that "The polymer compound HP-1, the compound B6 and the compound R1 (polymer compound HP-1/compound B6/compound R1 = 59.6 wt%/40.0 wt%/0.4 wt%)" were used instead of "The polymer compound HP-1, the compound B4, the compound G1 and the compound R2 (polymer compound HP-1/compound B4/compound G1/compound R2 = 62.05 wt%/37.5 wt%/0.25 wt%/0.2 wt%)" in Example D5.

When voltage was applied to the light emitting device CD8, EL emission was observed. At 1000 cd/m², the driving voltage was 8.7 [V] and the CIE chromaticity coordinate (x, y) was (0.48, 0.31) .

**[Table 21]**

| | light emitting device | light emitting layer | | driving voltage (V) (1000 cd/m²) |
|---|---|---|---|---|
| | | composition | composition ratio (wt%) | |
| Example D10 | D10 | HP-1/B1/R2 | 59.6/40/0.4 | 6.3 |
| Example D11 | D11 | HP-1/B4/R2 | 59.6/40/0.4 | 6.1 |
| Comparative Example CD8 | CD8 | HP-1/B6/R1 | 59.6/40/0.4 | 8.7 |

### <Example D12> Fabrication and evaluation of light emitting device D12

### (Fabrication of light emitting device D12)

### (Formation of anode and hole injection layer)

An ITO film was attached with a thickness of 45 nm to a glass substrate by a sputtering method, to form an anode on the substrate. A film of a hole injection material ND-3202 (manufactured by Nissan Chemical Industries, Ltd.) was formed with a thickness of 35 nm on the anode by a spin coat method. Under an air atmosphere, the film was heated on a hot plate at 50°C for 3 minutes and further heated at 230°C for 15 minutes, to form a hole injection layer.

### (Formation of hole transporting layer)

The low molecular weight compound HTL-M1 (manufactured by Luminescense Technology) was dissolved in chlorobenzene at a concentration of 0.7 wt%. A film was formed with a thickness of 20 nm using the resultant chlorobenzene solution on the hole injection layer by a spin coat method, and heated on a hot plate at 180°C for 60 minutes under a nitrogen gas atmosphere, to form a hole transporting layer.

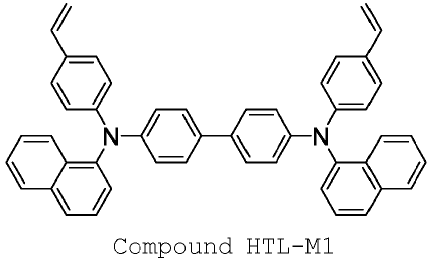

### (Formation of light emitting layer)

The low molecular weight compound HM-1 (manufactured by Luminescense Technology), the compound B3, the compound G2 and the compound R2 (low molecular weight compound HM-1/compound B3/compound G2/compound R2 = 62.05 wt%/37.5 wt%/0.25 wt%/0.2 wt%) were dissolved in toluene at a concentration of 1.2 wt%. A film was formed with a thickness of 75 nm using the resultant toluene solution on the hole transporting layer by a spin coat method, and heated at 150°C for 10 minutes under a nitrogen gas atmosphere, to form a light emitting layer.

### (Formation of electron transporting layer)

The polymer compound ET2 was dissolved in 2,2,3,3,4,4,5,5-octafluoro-1-pentanol at a concentration of 0.25 wt%. A film was formed with a thickness of 10 nm using the resultant 2,2,3,3,4,4,5,5-octafluoro-1-pentanol solution on the light emitting layer by a spin coat method, and heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure in the vapor deposition machine was reduced to 1.0×10⁻⁴ Pa or lower, then, as a cathode, sodium fluoride was vapor-deposited with a thickness of about 4 nm on the electron transporting layer and aluminum was vapor-deposited with a thickness of about 80 nm on the sodium fluoride layer. After vapor deposition, sealing with a glass substrate was performed, to fabricate a light emitting device D12.

### (Evaluation of light emitting device)

When voltage was applied to the light emitting device D12, EL emission was observed. At 1000 cd/m², the driving voltage was 6.3 [V] and the CIE chromaticity coordinate (x, y) was (0.34, 0.45) . At 10000 cd/m², the driving voltage was 9.0 [V] and the CIE chromaticity coordinate (x, y) was (0.32, 0.46).

### <Example D13> Fabrication and evaluation of light emitting device D13

A light emitting device D13 was fabricated in the same manner as in Example D12, excepting that "The low molecular weight compound HM-1, the compound B7, the compound G2 and the compound R2 (low molecular weight compound HM-1/compound B7/compound G2/compound R2 = 62.05 wt%/37.5 wt%/0.25 wt%/0.2 wt%) " were used instead of "The low molecular weight compound HM-1, the compound B3, the compound G2 and the compound R2 (low molecular weight compound HM-1/compound B3/compound G2/compound R2 = 62.05 wt%/37.5 wt%/0.25 wt%/0.2 wt%)" in Example D12.

### (Evaluation of light emitting device)

When voltage was applied to the light emitting device D13, EL emission was observed. At 1000 cd/m², the driving voltage was 7.4 [V] and the CIE chromaticity coordinate (x, y) was (0.43, 0.48). At 10000 cd/m², the driving voltage was 11.4 [V] and the CIE chromaticity coordinate (x, y) was (0.38, 0.50).

**[Table 22]**

| | light emitting device | light emitting layer | | driving voltage (V) (1000 cd/m² ) |
|---|---|---|---|---|
| | | composition | composition ratio (wt%) | |
| Example D12 | D12 | HM-1/B3/G2/R2 | 62.05/37.5/0.25/0.20 | 6.3 |
| Example D13 | D13 | HM-1/B7/G2/R2 | 62.05/37.5/0.25/0.20 | 7.4 |

### Industrial Applicability

According to the present invention, a composition which is useful for producing a light emitting device the driving voltage of which is low can be provided. Further, according to the present invention, a light emitting device comprising the composition can be provided.

## Claims

1. A composition comprising
a phosphorescent compound represented by the formula (1-A1) or (1-A3) and
a phosphorescent compound represented by the formula (2-B1) or (2-B2),
wherein the maximum peak wavelength of the emission spectrum of the phosphorescent compound represented by the formula (1-A1) or (1-A3) is 380 nm or more and less than 495 nm, and
the maximum peak wavelength of the emission spectrum of the phosphorescent compound represented by the formula (2-B1) or (2-B2) is 495 nm or more and less than 750 nm: 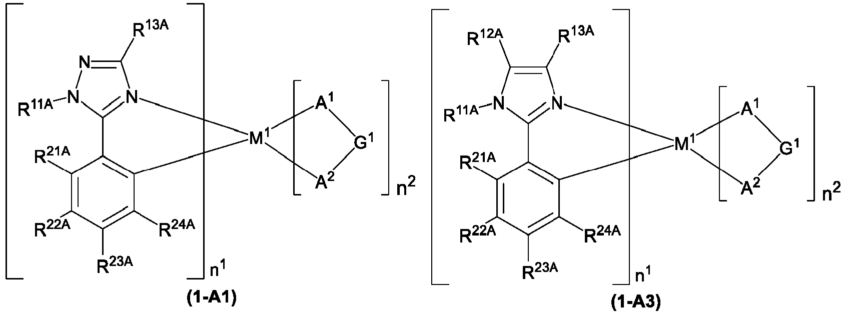 wherein
M¹ represents an iridium atom,
n¹ represents an integer of 1 or more, n² represents an integer of 0 or more, and n¹+n² is 3,
R^{11A}, R^{12A}, R^{13A}, R^{21A}, R^{22A}, R^{23A} and R^{24A} each independently represent a substituent that is constituted of atoms selected from the group consisting of a hydrogen atom, a carbon atom, a nitrogen atom, an oxygen atom and a sulfur atom, and more specifically wherein R^{11A} , R^{12A}, R^{13A}, R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent heterocyclic group or a substituted amino group and these groups each optionally have a substituent, and when a plurality of R^{11A}, R^{12A}, R^{13A}, R^{21A}, R^{22A}, R^{23A} and R^{24A} are present, they may be the same or different at each occurrence, and R^{21A} and R^{22A}, R^{22A} and R^{23A}, and R^{23A} and R^{24A} each may be combined together to form a ring together with the atoms to which they are attached, and at least one selected from the group consisting of R^{11A}, R^{12A}, R^{13A}, R^{21A}, R^{22A}, R^{23A} and R^{24A} is a group represented by the formula (1-S1),
the ligand constituted of the triazole or imidazole ring and the benzene ring is a ligand constituted of atoms selected from the group consisting of a hydrogen atom, a carbon atom, a nitrogen atom, an oxygen atom and a sulfur atom, and
A¹-G¹-A² represents an anionic bidentate ligand, A¹ and A² each independently represent a carbon atom, an oxygen atom or a nitrogen atom and thses atoms may be an atom constituting a ring, G¹ represents a single bond or an atomic group constituting the bidentate ligand together with A¹ and A², and when a plurality of A¹-G¹-A² are present, they may be the same or different: 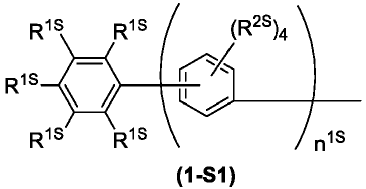 wherein
n^{1S} represents an integer of 0 to 2, and
R^{1S} and R^{2S} each independently represent a hydrogen atom, an alkyl group, a cycloalkyl group, an alkoxy group or a cycloalkoxy group and these groups each optionally have a substituent, and the plurality of R^{1S} may be the same or different, and the plurality of R^{2S} may be the same or different: 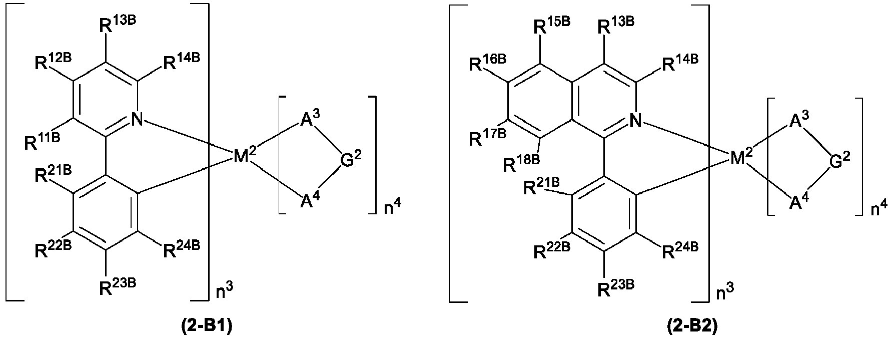 wherein
M² represents an iridium atom,
n³ represents an integer of 1 or more, n⁴ represents an integer of 0 or more, and n³+n⁴ is 3,
R^{11B}, R^{12B}, R^{13B}, R^{14B}, R^{21B}, R^{22B}, R^{23B} and R^{24B} each independently represent a hydrogen atom, an alkyl group, a cycloalkyl group, an alkoxy group, a cycloalkoxy group, an aryl group, an aryloxy group or a monovalent heterocyclic group and these groups each optionally have a substituent, and when a plurality of R^{11B}, R^{12B}, R^{13B}, R^{14B}, R^{21B}, R^{22B}, R^{23B} and R^{24B} are present, they may be the same or different at each occurrence, and R^{11B} and R^{12B}, R^{12B} and R^{13B}, R^{13B} and R^{14B}, R^{11B} and R^{21B}, R^{21B} and R^{22B}, R^{22B} and R^{23B}, and R^{23B} and R^{24B} each may be combined together to form a ring together with the atoms to which they are attached,
R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group or a monovalent heterocyclic group and these groups each optionally have a substituent, and when a plurality of R^{15B}, R^{16B}, R^{17B} and R^{18B} are present, they may be the same or different at each occurrence, and R^{15B} and R^{16B}, R^{16B} and R^{17B}, and R^{17B} and R^{18B} each may be combined together to form a ring together with the atoms to which they are attached, and
at least one selected from the group consisting of R^{11B}, R^{12B}, R^{13B}, R^{14B}, R^{22B}, R^{22B}, R^{23B} and R^{24B} is a group represented by the formula (1-T1),
the ligand constituted of the pyridine, quinoline or isoquinoline ring and the benzene ring is a ligand constituted of atoms selected from the group consisting of a hydrogen atom, a carbon atom, a nitrogen atom, an oxygen atom and a sulfur atom, and
A³-G²-A⁴ represents an anionic bidentate ligand, A³ and A⁴ each independently represent a carbon atom, an oxygen atom or a nitrogen atom and these atoms may be an atom constituting a ring, G² represents a single bond or an atomic group constituting the bidentate ligand together with A³ and A⁴, and when a plurality of A³-G²-A⁴ are present, they may be the same or different: 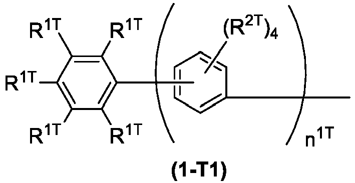 wherein
n^{1T} represents an integer of 0 to 2, and
R^{1T} and R^{2T} each independently represent a hydrogen atom, an alkyl group, a cycloalkyl group, an alkoxy group or a cycloalkoxy group and these groups each optionally have a substituent, and the plurality of R^{1T} may be the same or different, and the plurality of R^{2T} may be the same or different.

2. The composition according to claim 1, wherein n¹ is 3.

3. The composition according to claim 1 or 2, wherein the group represented by the formula (1-S1)is a group represented by the formula (1-S1-1), a group represented by the formula (1-S1-2), a group represented by the formula (1-S1-3) or a group represented by the formula (1-S1-4): 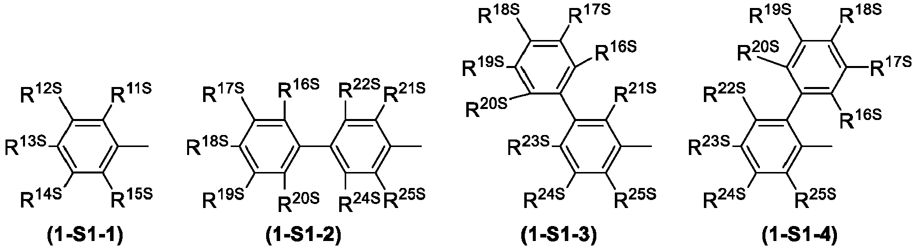 wherein
R^{11S}, R^{12S}, R^{13S}, R^{14S}, R^{15S}, R^{16S}, R^{17S}, R^{18S}, R^{19S}, R^{20S}, R^{21S}, R^{22S}, R^{23S}, R^{24S} and R^{25S} each independently represent a hydrogen atom, an alkyl group, a cycloalkyl group, an alkoxy group or a cycloalkoxy group and the these groups each optionally have a substituent.

4. The composition according to any one of claims 1 to 3, wherein the group represented by the formula (1-T1) is a group represented by the formula (1-T1-1), a group represented by the formula (1-T1-2), a group represented by the formula (1-T1-3) or a group represented by the formula (1-T1-4): 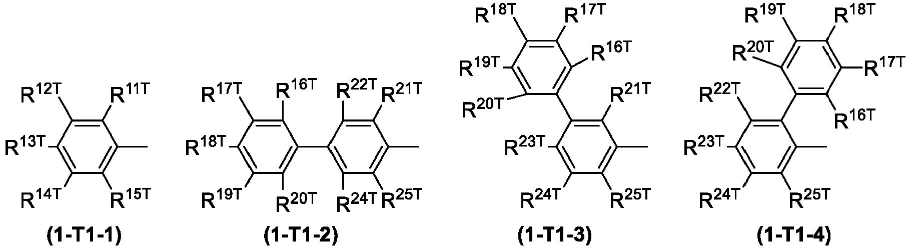 wherein
R^{11T}, R^{12T}, R^{13T}, R^{14T}, R^{15T}, R^{16T}, R^{17T}, R^{18T}, R^{19T}, R^{20T}, R^{21T}, R^{22T}, R^{23T}, R^{24T} and R^{25T} each independently represent a hydrogen atom, an alkyl group, a cycloalkyl group, an alkoxy group or a cycloalkoxy group and these groups each optionally have a substituent.

5. The composition according to any one of claims 1 to 4, further comprising a compound represented by the formula (H-1) : 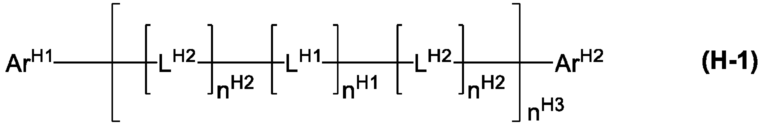 wherein
Ar^{H1} and Ar^{H2} each independently represent an aryl group or a monovalent heterocyclic group and these groups each optionally have a substituent,
n^{H1} and n^{H2} each independently represent 0 or 1, and when a plurality of n^{H1} are present, they may be the same or different, and the plurality of n^{H2} may be the same or different,
n^{H3} represents an integer of 0 or more,
L^{H1} represents an arylene group, a divalent heterocyclic group or a group represented by -[C(R^{H11})₂]n^{H11}- and these groups each optionally have a substituent, and when a plurality of L^{H1} are present, they may be the same or different,
n^{H11} represents an integer of 1 to 10, and R^{H11} represents a hydrogen atom, an alkyl group, a cycloalkyl group, an alkoxy group, a cycloalkoxy group, an aryl group or a monovalent heterocyclic group and these groups each optionally have a substituent, and the plurality of R^{H11} may be the same or different and may be combined together to form a ring together with the carbon atoms to which they are attached,
L^{H2} represents a group represented by -N(-L^{H21}-R^{H21})-, and when a plurality of L^{H2} are present, they may be the same or different, and
L^{H21} represents a single bond, an arylene group or a divalent heterocyclic group and these groups each optionally have a substituent, and R^{H21} represents a hydrogen atom, an alkyl group, a cycloalkyl group, an aryl group or a monovalent heterocyclic group and these groups each optionally have a substituent.

6. The composition according to any one of claims 1 to 4, further comprising a polymer compound comprising a constitutional unit represented by the formula (Y):
-[Ar^{Y1}]- (Y)
wherein Ar^{Y1} represents an arylene group, a divalent heterocyclic group or a divalent group in which at least one arylene group and at least one divalent heterocyclic group are bonded directly to each other, and these groups each optionally have a substituent.

7. The composition according to any one of claims 1 to 6, further comprising at least one material selected from the group consisting of a hole transporting material, a hole injection material, an electron transporting material, an electron injection material, a light emitting material, an antioxidant and a solvent.

8. A light emitting device comprising the composition according to any one of claims 1 to 6.

## Patentansprüche

1. Zusammensetzung, umfassend:
eine phosphoreszierende Verbindung, die durch die Formel (1-A1) oder (1-A3) dargestellt wird, und
eine phosphoreszierende Verbindung, die durch die Formel (2-B1) oder (2-B2) dargestellt wird,
wobei die maximale Spitzenwellenlänge des Emissionsspektrums der phosphoreszierenden Verbindung, die durch die Formel (1-A1) oder (1-A3) dargestellt wird, 380 nm oder mehr und weniger als 495 nm beträgt und
die maximale Spitzenwellenlänge des Emissionsspektrums der phosphoreszierenden Verbindung, die durch die Formel (2-B1) oder (2-B2) dargestellt wird, 495 nm oder mehr und weniger als 750 nm beträgt: 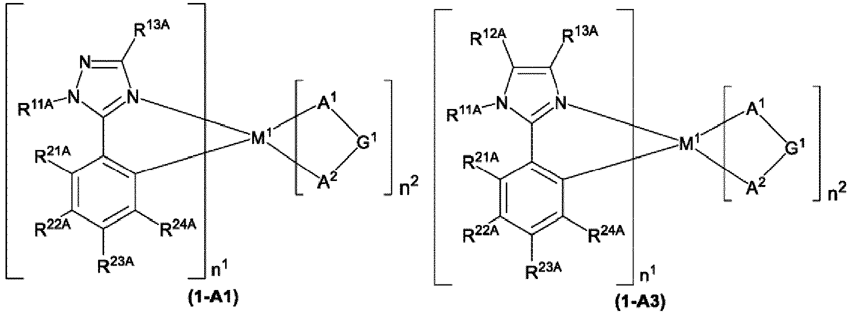 wobei
M¹ ein Iridiumatom darstellt,
n¹ eine ganze Zahl von 1 oder mehr darstellt, n² eine ganze Zahl von 0 oder mehr darstellt und n¹+n² 3 beträgt,
R^{11A}, R^{12A}, R^{13A}, R^{21A,} R^{22A}, R^{23A} und R^{24A} jeweils unabhängig einen Substituenten darstellen, der aus Atomen gebildet ist, die aus der Gruppe ausgewählt sind, bestehend aus einem Wasserstoffatom, einem Kohlenstoffatom, einem Stickstoffatom, einem Sauerstoffatom und einem Schwefelatom, und genauer wobei R^{11A}, R^{12A}, R^{13A}, R^{21A}, R^{22A}, R^{23A} und R^{24A} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine monovalente heterocyclische Gruppe oder eine substituierte Aminogruppe darstellen und diese Gruppen jeweils optional einen Substituenten aufweisen, und wenn eine Mehrzahl von R^{11A}, R^{12A}, R^{13A}, R^{21A}, R^{22A}, R^{23A} und R^{24A} vorliegt, sie bei jedem Auftreten dieselbe oder unterschiedlich sein können, und R^{21A} und R^{22A}, R^{22A} und R^{23A} und R^{23A} und R^{24A} jeweils zusammen kombiniert werden können, um einen Ring zusammen mit den Atomen auszubilden, an die sie angelagert sind, und wenigstens eine, ausgewählt aus der Gruppe, bestehend aus R^{11A}, R^{12A}, R^{13A}, R^{21A}, R^{22A}, R^{23A} und R^{24A}, eine Gruppe ist, die durch die Formel (1-S1)dargestellt wird,
der Ligand, der aus dem Triazol- oder Imidazolring und dem Benzolring gebildet ist, ein Ligand ist, der aus Atomen gebildet ist, die aus der Gruppe ausgewählt sind, bestehend aus einem Wasserstoffatom, einem Kohlenstoffatom, einem Stickstoffatom, einem Sauerstoffatom und einem Schwefelatom, und
A¹-G¹-A² einen anionischen zweizähnigen Liganden darstellt, A¹ und A² jeweils unabhängig ein Kohlenstoffatom, ein Sauerstoffatom oder ein Stickstoffatom darstellen und diese Atome ein Atom sein können, das einen Ring bildet, G¹ eine Einzelbindung oder eine atomische Gruppe darstellt, die den zweizähnigen Liganden zusammen mit A¹ und A² bildet, und
wenn eine Mehrzahl von A¹-G¹-A² vorliegt, sie dieselben oder unterschiedlich sein können: 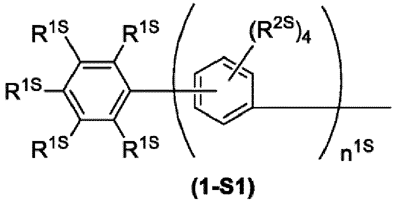 wobei
n^{1s} eine ganze Zahl von 0 bis 2 darstellt und
R^{1S} und R^{2S} jeweils unabhängig ein Wasserstoffatom, eine Alkylgruppe, eine Cycloalkylgruppe, eine Alkoxygruppe oder eine Cycloalkoxygruppe darstellen und diese Gruppen jeweils optional einen Substituenten aufweisen und die Mehrzahl von R^{1S} dieselbe oder unterschiedlich sein kann und die Mehrzahl von R^{2S} dieselbe oder unterschiedlich sein kann: 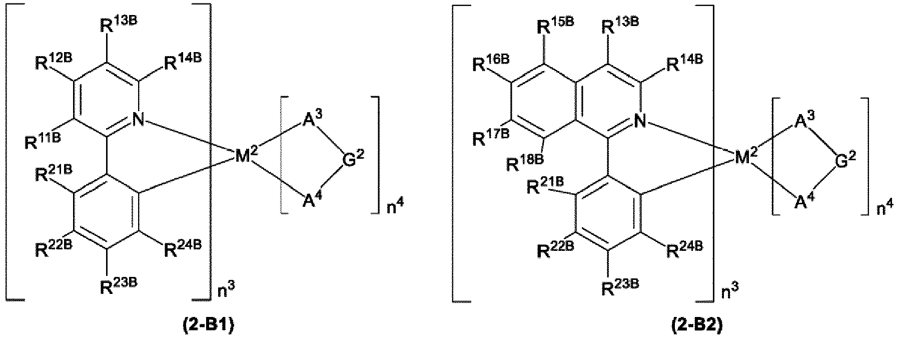 wobei
M² ein Iridiumatom darstellt,
n³ eine ganze Zahl von 1 oder mehr darstellt, n⁴ eine ganze Zahl von 0 oder mehr darstellt und n³+n⁴ 3 beträgt,
R^{11B}, R^{12B}, R^{13B}, R^{14B}, R^{21B}, R^{22B}, R^{23B} und R^{24B} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe oder eine monovalente heterocyclische Gruppe darstellen und diese Gruppen jeweils optional einen Substituenten aufweisen, und wenn eine Mehrzahl von R^{11B}, R^{12B}, R^{13B}, R^{14B}, R^{21B}, R^{22B}, R^{23B} und R^{24B} vorliegt, sie bei jedem Auftreten dieselben oder unterschiedlich sein können, und R^{11B} und R^{12B}, R^{12B} und R^{13B}, R^{13B} und R^{14B}, R^{11B} und R^{21B}, R^{21B} und R^{22B}, R^{22B} und R^{23B} und R^{23A} und R^{24A} jeweils zusammen kombiniert werden können, um einen Ring zusammen mit den Atomen auszubilden, an die sie angelagert sind,
R^{15B}, R^{16B}, R^{17B} und R^{18B} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe oder eine monovalente heterocyclische Gruppe darstellen und diese Gruppen jeweils optional einen Substituenten aufweisen, und wenn eine Mehrzahl von R^{15B}, R^{16B}, R^{17B} und R^{18B} vorliegt, sie bei jedem Auftreten dieselben oder unterschiedlich sein können, und R^{15B} und R^{16B}, R^{16B} und R^{17B} und R^{17B} und R^{18B} jeweils zusammen kombiniert werden können, um einen Ring zusammen mit den Atomen auszubilden, an die angelagert sind, und
wenigstens eine, die aus der Gruppe ausgewählt ist, bestehend aus R^{11B}, R^{12B}, R^{13B}, R^{14B}, R^{21B}, R^{22B}, R^{23B} und R^{24B}, eine Gruppe ist, die durch die Formel (1-T1) dargestellt wird,
der Ligand, der aus dem Pyridin-, Chinolin- oder Isochinolinring und dem Benzolring gebildet ist, ein Ligand ist, der aus Atomen gebildet ist, die aus der Gruppe ausgewählt sind, bestehend aus einem Wasserstoffatom, einem Kohlenstoffatom, einem Stickstoffatom, einem Sauerstoffatom und einem Schwefelatom, und
A³-G²-A⁴ einen anionischen zweizähnigen Liganden darstellt, A³ und A⁴ jeweils unabhängig ein Kohlenstoffatom, ein Sauerstoffatom oder ein Stickstoffatom darstellen und diese Atome ein Atom sein können, das einen Ring bildet, G² eine Einzelbindung oder eine atomische Gruppe darstellt, die den zweizähnigen Liganden zusammen mit A³ und A⁴ bildet, und wenn eine Mehrzahl von A³-G²-A⁴ vorliegt, sie dieselben oder unterschiedlich sein können: 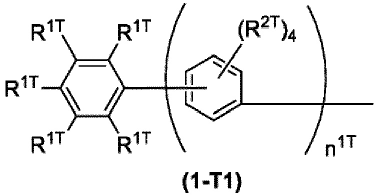 wobei
n^{1T} eine ganze Zahl von 0 bis 2 darstellt und
R^{1T} und R^{2T} jeweils unabhängig ein Wasserstoffatom, eine Alkylgruppe, eine Cycloalkylgruppe, eine Alkoxygruppe oder eine Cycloalkoxygruppe darstellen und diese Gruppen jeweils optional einen Substituenten aufweisen und die Mehrzahl von R^{1T} dieselbe oder unterschiedlich sein kann und die Mehrzahl von R^{2T} dieselbe oder unterschiedlich sein kann.

2. Zusammensetzung nach Anspruch 1, wobei n¹ 3 ist.

3. Zusammensetzung nach Anspruch 1 oder 2, wobei die Gruppe, die durch die Formel (1-S1) dargestellt ist, eine Gruppe, die durch die Formel (1-S1-1) dargestellt ist, eine Gruppe, die durch die Formel (1-S1-2)dargestellt ist, eine Gruppe die durch die Formel (1-S1-3) dargestellt ist, oder eine Gruppe ist, die durch die Formel (1-S1-4) dargestellt ist: 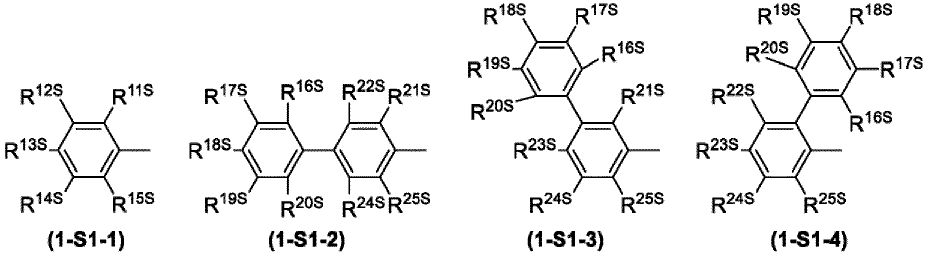 wobei
R^{11S}, R^{12S}, R^{13S}, R^{14S}, R^{15S}, R^{16S}, R^{17S}, R^{18S}, R^{19S}, R^{20S}, R^{21S}, R^{22S}, R^{23S},R^{24S} und R^{25S} jeweils unabhängig ein Wasserstoffatom, eine Alkylgruppe, eine Cycloalkylgruppe, eine Alkoxygruppe oder eine Cycloalkoxygruppe darstellen und diese Gruppen jeweils optional einen Substituenten aufweisen.

4. Zusammensetzung nach einem der Ansprüche 1 bis 3, wobei die Gruppe, die durch die Formel (1-T1) dargestellt ist, eine Gruppe, die durch die Formel (1-T1-1) dargestellt ist, eine Gruppe, die durch die Formel (1-T1-2) dargestellt ist, eine Gruppe, die durch die Formel (1-T1-3) dargestellt ist, oder eine Gruppe ist, die durch die Formel (1-T1-4) dargestellt ist: 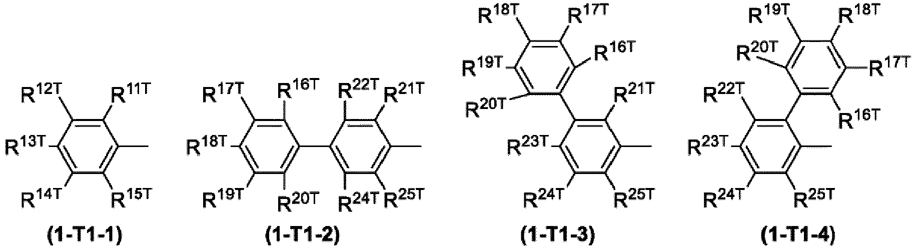 wobei
R^{11T}, R^{12T}, R^{13T}, R^{14T}, R^{15T}, R^{16T}, R^{17T}, R^{18T}, R^{19T}, R^{20T}, R^{21T}, R^{22T}, R^{23T}, R^{24T} und R^{25T} jeweils unabhängig ein Wasserstoffatom, eine Alkylgruppe, eine Cycloalkylgruppe, eine Alkoxygruppe oder eine Cycloalkoxygruppe darstellen und diese Gruppen jeweils optional einen Substituenten aufweisen.

5. Zusammensetzung nach einem der Ansprüche 1 bis 4, ferner umfassend eine Verbindung, die durch die Formel (H-1) dargestellt wird: 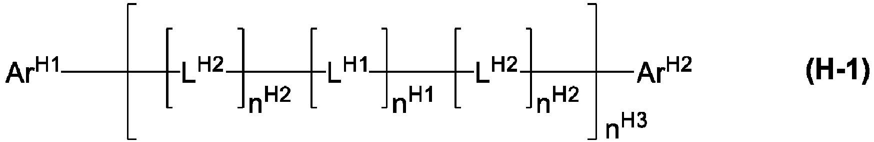 wobei
Ar^{H1} und Ar^{H2} jeweils unabhängig eine Arylgruppe oder eine monovalente heterocyclische Gruppe darstellen und diese Gruppen jeweils optional einen Substituenten aufweisen,
n^{H1} und n^{H2} jeweils unabhängig 0 oder 1 darstellen und wenn eine Mehrzahl von n^{H1} vorliegt, sie dieselben oder unterschiedlich sein können und die Mehrzahl von n^{H2} dieselbe oder unterschiedlich sein kann,
n^{H3} eine ganze Zahl von 0 oder mehr darstellt,
L^{H1} eine Arylengruppe, eine bivalente heterocyclische Gruppe oder eine Gruppe darstellt, die durch -[C(RH¹¹)₂]n^{H11}- dargestellt wird, und diese Gruppen jeweils optional einen Substituenten aufweisen, und wenn eine Mehrzahl von L^{H1} vorliegt, sie dieselben oder unterschiedlich sein können,
n^{H11} eine ganze Zahl von 1 bis 10 darstellt und R^{H11} ein Wasserstoffatom, eine Alkylgruppe, eine Cycloalkylgruppe, eine Alkoxygruppe, eine Cycloalkoxygruppe, eine Arylgruppe oder eine monovalente heterocyclische Gruppe darstellt und diese Gruppen jeweils optional einen Substituenten aufweisen können und die Mehrzahl von R^{H11} dieselbe oder unterschiedlich sein kann und kombiniert werden kann, um einen Ring zusammen mit den Kohlenstoffatomen auszubilden, an die sie angelagert sind,
L^{H2} eine Gruppe darstellt, die durch -N(-LH²¹-RH²¹)- dargestellt wird, und wenn eine Mehrzahl von L^{H2} vorliegt, sie dieselben oder unterschiedlich sein können und
L^{H21} eine Einzelbindung, eine Arylengruppe oder eine bivalente heterocyclische Gruppe darstellen und diese Gruppen jeweils optional einen Substituenten aufweisen, und R^{H21} ein Wasserstoffatom, eine Alkylgruppe, eine Cycloalkylgruppe, eine Arylgruppe oder eine monovalente heterocyclische Gruppe darstellt und diese Gruppen jeweils optional einen Substituenten aufweisen.

6. Zusammensetzung nach einem der Ansprüche 1 bis 4, ferner umfassend eine Polymerverbindung, umfassend eine konstitutionelle Einheit, die durch die Formel (Y) dargestellt wird:
-[Ar^{Y1}]- (Y)
wobei Ar^{Y1} eine Arylengruppe, eine bivalente heterocyclische Gruppe oder eine bivalente Gruppe darstellt, in der wenigstens eine Arylengruppe und wenigstens eine bivalente heterocyclische Gruppe direkt miteinander verbunden sind, und diese Gruppen jeweils optional einen Substituenten aufweisen.

7. Zusammensetzung nach einem der Ansprüche 1 bis 6, ferner umfassend wenigstens ein Material, das aus der Gruppe ausgewählt ist, bestehend aus einem Lochleitungsmaterial, einem Lochinjektionsmaterial, einem Elektronenleitungsmaterial, einem Elektroneninjektionsmaterial, einem lichtemittierenden Material, einem Antioxidationsmittel und einem Lösungsmittel.

8. Lichtemittierende Vorrichtung, umfassend die Zusammensetzung nach einem der Ansprüche 1 bis 6.

## Revendications

1. Composition, comprenant
un composé phosphorescent représenté par la formule (1-A1) ou (1-A3) et
un composé phosphorescent représenté par la formule (2-B1) ou (2-B2),
dans laquelle la longueur d'onde de pic maximum du spectre d'émission du composé phosphorescent représenté par la formule (1-A1) ou (1-A3) est de 380 nm ou plus et inférieure à 495 nm, et
la longueur d'onde de pic maximum du spectre d'émission du composé phosphorescent représenté par la formule (2-B1) ou (2-B2) est de 495 nm ou plus et inférieure à 750 nm : 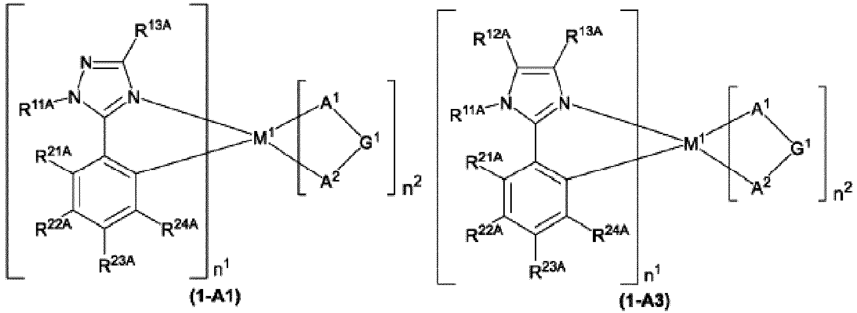 dans laquelle
M¹ représente un atome d'iridium,
n¹ représente un nombre entier relatif d'1 ou plus, n² représente un nombre entier relatif de 0 ou plus, et n¹+n² est 3,
R^{11A}, R^{12A}, R^{13A}, R^{21A}, R^{22A}, R^{23A} et R^{24A} représentent chacun indépendamment un substituant qui est constitué d'atomes sélectionnés parmi le groupe constitué de : un atome d'hydrogène, un atome de carbone, un atome d'azote, un atome d'oxygène et un atome de soufre, et plus spécifiquement dans laquelle R^{11A}, R^{12A}, R^{13A}, R^{21A}, R^{22A}, R^{23A} et R^{24A} représentent chacun indépendamment un atome d'hydrogène, un groupe alkyle, un groupe cycloalkyle, un groupe alkoxy, un groupe cycloalkoxy, un groupe aryle, un groupe aryloxy, un groupe hétérocyclique monovalent ou un groupe amino substitué et ces groupes ont chacun optionnellement un substituant, et lorsqu'une pluralité de : R^{11A}, R^{12A}, R^{13A}, R^{21A}, R^{22A}, R^{23A} et R^{24A} sont présents, ils peuvent être les mêmes ou différents dans chaque cas, et R^{21A} et R^{22A}, R^{22A} et R^{23A}, et R^{23A} et R^{24A} peuvent chacun être combinés ensemble pour former un anneau conjointement avec les atomes auxquels ils sont attachés, et au moins un sélectionné parmi le groupe constitué de : R^{11A}, R^{12A}, R^{13A}, R^{21A}, R^{22A}, R^{23A} et R^{24A} est un groupe représenté par la formule (1-S1),
le ligand constitué de l'anneau triazole ou imidazole et l'anneau benzène est un ligand constitué d'atomes sélectionnés parmi le groupe constitué de : un atome d'hydrogène, un atome de carbone, un atome d'azote, un atome d'oxygène et un atome de soufre, et
A¹-G¹-A² représente un ligand bidenté anionique, A¹ et A² représentent chacun indépendamment un atome de carbone, un atome d'oxygène ou un atome d'azote et ces atomes peuvent être un atome constituant un anneau, G¹ représente une liaison unique ou un groupe atomique constituant le ligand bidenté conjointement avec A¹ et A², et
lorsqu'une pluralité de A¹-G¹-A² sont présents, ils peuvent être les mêmes ou différents : 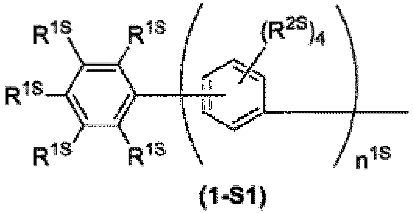 dans laquelle
n^{1S} représente un nombre entier relatif de 0 à 2, et
R^{1S} et R^{2S} représentent chacun indépendamment un atome d'hydrogène, un groupe alkyle, un groupe cycloalkyle, un groupe alkoxy ou un groupe cycloalkoxy et ces groupes ont chacun optionnellement un substituant, et la pluralité de R^{1S} peuvent être les mêmes ou différents, et la pluralité de R^{2S} peuvent être les mêmes ou différents : 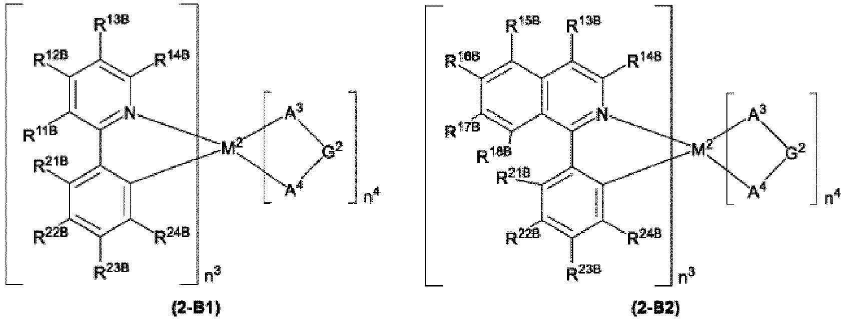 dans laquelle
M² représente un atome d'iridium,
n³ représente un nombre entier relatif de 1 ou plus, n⁴ représente un nombre entier relatif de 0 ou plus, et n³+n⁴ est 3,
R^{11B,} R^{12B}, R^{13B}, R^{14B}, R^{21B}, R^{22B}, R^{23B} et R^{24B} représentent chacun indépendamment un atome d'hydrogène, un groupe alkyle, un groupe cycloalkyle, un groupe alkoxy, un groupe cycloalkoxy, un groupe aryle, un groupe aryloxy ou un groupe hétérocyclique monovalent et ces groupes ont chacun optionnellement un substituant, et, lorsqu'une pluralité de : R^{11B}, R^{12B}, R^{13B}, R^{14B}, R^{21B}, R^{22B}, R^{23B} et R^{24B} sont présents, ils peuvent être les mêmes ou différents dans chaque cas, et R^{11B} et R^{12B}, R^{12B} et R^{13B}, R^{13B} et R^{14B}, R^{11B} et R^{21B}, R^{21B} et R^{22B}, R^{22B} et R^{23B}, et R^{23B} et R^{24B} peuvent chacun être combinés ensemble pour former un anneau conjointement avec les atomes auxquels ils sont attachés,
R^{15B}, R^{16B}, R^{17B} et R^{18B} représentent chacun indépendamment un atome d'hydrogène, un groupe alkyle, un groupe cycloalkyle, un groupe alkoxy, un groupe cycloalkoxy, un groupe aryle, un groupe aryloxy ou un groupe hétérocyclique monovalent et ces groupes ont chacun optionnellement un substituant, et, lorsqu'une pluralité de R^{15B}, R^{16B}, R^{17B} et R^{18B} sont présents, ils peuvent être les mêmes ou différents dans chaque cas, et R^{15B} et R^{16B}, R^{16B} et R^{17B}, et R^{17B} et R^{18B} peuvent chacun être combinés ensemble pour former un anneau conjointement avec les atomes auxquels ils sont attachés, et
au moins un sélectionné parmi le groupe constitué de : R^{11B}, R^{12B}, R^{13B}, R^{14B}, R^{21B}, R^{22B}, R^{23B} et R^{24B} est un groupe représenté par la formule (1-T1),
le ligand constitué de l'anneau pyridine, quinoline ou isoquinoline et de l'anneau benzène est un ligand constitué d'atomes sélectionnés parmi le groupe constitué de : un atome d'hydrogène, un atome de carbone, un atome d'azote, un atome d'oxygène et un atome de soufre, et
A³-G²-A⁴ représente un ligand bidenté anionique, A³ et A⁴ représentent chacun indépendamment un atome de carbone, un atome d'oxygène ou un atome d'azote et ces atomes peuvent être un atome constituant un anneau, G² représente une liaison unique ou un groupe atomique constituant le ligand bidenté conjointement avec A³ et A⁴, et, lorsqu'une pluralité de A³-G²-A⁴ sont présents, ils peuvent être les mêmes ou différents : 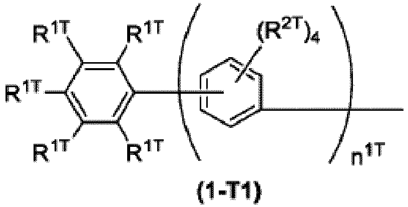 dans laquelle
n^{1T} représente un nombre entier relatif de 0 à 2, et
R^{1T} et R^{2T} représentent chacun indépendamment un atome d'hydrogène, un groupe alkyle, un groupe cycloalkyle, un groupe alkoxy ou un groupe cycloalkoxy et ces groupes ont chacun optionnellement un substituant, et la pluralité de R^{1T} peuvent être les mêmes ou différents, et la pluralité de R^{2T} peuvent être les mêmes ou différents.

2. Composition selon la revendication 1, dans laquelle n¹ est 3.

3. Composition selon la revendication 1 ou 2, dans laquelle le groupe représenté par la formule (1-S1) est un groupe représenté par la formule (1-S1-1), un groupe représenté par la formule (1-S1-2), un groupe représenté par la formule (1-S1-3) ou un groupe représenté par la formule (1-S1-4) : 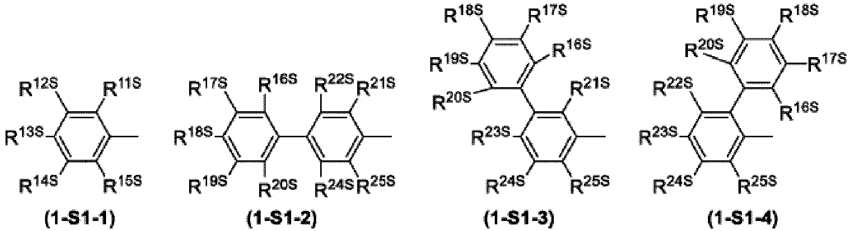 dans laquelle
R^{11S}, R^{12S}, R^{13S}, R^{14S}, R^{15S}, R^{16S}, R^{17S}, R^{18S}, R^{19S}, R^{20S}, R^{21S}, R^{22S}, R^{23S}, R^{24S} et R^{25S} représentent chacun indépendamment un atome d'hydrogène, un groupe alkyle, un groupe cycloalkyle, un groupe alkoxy ou un groupe cycloalkoxy et ces groupes ont chacun optionnellement un substituant.

4. Composition selon l'une quelconque des revendications 1 à 3, dans laquelle le groupe représenté par la formule (1-T1) est un groupe représenté par la formule (1-T1-1), un groupe représenté par la formule (1-T1-2), un groupe représenté par la formule (1-T1-3) ou un groupe représenté par la formule (1-T1-4) 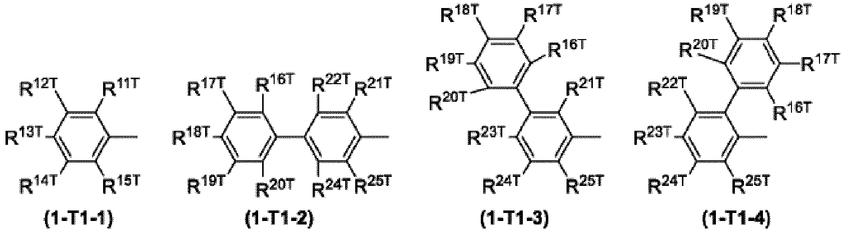 dans laquelle
R^{11T}, R^{12T}, R^{13T}, R^{14T}, R^{15T}, R^{16T}, R^{17T}, R^{18T}, R^{19T}, R^{20T}, R^{21T}, R^{22T}, R^{23T}, R^{24T} et R^{25T} représentent chacun indépendamment un atome d'hydrogène, un groupe alkyle, un groupe cycloalkyle, un groupe alkoxy ou un groupe cycloalkoxy et ces groupes ont chacun optionnellement un substituant.

5. Composition selon l'une quelconque des revendications 1 à 4, comprenant en outre un composé représenté par la formule (H-1) : 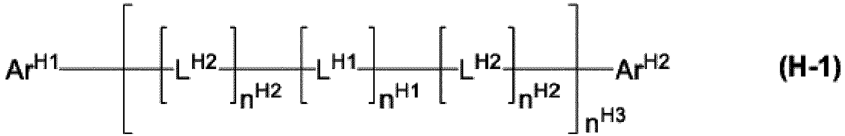 dans laquelle
Ar^{H1} et Ar^{H2} représentent chacun indépendamment un groupe aryle ou un groupe hétérocyclique monovalent et ces groupes ont chacun optionnellement un substituant,
n^{H1} et n^{H2} représentent chacun indépendamment 0 ou 1, et, lorsqu'une pluralité de n^{H1} sont présents, ils peuvent être les mêmes ou différents, et la pluralité de n^{H2} peuvent être les mêmes ou différents,
n^{H3} représente un nombre entier relatif de 0 ou plus,
L^{H1} représente un groupe arylène, un groupe hétérocyclique divalent ou un groupe représenté par -[C(R^{H11})₂]n¹¹- et ces groupes ont chacun optionnellement un substituant, et, lorsqu'une pluralité de L^{H1} sont présents, ils peuvent être les mêmes ou différents,
n^{H11} représente un nombre entier relatif d'1 à 10, et R^{H11} représente un atome d'hydrogène, un groupe alkyle, un groupe cycloalkyle, un groupe alkoxy, un groupe cycloalkoxy, un groupe aryle ou un groupe hétérocyclique monovalent et ces groupes ont chacun optionnellement un substituant, et la pluralité de R^{H11} peuvent être les mêmes ou différents et peuvent être combinés ensemble pour former un anneau conjointement avec les atomes de carbone auxquels ils sont attachés,
L^{H2} représente un groupe représenté par -N(-L^{H21}-R^{H21})-, et lorsque une pluralité de L^{H2} sont présents, ils peuvent être les mêmes ou différents, et
L^{H21} représente une liaison unique, un groupe arylène ou un groupe hétérocyclique divalent et ces groupes ont chacun optionnellement un substituant, et R^{H21} représente un atome d'hydrogène, un groupe alkyle, un groupe cycloalkyle, un groupe aryle ou un groupe hétérocyclique monovalent et ces groupes ont chacun optionnellement un substituant.

6. Composition selon l'une quelconque des revendications 1 à 4, comprenant en outre un composé polymère comprenant une unité constitutive représentée par la formule (Y) :
-[Ar^{Y1}]- (Y)
dans laquelle Ar^{Y1} représente un groupe arylène, un groupe hétérocyclique divalent ou un groupe divalent dans lequel au moins un groupe arylène et au moins un groupe hétérocyclique divalent sont liés directement l'un à l' autre, et ces groupes ont chacun optionnellement un substituant.

7. Composition selon l'une quelconque des revendications 1 à 6, comprenant en outre au moins un matériau sélectionné parmi le groupe constitué de : un matériau de transport de trous, un matériau d'injection de trous, un matériau de transport d'électrons, un matériau d'injection d'électrons, un matériau luminescent, un antioxydant et un solvant.

8. Dispositif luminescent, comprenant la composition selon l'une quelconque des revendications 1 à 6.
